# EUROPEAN PATENT SPECIFICATION

(11) **EP 4 341 315 B1**
(45) Date of publication and mention of the grant of the patent: **07.10.2026**
(21) Application number: 22805690.9
(22) Date of filing: 16.05.2022
(51) Int. Cl.: C08F 112/32, C08F 220/34, C08F 226/06, C09G 1/04, C08F 112/14, H10P 52/40, C09K 3/14

(54) **CHEMICAL-MECHANICAL PLANARIZATION COMPOSITION COMPRISING IMIDAZOLIUM-BASED POLY(IONIC LIQUID)S AND USE THEREOF**
CHEMISCH-MECHANISCHE ZUSAMMENSETZUNG ZUM PLANARISIEREN ENTHALTEND IMIDAZOLIUMBASIERTE POLY(IONISCHE FLÜSSIGKEIT) UND VERWENDUNG DAVON
COMPOSITION CHIMICO-MÉCHANIQUE DE PLANARISATION COMPRENANT DES POLY(LIQUIDE(S) IONIQUE(S)) À BASE D'IMIDAZOLIUM ET UTILISATION ASSOCIÉE

(30) Priority: 20.05.2021 US 202163191047 P
(43) Date of publication of application: 27.03.2024
(73) Proprietor: Versum Materials US, LLC, Tempe, AZ 85284 (US)
(72) Inventor: LARBIG, Gregor, Tempe, Arizona 85284 (US); KIRSCH, Peer, Tempe, Arizona 85284 (US); STENDER, Matthias, Tempe, Arizona 85284 (US); SHI, Xiaobo, Tempe, Arizona 85284 (US)
(74) Representative: Merck Patent Association
(86) International application number: PCT/US2022/072336
(87) International publication number: WO 2022/246381

(56) References cited:
- CN-A- 105 017 315
- CN-A- 105 968 364
- CN-A- 111 987 361
- KR-A- 20130 071 089
- KR-A- 20130 071 089
- KR-A- 20160 066 424
- US-A1- 2009 266 230
- US-A1- 2009 266 230
- LAMBERT ROMAIN ET AL: "Imidazolium-Based Poly (Ionic Liquid)s Featuring Acetate Counter Anions: Thermally Latent and Recyclable Precursors of Polymer-Supported N-Heterocyclic Carbenes for Organocatalysis", MACROMOLECULAR RAPID COMMUNICATIONS, vol. 37, no. 14, 18 March 2016 (2016-03-18), pages 1143 - 1149, XP093006291, DOI: 10.1002/marc.201600019
- HOSSEINZADEH FATEMEH ET AL: "Synthesis and characterization of ionic liquid functionalized polymers for drug delivery of an anti-inflammatory drug", DESIGNED MONOMERS AND POLYMERS, vol. 15, no. 4, 29 June 2012 (2012-06-29), pages 379 - 388, XP093006287, DOI: 10.1080/1385772X.2012.686689
- COUPILLAUD ET AL: "Reactive Poly(ionic liquid)s (PILs) and Nanostructures from PIL-based Block Copolymers", MACROMOLECULAR RAPID COMMUNICATIONS, 19 November 2014 (2014-11-19), XP055688071
- LAMBERT ROMAIN, PAUL COUPILLAUD, ANNE-LAURE WIROTIUS, JOAN VIGNOLLE, DANIEL TATON : "Imidazolium‐Based Poly (Ionic Liquid)s Featuring Acetate Counter Anions: Thermally Latent and Recyclable Precursors of Polymer‐Supported N‐Heterocyclic Carbenes for Organocatalysis", MACROMOLECULAR RAPID COMMUNICATIONS, vol. 37, no. 14, 18 March 2016 (2016-03-18), pages 1143 - 1149, XP093006291, DOI: 10.1002/marc.201600019
- HOSSEINZADEH FATEMEH, MAHKAM MEHRDAD, GALEHASSADI MOHAMMAD: "Synthesis and characterization of ionic liquid functionalized polymers for drug delivery of an anti-inflammatory drug", DESIGNED MONOMERS AND POLYMERS, vol. 15, no. 4, 1 July 2012 (2012-07-01), pages 379 - 388, XP093006287, DOI: 10.1080/1385772X.2012.686689
- COUPILLAUD, PAUL: "Reactive Poly(ionic liquid)s (PILs) and Nanostructures from PIL-based Block Copolymers", PHD THESIS, UNIVERSITÉ DE BORDEAUX; UNIVERSIDAD DEL PAÍS VASCO, 20 November 2014 (2014-11-20), XP055688071

## Description

### CROSS-REFERENCE OF RELATED APPLICATIONS

This application claims the benefit of priority to U.S. provisional application Serial No. 63/191,047, filed May 20, 2021.

### BACKGROUND OF THE INVENTION

The present disclosure relates to the synthesizing of imidazolium-based poly(ionic liquid)s, and the use therefore.

The present disclosure relates to the use of imidazolium-based poly(ionic liquid)s as additives in chemical mechanical planarization or polishing ("CMP") slurry (or composition, or formulation), polishing method and polishing system for carrying out chemical mechanical planarization in the production of a semiconductor device. In particular, the present disclosure relates to polishing slurries that are suitably used for polishing patterned semiconductor wafers that include metallic materials containing tungsten.

Integrated circuits are interconnected through the use of well-known multilevel interconnections. Interconnection structures normally have a first layer of metallization, an interconnection layer, a second level of metallization, and typically third and subsequent levels of metallization. Interlevel dielectric materials such as silicon dioxide and sometimes low-k materials are used to electrically isolate the different levels of metallization in a silicon substrate or well. The electrical connections between different interconnection levels are made through the use of metallized vias and in particular tungsten vias. U.S. Pat. No. 4,789,648 describes a method for preparing multiple metallized layers and metallized vias in insulator films. In a similar manner, metal contacts are used to form electrical connections between interconnection levels and devices formed in a well. The metal vias and contacts are generally filled with tungsten and generally employ an adhesion layer such as titanium nitride (TiN) and/or titanium to adhere a metal layer such as a tungsten metal layer to the dielectric material.

In one semiconductor manufacturing process, metallized vias or contacts are formed by a blanket tungsten deposition followed by a CMP step. In a typical process, via holes are etched through the interlevel dielectric (ILD) to interconnection lines or to a semiconductor substrate. Next, a thin adhesion layer such as titanium nitride and/or titanium is generally formed over the ILD and is directed into the etched via hole. Then, a tungsten film is blanket deposited over the adhesion layer and into the via. The deposition is continued until the via hole is filled with tungsten. Finally, the excess tungsten is removed by CMP to form metal vias.

In another semiconductor manufacturing process, tungsten is used as a gate electrode material in the transistor because of its superior electrical characteristics over poly-silicon which has been traditionally used as gate electrode material, as taught by A. Yagishita et al, IEEE TRANSACTIONS ON ELECTRON DEVICES, VOL. 47, NO. 5, MAY 2000.

In a typical CMP process, the substrate is placed in direct contact with a rotating polishing pad. A carrier applies pressure against the backside of the substrate. During the polishing process, the pad and table are rotated while a downward force is maintained against the substrate back. An abrasive and chemically reactive solution, commonly referred to as a polishing "slurry", a polishing "composition" or a polishing "formulation", is deposited onto the pad during polishing, where rotation and/or movement of the pad relative to the wafer brings said slurry into the space between the polishing pad and the substrate surface. The slurry initiates the polishing process by chemically reacting with the film being polished. The polishing process is facilitated by the rotational movement of the pad relative to the substrate as slurry is provided to the wafer/pad interface. Polishing is continued in this manner until the desired film on the insulator is removed. Removal of tungsten in the CMP is believed to be due to synergy between mechanical abrasion and tungsten oxidation followed by dissolution.

Despite its relatively simple outward appearance, chemical mechanical planarization (CMP) is a highly complex process. It's importance as enabling technology for past and future requirements for device scaling and new trends in semiconductor industry is undisputed. A multitude of interactions between wafer, slurry and pad as well as general process parameters determine the CMP outcome. Finally, material removal in CMP is the result of complex interaction between chemical and mechanical forces. Large numbers of materials are used in semiconductor device fabrication, all of which require an optimized CMP process. Simultaneous polishing of combinations of completely different materials such as dielectric materials, barrier and metal layers is a real challenge with CMP.

Highly selective slurries, which have a large difference in removal rate of metal versus rate of dielectric removal, are of great interest for future industry needs. However, there are imperfections associated with the use of these highly selective slurries. Metal layers can easily be over-polished, creating a "dishing" effect. Another unacceptable defect is called "erosion", which describes topographical difference between an area with dielectric and a dense array of metal vias or trenches.

One of the commonly encountered problems in CMP in particular in metal applications such as tungsten is how to control topological defects such as erosion and dishing.

Water-based slurries are considered main drivers in improving CMP performance for future devices. The slurry developments not only affect the removal rate and selectivity between different layers, but also control defects during the polishing process. In general, the slurry composition is a complex combination of abrasives and chemical ingredients with different functions.

US 5,876,490 describes the use of polish slurry comprising abrasive particles and exhibiting normal stress effect and further comprising polyelectrolyte having ionic moieties of a charge that differs from that associated with said abrasive particles and wherein the concentration of said polyelectrolyte is about 5 to about 50 percent by weight of said abrasive particles and wherein said polyelectrolyte has a molecular weight of about 500 to about 10,000.

US patent 6,776,810 describes the use of positively charged polyelectrolytes with a molecular weight of 15,000 or more for the use in CMP slurries with silica or alumina particles for the use on metallic substrates. A variety of different cationic homo- and co-polymers are mentioned in this patent.

US 7,247,567 describes a method of chemically-mechanically polishing a substrate comprising tungsten through use of a composition comprising a tungsten etchant, an inhibitor of tungsten etching, and water, wherein the inhibitor of tungsten polishing is a polymer, copolymer, or polymer blend comprising at least one repeating group comprising at least one nitrogen-containing heterocyclic ring or a tertiary or quaternary nitrogen atom. The invention further provides a chemical-mechanical polishing composition particularly useful in polishing tungsten-containing substrates.

US 7,994,057 discloses a method comprises chemically-mechanically polishing a substrate with an inventive polishing composition comprising a liquid carrier, a cationic polymer, and abrasive particles that have been treated with an aminosilane compound.

US patent 8,858,819 describes the use of (polyalkyleneimine), a polymer with a large positive charge density, as an inhibitor in tungsten slurries.

US 8,492,276 describes the use of cationic water-soluble polymers for the use in acidic (pH 1-3) tungsten slurries. A variety of different types of cationic polymers are listed and the formulations were evaluated on patterned wafers. Good performance on topography was reported, however no specific dishing values are provided.

US 8,480,920 describes a chemical mechanical polishing aqueous dispersion used to polish a polishing target that includes a wiring layer that contains tungsten, the chemical mechanical polishing aqueous dispersion including: (A) a cationic water-soluble polymer; (B) an iron (III) compound; and (C) colloidal silica having an average particle diameter calculated from a specific surface area determined by the BET method of 10 to 60 nm, the content (M_{A}) (mass %) of the cationic water-soluble polymer (A) and the content (M_{C}) (mass %) of the colloidal silica (C) satisfying the relationship "M_{A}/M_{C}= 0.0001 to 0.003", and the chemical mechanical polishing aqueous dispersion having a pH of 1 to 3.

US 8,808,573 and US 9,633,863 describe an acidic aqueous polishing composition suitable for polishing a silicon nitride-containing substrate in a chemical-mechanical polishing (CMP) process. The composition, at point of use, comprises about 0.01 to about 2 percent by weight of a particulate calcined ceria abrasive, about 10 to about 1000 ppm of at least one cationic polymer, optionally, about 10 to about 2000 ppm of a polyoxyalkylene polymer; and an aqueous carrier therefor. The at least one cationic polymer is selected from a poly(vinylpyridine) polymer and a combination of a poly(vinylpyridine) polymer and a quaternary ammonium-substituted polymer. Methods of polishing substrates and of selectively removing silicon nitride from a substrate in preference to removal of polysilicon using the compositions are also provided.

US 9,358,659 describes a chemical-mechanical polishing composition containing (a) abrasive particles, (b) a polymer, and (c) water, wherein (i) the polymer possesses an overall charge, (ii) the abrasive particles have a zeta potential Za measured in the absence of the polymer and the abrasive particles have a zeta potential Zb measured in the presence of the polymer, wherein the zeta potential Za is a numerical value that is the same sign as the overall charge of the polymer, and (iii) Izeta potential Zbl > Izeta potential Zal. The invention also provides a method of polishing a substrate with the polishing composition.

US 9,631,122 describes chemical mechanical polishing compositions and methods of using the compositions for planarizing a surface of a substrate that contains tungsten, the compositions containing silica abrasive particles and cationic surfactant.

US 6,083,838 describes adding surfactant to CMP slurries to planarize a metal and in particular tungsten surface. In one embodiment, the method comprises selecting a slurry that contains conventional components of an abrasive and an oxidant. The oxidant is known to have a known rate of oxidation and is capable of oxidizing the metal. This embodiment further comprises reducing a rate of exposure of the metal to the oxidant by altering a property of the slurry, oxidizing the metal at the reduced rate to form an oxide of the metal, and removing the oxide with the abrasive to produce a planarized surface of the semiconductor wafer.

KR 2013-0071089 A teaches a chemical-mechanical abrasion slurry composition comprising abrasive particles, a pH modifier, a pH buffer agent, water, and an ionic liquid represented by chemical formula 1:

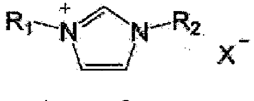

In chemical formula 1, each of R¹ and R² is C1-10 alkyl group; X⁻ is a monovalent anion. The abrasive particles are selected from colloidal silica, fumed silica, alumina, ceria, titania, zirconia, and a mixture thereof. The pH modifier is selected from phosphoric acid, hydrochloric acid, sulfuric acid, nitric acid, ammonia, potassium hydroxide, tetramethyl ammonium hydroxide, tetraethyl ammonium hydroxide, and a mixture thereof.

One of the commonly encountered problems in CMP, particularly in metal applications such as tungsten, is dishing of tungsten lines and erosion of arrays of metal lines. Dishing and erosion are critical CMP parameters that define the planarity of the polished wafers. Dishing of lines typically increases for wider lines. Erosion of arrays typically increases with an increase in pattern density.

Tungsten CMP slurries must be formulated such that the dishing and erosion can be minimized in order to meet certain design targets critical for a functioning device.

Finding solutions to control topological defects such as erosion and dishing is key to future CMP requirements. There still has been a need for novel tungsten CMP slurries that can reduce dishing and erosion while maintain desirable removal rate in polishing.

### BRIEF SUMMARY OF THE INVENTION

The present invention satisfies the need by providing intelligent designed tungsten CMP slurries, systems, and methods of using the CMP slurries to minimize surface imperfections of dishing and erosion while maintain desirable polishing of metal layers, specifically tungsten films. The scope of the invention and thus of protection is defined by the appended claims.

The present disclosure relates to imidazolium-based poly(ionic liquid)s and the present invention relates to their use in tungsten CMP.

More specifically, the present disclosure discloses the synthesis of certain imidazolium-based poly(ionic liquid)s; and demonstrates the use of the synthesized imidazolium-based poly(ionic liquid)s in the CMP slurries to reduce the described problem of dishing and erosion in highly selective tungsten slurries.

The imidazolium-based poly(ionic liquid) is a cationic polymer having an imidazolium group either in the main chain, in the side chain, or in both main chain and side chain in the monomers.
a)

The abrasive includes, but is not limited to inorganic oxide particles, metal oxide-coated inorganic oxide particles, organic polymer particles, metal oxide-coated organic polymer particles, and combinations thereof.

The inorganic metal oxide particles include but are not limited to ceria, colloidal silica, high purity colloidal silica, fumed silica, colloidal ceria, alumina, titania, zirconia particles.

The metal oxide-coated inorganic metal oxide particles include but are not limited to the ceria-coated inorganic metal oxide particles, such as, ceria-coated colloidal silica, ceria-coated high purity colloidal silica, ceria-coated alumina, ceria-coated titania, ceria-coated zirconia, or any other ceria-coated inorganic metal oxide particles.

The organic polymer particles include, but are not limited to, polystyrene particles, polyurethane particle, polyacrylate particles, or any other organic polymer particles.

The metal oxide-coated organic polymer particles are selected from the group consisting of ceria-coated organic polymer particles, zirconia-coated organic polymer.

The concentration of abrasive can range from about 0.01 wt.% to about 30 wt.%, the preferred is from about 0.05 wt.% to about 10 wt.%, the more preferred is from about 0.1 and about 2 wt.%. The weight percent is relative to the composition.

The oxidizing agent includes, but is not limited to peroxy compound selected from the group consisting of hydrogen peroxide, urea peroxide, peroxyformic acid, peracetic acid, propaneperoxoic acid, substituted or unsubstituted butaneperoxoic acid, hydroperoxy-acetaldehyde, potassium periodate, ammonium peroxymonosulfate; and non-peroxy compound selected from the group consisting of ferric nitrite, KClO₄, KBrO₄, KMnO₄.

The oxidizer concentration can range from about 0.01 wt.% to about 30 wt.% while the more preferred is from about 0.5 wt.% to about 10 wt.%. The weight percent is relative to the composition.

The additive comprising an imidazolium-based cationic polymer includes but is not limited to an imidazolium-based poly(ionic liquid).

The general amount of additive ranges from 0.1 to 10,000 ppm, 1 ppm to 5,000 ppm, 5 to 1,000 ppm, or 10 to 600 ppm.

Suitable pH-adjusting agents to lower the pH of the polishing composition include, but are not limited to, nitric acid, sulfuric acid, tartaric acid, succinic acid, citric acid, malic acid, malonic acid, various fatty acids, various polycarboxylic acids and mixtures thereof. Suitable pH-adjusting agents to raise the pH of the polishing composition include, but are not limited to, potassium hydroxide, sodium hydroxide, ammonia, tetraethylammonium hydroxide, ethylenediamine, piperazine, polyethyleneimine, modified polyethyleneimine, and mixtures thereof.

The pH of the slurry is between 1 and 14, preferably is between 1 and 7, more preferably is between 1 and 6, and most preferably is between 1 and 4.

The CMP slurries may further comprise surfactant; dispersion agent; chelating agent; film-forming anticorrosion agent; and biocide.

The macromolecules described above have been found to interact with the tungsten surface and inhibit removal of the metal, making them promising candidates for overall topography control and specifically for reducing dishing and erosion.

Other aspects, features and embodiments of the invention will be more fully apparent from the ensuing disclosure and appended claims.

The embodiments of the invention can be used alone or in combinations with each other.

### DETAILED DESCRIPTION OF THE INVENTION

Present invention pertains to slurries, systems, and methods that can be used in chemical mechanical planarization (CMP) of tungsten containing semiconductor devices, substrates, or films. CMP slurries of present invention reduce dishing and erosion while maintain desirable removal rate in polishing. The present disclosure relates to imidazolium-based poly(ionic liquid)s and the present invention relates to their use in tungsten CMP.

More specifically, the present disclosure discloses the synthesis of imidazolium-based poly(ionic liquid)s; and demonstrates the use of the synthesized imidazolium-based poly(ionic liquid)s in the CMP slurries to reduce the described problem of dishing and erosion in highly selective tungsten slurries.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (*e.g.,* "such as") provided herein, is intended merely to better illuminate the invention and does not pose a limitation on the scope of the invention unless otherwise claimed. No language in the specification should be construed as indicating any non-claimed element as essential to the practice of the invention. The use of the term "comprising" in the specification and the claims includes the narrower language of "consisting essentially of" and "consisting of."

Embodiments are described herein, including the best mode known to the inventors for carrying out the invention. Variations of those embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

For ease of reference, "microelectronic device" corresponds to semiconductor substrates, flat panel displays, phase change memory devices, solar panels and other products including solar substrates, photovoltaics, and microelectromechanical systems (MEMS), manufactured for use in microelectronic, integrated circuit, or computer chip applications. Solar substrates include, but are not limited to, silicon, amorphous silicon, polycrystalline silicon, monocrystalline silicon, CdTe, copper indium selenide, copper indium sulfide, and gallium arsenide on gallium. The solar substrates may be doped or undoped. It is to be understood that the term "microelectronic device" is not meant to be limiting in any way and includes any substrate that will eventually become a microelectronic device or microelectronic assembly.

"Substantially free" is defined herein as less than 0.001 wt. %. "Substantially free" also includes 0.000 wt. %. The term "free of" means 0.000 wt. %.

As used herein, "about" is intended to correspond to ±5%, preferably ±2% of the stated value.

In one aspect, the invention is a chemical mechanical planarization (CMP) composition comprising an imidazolium-based poly(ionic liquid) comprising at least one monomer having at least one imidazolium group with structure (I): 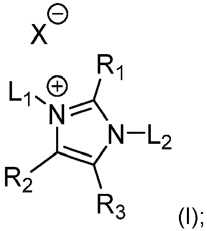 wherein
(a) the at least one imidazolium group with structure (I) is in a side chain or side chains of the imidazolium-based poly(ionic liquid);
   wherein
   one of L₁ and L₂ is a covalent bond or a spacer connecting imidazolium-ring to main chain of the imidazolium-based poly(ionic liquid), and comprises a substituted or unsubstituted aliphatic; cyclic or branched aliphatic, aromatic, heteroaromatic or siloxane moiety; wherein the main chain is formed after polymerization of a polymerizable group selected from the group consisting of vinyl, allyl, styrenic, acrylic, methacrylic, acrylamide, methacrylamide, siloxane, maleimide, norbornene, and combinations thereof;
   another one of L₁ and L₂ is an alkyl group selected from the group consisting of linear, branched, and cyclic alkyl group; wherein CH₂ thereof can be replaced by O, S or N in a way that no heteroatoms are connected to each other; hydrogen can be replaced by F, Cl or CN;
   each of R₁, R₂, R₃ can be independently H or an alkyl group selected from the group consisting of linear, branched, and cyclic alkyl group; where CH₂ thereof can be replaced by O, S or N in a way that no heteroatoms are connected to each other; and hydrogen can be replaced by F, Cl or CN; R₂ and R₃ can also be connected to a cyclic unit; preferably, R₁= R₂ = H;
      and
   anion X⁻ is selected from the group consisting of halide (F-, Cl-, Br-, I-), BF₄-, PF₆-, [C₂F₅BF₃]-, carboxylate RCOO- with R = H, alkyl or aryl; malonate, citrate, fumarate, MeOSO₃-, MeSO₃-, CF₃COO-, CF₃SO₃-, nitrate, and sulfate; wherein Me is methyl;
(b) the at least one imidazolium group with structure (I) is in main chain of the imidazolium-based poly(ionic liquid);
   wherein
   L₁ and L₂ each independently comprises a substituted or unsubstituted aliphatic, cyclic or branched aliphatic, aromatic, heteroaromatic, and siloxane moiety; wherein CH₂ thereof can be replaced by O, S or N in a way that no heteroatoms are connected to each other; hydrogen can be replaced by F, Cl or CN;
   L₁, L₂ or both L₁ and L₂ can connect the at least one imidazolium group via suitable functional group to the main chain to form the imidazolium-based poly(ionic liquid); wherein the suitable functional group is selected from group consisting of esters, amides, urethanes, ethers, thioethers, imides, and combinations thereof;
   each of R₁, R₂, R₃ can be independently H or an alkyl group selected from the group consisting of linear, branched, and cyclic alkyl group; where CH₂ can be replaced by O, S or N in a way that no heteroatoms are connected to each other; and hydrogen can be replaced by F, Cl or CN; R₂ and R₃ can also be connected to a cyclic unit; preferably, R₁= R₂ = H;
      and
   anion X⁻ is selected from the group consisting of halide (F-, Cl-, Br-, I-), BF₄-, PF₆-, [C₂F₅BF₃]-, carboxylate RCOO- with R = H, alkyl or aryl; malonate, citrate, fumarate, MeOSO₃-, MeSO₃-, CF₃COO-, CF₃SO₃-, nitrate, and sulfate, wherein Me is methyl;
      and
(c) the at least one imidazolium group with structure (I) are in both the side chain or the side chains of the imidazolium-based poly(ionic liquid) as defined in above (a) and in the main chain of the imidazolium-based poly(ionic liquid) as defined in above (b).

The imidazolium-based poly(ionic liquid) can be formed by suitable polycondensation reactions of corresponding monomers. In addition, imidazolium groups can be formed during the polymerization process by suitable reactions such as the Debus-Radziszewski imidazole reaction based on diamines, dicarbonyls and aldehydes.

The imidazolium-based poly(ionic liquid) can have a cross-linkable monomer with polymerizable groups for L₁ and L₂ of (a).

The imidazolium-based poly(ionic liquid) can be a copolymer comprising at least two different monomers selected from (a), (b), and (e) a non-ionic monomer selected from the group consisting of acrylates, methacrylates, acrylamides, methacrylamides, maleimides, vinyl benzene, other vinyl-type monomer, ethylene glycol, siloxane, norbornene, combinations thereof, or other monomer which can form copolymers with (a) and (b).

The imidazolium-based poly(ionic liquid) can be a block-copolymer.

The imidazolium-based poly(ionic liquid) can have at least one functional anion as a reducing or complexation agent.

The polymerization of the imidazolium-based poly(ionic liquid) can be a method selected from the group consisting of free radical polymerization, reversible addition-fragmentation chain-transfer polymerization (RAFT), nitroxide-mediated polymerization (NMP), atomic transfer reaction polymerization (ATRP), ring opening polymerization (ROMP), and polycondensation reaction.

The CMP slurries may comprise abrasive, optionally an oxidizing agent (i.e., an oxidizer that is not a free radical producer), an activator or catalyst, a corrosion inhibitor, a dishing reducing agent, a stabilizer, and a pH adjusting agent.

The CMP slurries may further comprise surfactant; dispersion agent; chelator; film-forming anticorrosion agent; biocide; and a polish enhancement agent.

The pH of the slurry is between 1 and 14, preferably is between 1 and 7, more preferably is between 1 and 6, and most preferably is between 1 and 4.

In all such compositions, wherein specific components of the composition are discussed in reference to weight percentage ranges including a zero lower limit, it will be understood that such components may be present or absent in various specific embodiments of the composition, and that in instances where such components are present, they may be present at concentrations as low as 0.00001 weight percent, based on the total weight of the composition in which such components are employed.

In yet another aspect, the invention is a method of using the chemical mechanical planarization (CMP) polishing composition comprising the imidazolium-based poly(ionic liquid).

In yet another aspect, the invention is a system of using the chemical mechanical planarization (CMP) polishing composition comprising the imidazolium-based poly(ionic liquid).

### Abrasive

Any suitable abrasive can be used.

The abrasive used in CMP slurries includes, but is not limited to inorganic oxide particles, metal oxide-coated inorganic oxide particles, organic polymer particles, metal oxide-coated organic polymer particles, surface modified abrasive particles, and combinations thereof.

The abrasive used in CMP slurries can be activator-containing particles (i.e., an abrasive having an activator coating); or non-activator-containing particles.

The inorganic oxide particles include but are not limited to ceria, silica, alumina, titania, germania, spinel, an oxide or nitride of tungsten, zirconia particles, or any of the above doped with one or more other minerals or elements, and any combination thereof. The oxide abrasive may be produced by any of a variety of techniques, including sol-gel, hydrothermal, hydrolytic, plasma, pyrogenic, aerogel, fuming and precipitation techniques, and any combination thereof.

Precipitated inorganic oxide particles can be obtained by known processes by reaction of metal salts and acids or other precipitating agents. Pyrogenic metal oxide and/or metalloid oxide particles are obtained by hydrolysis of a suitable, vaporizable starting material in an oxygen/hydrogen flame. An example is pyrogenic silicon dioxide from silicon tetrachloride. The pyrogenic oxides of aluminum oxide, titanium oxide, zirconium oxide, silicon dioxide, cerium oxide, germanium oxide and vanadium oxide and chemical and physical mixtures thereof are suitable.

The metal oxide-coated inorganic metal oxide particles include but are not limited to the ceria-coated or alumina-coated inorganic oxide particles, such as, ceria-coated colloidal silica, alumina-coated colloidal silica, ceria-coated high purity colloidal silica, alumina-coated high purity colloidal silica, ceria-coated alumina, ceria-coated titania, alumina-coated titania, ceria-coated zirconia, alumina-coated zirconia, or any other ceria-coated or alumina-coated inorganic metal oxide particles.

The metal oxide-coated organic polymer particles are selected from the group consisting of ceria-coated organic polymer particles, zirconia-coated organic polymer.

The organic polymer particles include, but are not limited to, polystyrene particles, polyurethane particle, polyacrylate particles, or any other organic polymer particles.

Colloidal silica particles and high purify colloidal silica particles are the preferred abrasive particles. The silica can be any of precipitated silica, fumed silica, silica fumed, pyrogenic silica, silica doped with one or more adjutants, or any other silica-based compound.

Colloidal silica particles and high purify colloidal silica particles being used as abrasives also include the surface chemically modified silica particles through chemical coupling reactions which allow such silica particle surface bearing different chemical functional groups and possess positive or negative charges at different applied pH conditions in CMP slurries. The examples of such surface chemical modified silica particles include, but not limited to, SiO₂-R-NH₂, -SiO-R-SO₃M; wherein R can be for example, (CH2)ₙ group with n ranged from 1 to 12, and M can be for example, sodium, potassium, or ammonium.

In an alternate embodiment the silica can be produced, for example, by a process selected from the group consisting of a sol-gel process, a hydrothermal process, a plasma process, a fuming process, a precipitation process, and any combination thereof.

The abrasive is generally in the form of an abrasive particle, and typically many abrasive particles, of one material or a combination of different materials. Generally, a suitable abrasive particle is more or less spherical and has an effective diameter of about 10 to 700 nm, about 20 to 500 nm, or about 30 to 300 nanometers (nm), although individual particle size may vary. Abrasive in the form of aggregated or agglomerated particles are preferably processed further to form individual abrasive particles.

Abrasive particles may be purified using suitable method such as ion exchange to remove metal impurities that may help improve the colloidal stability. Alternatively, high purity abrasive particles are used.

In general, the above-mentioned abrasives may be used either alone or in combination with one another. It may be advantageous to have two or more abrasive particles with different sizes or different types of abrasives be combined to obtain excellent performance.

The concentration of abrasive can range from 0.01 wt.% to 30 wt.%, the preferred range is from about 0.05 wt.% to about 20 wt.%, the more preferred range is from about 0.01 to about 10 wt.%, and the most preferred range is from 0.1 wt.% to 2 wt.%. The weight percent is relative to the composition.

### Additive

The CMP slurries of the present invention comprise additives that are imidazolium-based poly(ionic liquid)s.

Polymeric ionic liquids are considered key elements in various areas of material science. Poly(ionic liquid)s combine the unique properties of ionic liquids with the flexibility and properties of polymer architectures, offering novel properties and functions that are of great potential for a variety of applications.

Imidazolium salts are derivatives from imidazole rings via the alkylation of both nitrogen atoms in the heterocycles. While imidazoles have a strong ability to bind to metals as ligands and also to form hydrogen bonds with other suitable binding partners, the imidazolium salts have lost their metal-binding behavior and show a much weaker ability to hydrogen bonding as describes by Riduan, S. N.; Zhang, Y. Imidazolium salts and their polymeric materials for biological applications. Chemical Society Reviews 2013, 42 (23), 9055.

Imidazolium salts are a type of ionic liquid and have a high chemical and thermal stability. In addition, imidazolium groups can be introduced into many other polymer backbones, not just in the vinyl type. Those properties distinguish the polyimidazolium compounds from polyvinylimidazoles described before in CMP applications.

Key element for influencing erosion and dishing is the electrostatic interaction of polymer additives with differently charged surfaces. Polymers based on 1-vinylimidazole or imidazolium compounds can be clearly differentiated in their pH-dependence on the corresponding cations. The pKa values can be used to reveal the acidic nature of imidazolium or imidazole cations. While pKa values of vinylimidazole monomer are given as 6.79, the pKa for polyvinylimidazoles have values in the range from 3.6 - 4.9. Journal of Materials Research 2009, 24 (5), 1700.

On the other hand, pKa values of simple 1,3-dialkylimidazolium cations in DMSO or water were determined and ranged from 21 - 24. Molecules 2009, 14 (9), 3780. Despite the fact that these numbers are only partially comparable and depend on several factors, the general difference between polyimidazoles and polyimidazolium-based polymers should be clear: the nature of the imidazolium groups allows to use these additives in CMP over much wider pH range. In other words, polyimidazolium-based compounds interact electrostatically in much broader pH ranges than their parent polyimidazole materials. Even under acidic conditions, under which tungsten CMP is typically carried out, the degree of ionization of polyvinylimidazoles is often not complete, depending on the accessibility of the imidazole groups in the polymer network. The Journal of Physical Chemistry B 2008, 112 (33), 10123. Polyimidazolium polymers already carry the cation and are not influenced by incomplete ionization behavior in CMP applications.

In principal, it is not important for the mode of action to which polymer backbone the imidazolium group is attached, or which type of polymerization reaction is used. In addition, copolymers that are either randomly or block-like linked are part of the current solution if they have imidazolium groups in the main, side chains, or in both main chain and side chain.

It is considered that imidazolium-based poly(ionic liquid)s in the CMP slurries can adhere to tungsten surface and form a protective film. Oxidation of tungsten is inhibited, thereby reducing tungsten removal rate, and thus preventing over polishing or, in other words, dishing or erosion.

Furthermore, the present disclosure encompasses several controlled radical polymerization techniques, such as reversible addition-fragmentation chain-transfer polymerization (RAFT), which are not covered in related patent literatures. By using such controlled processes, the specific design of a material with optimized molecular weight and polydispersity is possible, which is a clear distinguishing feature from other described polymers in CMP applications.

The imidazolium-based poly(ionic liquid) is a cationic polymer having imidazolium groups either in the main chain (a main chain imidazolium polymer), or in the side chain (a side chain imidazolium polymer), or in both main chain and side chain as described above.

The macromolecules described above have been found to interact with the tungsten surface and inhibit removal of the metal, making them promising candidates for overall topography control and specifically for reducing dishing and erosion.

Examples of the imidazolium-based poly(ionic liquid)s include, but are not limited to poly(vinyl benzyl 1-butyl-1*H*-imidazol-3-ium) chloride, poly(vinyl 3-ethyl-1*H-*imidazol-3-ium) bromide, poly(vinyl benzyl 1-butyl-1*H*-imidazol-3-ium-co-acrylamide) chloride, poly(vinyl benzyl 1-butyl-1*H*-imidazol-3-ium-co-acrylomorpholine) chloride, poly(vinyl 3-ethyl-1*H*-imidazol-3-ium-co-*N*-vinylpyrrolidone) bromide, poly(vinyl benzyl 1-butyl-1H-imidazol-3-ium-co-N-methyl maleimide) chloride, poly 3-butyl-1H-imidazol-3-ium acetate, and poly 3-(2,2'-(ethane-1,2-diylbis(oxy))bis(ethane)-1*H*-imidazol-3-ium acetate.

Examples of synthesized imidazolium-based cationic polymer are:
(1) poly(vinyl benzene 1-butyl-1H-imidazol-3-ium) chloride: 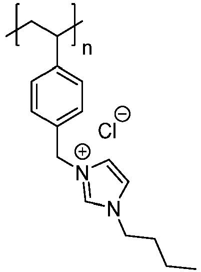 wherein n is 5 to 2000, 10 to 1000 or 20 to 500;
(2) poly(vinyl 3-ethyl-1H-imidazol-3-ium) bromide: 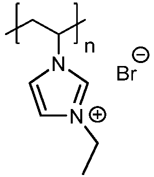 wherein n is 5 to 2000, 10 to 1000 or 20 to 500;
(3) poly (vinyl benzyl 1-butyl-1*H*-imidazol-3-ium-co-acrylamide) chloride: 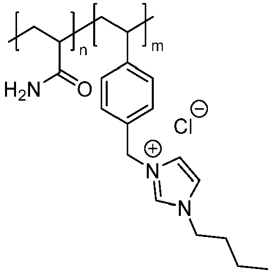 wherein n, m each independently is 5 to 2000, 10 to 1000 or 20 to 500;
(4) poly(vinyl benzyl 1-butyl-1*H*-imidazol-3-ium-co-acrylomorpholine) chloride: 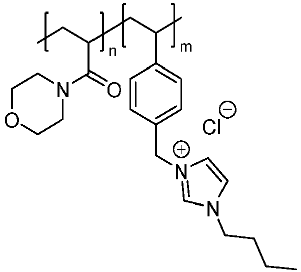 wherein n, m each independently is 5 to 2000, 10 to 1000 or 20 to 500;
(5) poly(vinyl 3-ethyl-1*H*-imidazol-3-ium-co-*N*-vinylpyrrolidone) bromide: 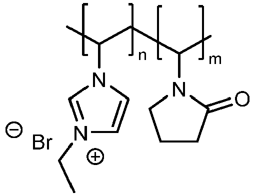 wherein n, m each independently is 5 to 2000, 10 to 1000 or 20 to 500;
(6) poly(vinyl benzyl 1-butyl-1*H*-imidazol-3-ium-co-*N*-methyl maleimide) chloride: 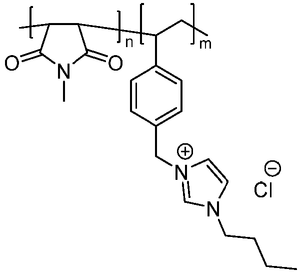 wherein n, m each independently is 5 to 1000, 10 to 750 or 20 to 500;
(7) poly 3-butyl-1*H*-imidazol-3-ium acetate: 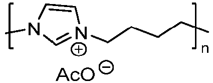 wherein n is 5 to 1000, 10 to 500 or 20 to 250;
(8) poly 3-(2,2'-(ethane-1,2-diylbis(oxy))bis(ethane)-1H-imidazol-3-ium acetate: 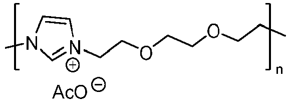 wherein n is 5 to 1000, 10 to 500 or 20 to 250;
(9) poly(vinyl 3-butyl-1*H*-imidazol-3-ium) bromide: 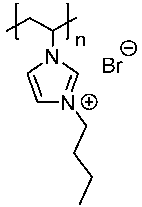 wherein n is 5 to 2000, 10 to 1000 or 20 to 500;
(10) poly(vinylbenzyl-1-ethyl-1*H*-imidazol-3-ium) chloride: 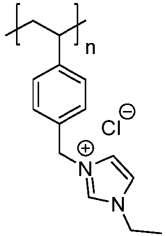 wherein n is 5 to 2000, 10 to 1000 or 20 to 500;
(11) poly(vinyl 3-ethyl-1*H*-imidazol-3-ium-co-vinyl 3,3'-butane-1*H*-imidazol-3-ium) bromide: 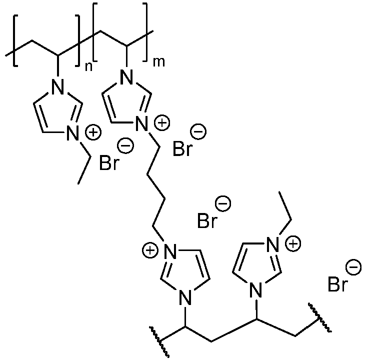 wherein n is 5 to 2000, 10 to 1000 or 20 to 500 and m is 1 to 100 or 1 to 25;
(12) poly(vinylbenzyl-1-ethyl-1*H*-imidazol-3-ium-co-vinyl-3-ethyl-1*H*-imidazol-3-ium) bromide chloride: 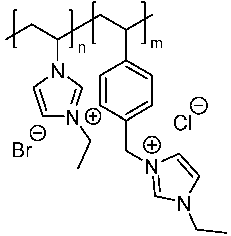 wherein n, m each independently is 5 to 2000, 10 to 1000 or 20 to 500;
(13) poly(1-ethyl-3-propyl-1H-imidazol-3-ium acrylate) bromide 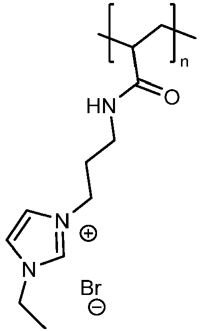 wherein n is 5 to 2000, 10 to 1000 or 20 to 500;
(14) poly(vinyl 3-isopropyl-1*H*-imidazol-3-ium) bromide 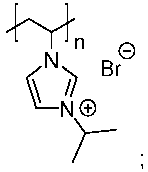 wherein n is 5 to 2000, 10 to 1000 or 20 to 500;
(15) poly(vinyl 3-isopropyl-1*H*-imidazol-3-ium-co-*N*-vinylpyrrolidone) bromide 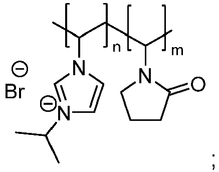 wherein n, m each independently is 5 to 2000, 10 to 1000 or 20 to 500;
(16) poly(vinyl 3-butyl-1*H*-imidazol-3-ium-co-*N*-vinylpyrrolidone) bromide 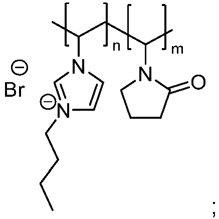 wherein n, m each independently is 5 to 2000, 10 to 1000 or 20 to 500;
(17) poly(vinyl 3-ethyl-1*H*-imidazol-3-ium) acetate 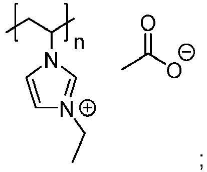 wherein n is 5 to 2000, 10 to 1000 or 20 to 500;
(18) poly(vinyl 3-ethyl-1*H*-imidazol-3-ium) malonate 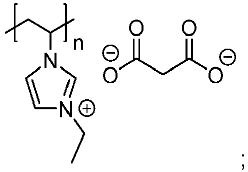 wherein n is 5 to 2000, 10 to 1000 or 20 to 500;
(19) poly(vinyl 3-ethyl-1*H*-imidazol-3-ium) nitrate 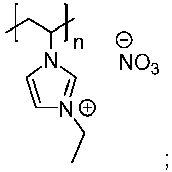 wherein n is 5 to 2000, 10 to 1000 or 20 to 500.

The additive has a concentration ranging from about 0.00001 wt.% to 1.0 wt.%, preferably about 0.0001 wt.% to 0.5 wt.%, and more preferably 0.0005 wt.% to 0.1 wt. %.

### Oxidizing Agent

The CMP slurries of the present invention comprise an oxidizing agent or an oxidizer for chemical etching of material. Any suitable oxidizing agent can be used.

The oxidizing agent of the CMP slurry is in a fluid composition which contacts the substrate and assists in the chemical removal of targeted material on the substrate surface. The oxidizing agent component is thus believed to enhance or increase the material removal rate of the composition. Preferably, the amount of oxidizing agent in the composition is sufficient to assist the chemical removal process, while being as low as possible to minimize handling, environmental, or similar or related issues, such as cost.

Advantageously, in one embodiment of this invention, the oxidizer is a component which will, upon exposure to at least one activator, produce free radicals giving an increased etching rate on at least selected structures. The free radicals described infra will oxidize most metals and will make the surface more susceptible to oxidation from other oxidizers. However, oxidizers are listed separately from the "Compound Producing Free Radicals", to be discussed infra, because some oxidizers do not readily form free radicals when exposed to the activators, and in some embodiments it is advantageous to have one or more oxidizers which provide matched etching or preferential etching rates on a variety of combinations of metals which may be found on a substrate.

As is known in the art, some oxidizers are better suited for certain components than for other components. In some embodiments of this invention, the selectivity of the CMP system to one metal as opposed to another metal is maximized, as is known in the art. However, in certain embodiments of present invention, the combination of oxidizers is selected to provide substantially similar CMP rates (as opposed to simple etching rates) for a conductor and a barrier combination.

In one embodiment, the oxidizing agent is an inorganic or organic per-compound.

A per-compound is generally defined as a compound containing an element in its highest state of oxidation, such as perchloric acid; or a compound containing at least one peroxy group 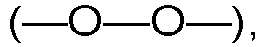 such as peracetic acid and perchromic acid.

Suitable per-compounds containing at least one peroxy group include, but are not limited to, peracetic acid or salt thereof, a percarbonate, and an organic peroxide, such as benzoyl peroxide, urea hydrogen peroxide, and/or di-t-butyl peroxide.

Suitable per-compounds containing at least one peroxy group include peroxides. As used herein, the term "peroxides" encompasses 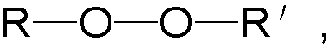 where R and R' are each independently H, a C₁ to C₆ straight or branched alkyl, alkanol, carboxylic acid, ketone (for example), or amine, and each of the above can independently be substituted with one or more benzyl group (for example benzoyl peroxide) which may themselves be substituted with OH or C₁-C₅ alkyls, and salts and adducts thereof. This term therefore includes common examples such as hydrogen peroxide, peroxyformic acid, peracetic acid, propaneperoxoic acid, substituted or unsubstituted butaneperoxoic acid, hydroperoxy-acetaldehyde, also encompassed in this term are common complexes of peroxides, for example urea peroxide.

Suitable per-compounds containing at least one peroxy group include persulfates. As used herein, the term "persulfates" encompasses monopersulfates, di-persulfates, and acids and salts and adducts thereof. Included for example is peroxydisulfates, peroxymonosulfuric acid and/or peroxymonosulfates, Caro's acid, including for example a salt such as potassium peroxymonosulfate, but preferably a non-metallic salt such as ammonium peroxymonosulfate.

Suitable per-compounds containing at least one peroxy group include perphosphates, defined as above and including peroxydiphosphates.

Also, ozone is a suitable oxidizing agent either alone or in combination with one or more other suitable oxidizing agents.

Suitable per-compounds that do not contain a peroxy group include, but are not limited to, periodic acid and/or any periodiate salt (hereafter "periodates"), perchloric acid and/or any perchlorate salt (hereafter "perchlorates") perbromic acid and/or any perbromate salt (hereafter "perbromates"), and perboric acid and/or any perborate salt (hereafter "perbromates").

Other oxidizing agents are also suitable components of the composition of the present invention. Iodates are useful oxidizers.

Two and more oxidizers may also be combined to obtain synergistic performance benefits.

In most embodiments of the present invention, the oxidizer is selected from the group consisting of peroxy compound selected from the group consisting of hydrogen peroxide, urea peroxide, peroxyformic acid, peracetic acid, propaneperoxoic acid, substituted or unsubstituted butaneperoxoic acid, hydroperoxy-acetaldehyde, potassium periodate, ammonium peroxymonosulfate; and non-per-oxy compound selected from the group consisting of ferric nitrite, KClO₄, KBrO₄, KMnO₄.

In some embodiments, the preferred oxidizer is hydrogen peroxide.

The oxidizer concentration can range from about 0.01 wt.% to 30 wt.% while the preferred concentration of oxidizing agents is from about 0.1 wt.% to 20 wt.%, and the more preferred concentration of oxidizing agents is from about 0.5 wt.% to about 10 wt.%. The weight percent is relative to the composition.

### Activator

An activator or a catalyst, is a material that interacts with an oxidizing agent and facilitates the formation of free radicals by at least one free radical-producing compounds present in the fluid.

The activator can be a metal-containing compound, in particular a metal selected from the group consisting of the metals known to activate a Fenton's Reaction process in the presence of an oxidizing agent such as, hydrogen peroxide.

The activator may be a non-metal-containing compound. Iodine is a useful with for example hydrogen peroxide to form free radicals.

If the activator is a metal ion, or metal-containing compound, it is in a thin layer associated with a surface of a solid which contacts the fluid. If the activator is a non-metal-containing substance, it can be dissolved in the fluid. It is preferred that the activator is present in amount that is sufficient to promote the desired reaction.

The activator includes, but is not limited to, (1) inorganic oxide particle with transition metal coated onto its surface, where the transition metal is selected from the group consisting of iron, copper, manganese, cobalt, cerium, and combinations thereof; (2)soluble catalyst includes, but is not limited to ammonium iron (III) oxalate trihydrate, iron(III) citrate tribasic monohydrate, iron(III) acetylacetonate and ethylenediamine tetraacetic acid, iron (III) sodium salt hydrate, a metal compound having multiple oxidation states selected from the group consisting of Ag, Co, Cr, Cu, Fe, Mo, Mn, Nb, Ni, Os, Pd, Ru, Sn, Ti, V; and combinations thereof.

The amount of activator in a slurry ranges from about 0.00001 wt.% to 5 wt.%, preferably about 0.0001 wt. % to 2.0 wt. %, more preferably about 0.0005 wt. % to 1.0 wt.%; and most preferably between 0.001 wt. % to 0.5 wt.%.

### Water

The polishing compositions are aqueous-based and, thus, comprise water. In the compositions, water functions in various ways such as, for example, to dissolve one or more solid components of the composition, as a carrier of the components, as an aid in the removal of polishing residue, and as a diluent. Preferably, the water employed in the cleaning composition is de-ionized (DI) water.

It is believed that, for most applications, water will comprise, for example, from about 10 to about 90% by weight or 90 wt. % of water. Other preferred embodiments could comprise from about 30 to about 95 wt. % of water. Yet other preferred embodiments could comprise from about 50 to about 90 wt. % % of water. Still other preferred embodiments could include water in an amount to achieve the desired weight percent of the other ingredients.

### Corrosion Inhibitor (Optional)

Corrosion inhibitors used in the CMP compositions disclosed herein include, but are not limited to, nitrogenous cyclic compounds such as 1,2,3-triazole, 1,2,4-triazole, 1,2,3-benzotriazole, 5-methylbenzotriazole, benzotriazole, 1-hydroxybenzotriazole, 4-hydroxybenzotriazole, 3-amino-1,2,4-triazole, 4-amino-4H-1,2,4-triazole, 5 amino triazole, benzimidazole, benzothiazoles such as 2,1,3-benzothiadiazole, triazinethiol, triazinedithiol, and triazinetrithiol, pyrazoles, imidazoles, isocyanurate such as 1,3,5-tris(2-hydroxyethyl), and mixtures thereof. Preferred inhibitors are 1,2,4-triazole, 5 amino triazole and 1,3,5-tris(2-hydroxyethyl)isocyanurate.

The CMP compositions disclosed herein preferably contain less than 1.0 wt.%, preferably less than 0.5 wt.%, or more preferably less than 0.25 wt. %.

### Dishing Reducing Agent (Optional)

The CMP composition may further comprise a dishing reducing agent or a dishing reducer selected from the group consisting of sarcosinate and related carboxylic compounds; hydrocarbon substituted sarcosinate; amino acids; organic polymers and copolymers having molecules containing ethylene oxide repeating units, such as polyethylene oxide (PEO); ethoxylated surfactants; nitrogen containing heterocycles without nitrogen-hydrogen bonds, sulfide, oxazolidine or mixture of functional groups in one compound; nitrogen containing compounds having three or more carbon atoms that form alkylammonium ions; amino alkyls having three or more carbon atoms; polymeric corrosion inhibitor comprising a repeating group of at least one nitrogen-containing heterocyclic ring or a tertiary or quaternary nitrogen atom; polycationic amine compound; cyclodextrin compound; polyethyleneimine compound; glycolic acid; chitosan; sugar alcohols; polysaccharides; alginate compound; phosphonium compound; sulfonic acid polymer. Glycine is a preferred dishing reducing agent.

Where the dishing reducing agent is present, the amount of dishing reducing agent ranges from about 0.001 wt.% to 2.0 wt. %, preferably 0.005 wt.% to 1.5 wt. %, and more preferably 0.01 wt.% to 1.5 wt. % based on weight per weight of the entire CMP composition.

### Stabilizers (Optional)

The composition may also include one or more of various optional additives. Suitable optional additives include stabilization agents. These optional additives are generally employed to facilitate or promote stabilization of the composition against settling, flocculation (including precipitation, aggregation or agglomeration of particles, and the like), and decomposition. Stabilizers can be used to extend the pot-life of the oxidizing agent(s), including compounds that produce free radicals, by isolating the activator material, by quenching free radicals, or by otherwise stabilizing the compounds that form free radicals.

Some materials are useful to stabilize hydrogen peroxide. One exception to the metal contamination is the presence of selected stabilizing metals such as tin. In some embodiments of this invention, tin can be present in small quantities, typically less than about 25 ppm, for example between about 3 and about 20 ppm. Similarly, zinc is often used as a stabilizer. In some embodiments of this invention, zinc can be present in small quantities, typically less than about 20 ppm, for example between about 1 and about 20 ppm. In another preferred embodiment the fluid composition contacting the substrate has less than 500 ppm, for example less than 100 ppm, of dissolved metals, except for tin and zinc, having multiple oxidation states. In the most preferred commercial embodiments of this invention, the fluid composition contacting the substrate has less than 9 ppm of dissolved metals having multiple oxidation states, for example less than 2 ppm of dissolved metals having multiple oxidation states, except for tin and zinc. In some preferred embodiments of this invention, the fluid composition contacting the substrate has less than 50 ppm, preferably less than 20 ppm, and more preferably less than 10 ppm of dissolved total metals, except for tin and zinc.

As metals in solution are generally discouraged, it is preferred that those non-metal-containing oxidizers that are typically present in salt forms, for example persulfates, are in the acid form and/or in the ammonium salt form, such as ammonium persulfate.

Other stabilizers include free radical quenchers. As discussed, these will impair the utility of the free radicals produced. Therefore, it is preferred that if present they are present in small quantities. Most antioxidants, i.e., vitamin B, vitamin C, citric acid, and the like, are free radical quenchers. Most organic acids are free radical quenchers, but three that are effective and have other beneficial stabilizing properties are phosphonic acid, the binding agent oxalic acid, and the non-radical-scavenging sequestering agent gallic acid.

In addition, it is believed that carbonate and phosphate will bind onto the activator and hinder access of the fluid. Carbonate is particularly useful as it can be used to stabilize a slurry, but a small amount of acid can quickly remove the stabilizing ions. Stabilization agents useful for absorbed activator can be film forming agents forming films on the silica particle.

Suitable stabilizing agents include organic acids, such as adipic acid, phthalic acid, citric acid, malonic acid, orthophthalic acid; and phosphoric acid; substituted or unsubstituted phosphonic acids, i.e., phosphonate compounds; nitriles; and other ligands, such as those that bind the activator material and thus reduce reactions that degrade the oxidizing agent, and any combination of the foregoing agents. As used herein, an acid stabilizing agent refers to both the acid stabilizer and its conjugate base. That is, the various acid stabilizing agents may also be used in their conjugate form. By way of example, herein, an adipic acid stabilizing agent encompasses adipic acid and/or its conjugate base, a carboxylic acid stabilizing agent encompasses carboxylic acid and/or its conjugate base, carboxylate, and so on for the above mentioned acid stabilizing agents. A suitable stabilizer, used alone or in combination with one or more other stabilizers, decreases the rate at which an oxidizing agent such as hydrogen peroxide decomposes when admixed into the CMP slurry.

On the other hand, the presence of a stabilization agent in the composition may compromise the efficacy of the activator. The amount should be adjusted to match the required stability with the lowest adverse effect on the effectiveness of the CMP system. In general, any of these optional additives should be present in an amount sufficient to substantially stabilize the composition. The necessary amount varies depending on the particular additive selected and the particular makeup of the CMP composition, such as the nature of the surface of the abrasive component. If too little of the additive is used, the additive will have little or no effect on the stability of the composition. On the other hand, if too much of the additive is used, the additive may contribute to the formation of undesirable foam and/or flocculant in the composition.

Generally, suitable amounts of these stabilizer range from about 0.0001 to 5 wt.% relative to the composition, preferably from about 0.0005 to 2 wt.%, and more preferably from about 0.001 to about 1 wt.%. The stabilizer may be added directly to the composition or applied to the surface of the abrasive component of the composition.

### pH Adjusting Agent (Optional)

Compositions disclosed herein comprise pH adjusting agents. A pH adjusting agent is typically employed in the compositions disclosed herein to raise or lower the pH of the polishing composition. The pH-adjusting agent may be used to improve the stability of the polishing composition, to tune the ionic strength of the polishing composition, and to improve the safety in handling and use, as needed.

Suitable pH-adjusting agents to lower the pH of the polishing composition include, but are not limited to, nitric acid, sulfuric acid, tartaric acid, succinic acid, citric acid, malic acid, malonic acid, various fatty acids, various polycarboxylic acids and mixtures thereof. Suitable pH-adjusting agents to raise the pH of the polishing composition include, but are not limited to, potassium hydroxide, sodium hydroxide, ammonia, tetraethylammonium hydroxide, ethylenediamine, piperazine, polyethyleneimine, modified polyethyleneimine, and mixtures thereof.

When employed, the amount of pH-adjusting agent preferably ranges from about 0.01 wt.% to about 5.0 wt.% relative to the total weight of the polishing composition. The preferred range is from about 0.01 wt.% to about 1 wt.% or from about 0.05 wt.% to about 0.15 wt.%.

The pH of the slurry is between 1 and 14, preferably is between 1 and 7, more preferably is between 1 and 6, and most preferably is between 1 and 4.

### Surfactant (Optional)

The compositions disclosed herein optionally comprise a surfactant, which, in part, aids in protecting the wafer surface during and after polishing to reduce defects in the wafer surface. Surfactants may also be used to control the removal rates of some of the films used in polishing such as low-K dielectrics. Suitable surfactants include non-ionic surfactants, anionic surfactants, cationic surfactants, ampholytic surfactants, and mixtures thereof.

Non-ionic surfactants may be chosen from a range of chemical types including but not limited to long chain alcohols, ethoxylated alcohols, ethoxylated acetylenic diol surfactants, polyethylene glycol alkyl ethers, propylene glycol alkyl ethers, glucoside alkyl ethers, polyethylene glycol octylphenyl ethers, polyethylene glycol alkylphenyl ethers, glycerol alkyl esters, polyoxyethylene glycol sorbiton alkyl esters, sorbiton alkyl esters, cocamide monoethanol amine, cocamide diethanol amine dodecyl dimethylamine oxide, block-copolymers of polyethylene glycol and polypropylene glycol, polyethoxylated tallow amines, fluorosurfactants.

Molecular weight of surfactants may range from several hundreds to over 1 million. The viscosities of these materials also possess a very broad distribution.

Anionic surfactants include, but are not limited to salts with suitable hydrophobic tails, such as alkyl carboxylate, alkyl polyacrylic salt, alkyl sulfate, alkyl phosphate, alkyl bicarboxylate, alkyl bisulfate, alkyl biphosphate, such as alkoxy carboxylate, alkoxy sulfate, alkoxy phosphate, alkoxy bicarboxylate, alkoxy bisulfate, alkoxy biphosphate, such as substituted aryl carboxylate, substituted aryl sulfate, substituted aryl phosphate, substituted aryl bicarboxylate, substituted aryl bisulfate, and substituted aryl biphosphate etc. The counter ions for this type of surfactants include, but are not limited to potassium, ammonium and other positive ions. The molecular weights of these anionic surface wetting agents range from several hundred to several hundred-thousand.

Cationic surfactants possess the positive net charge on major part of molecular frame. Cationic surfactants are typically halides of molecules comprising hydrophobic chain and cationic charge centers such as amines, quaternary ammonium, benzyalkonium, and alkylpyridinium ions.

In another aspect, the surfactant can be an ampholytic surfactant, which possess both positive (cationic) and negative (anionic) charges on the main molecular chains and with their relative counter ions. The cationic part is based on primary, secondary, or tertiary amines or quaternary ammonium cations. The anionic part can be more variable and include sulfonates, as in the sultaines CHAPS (3-[(3-Cholamidopropyl)dimethylammonio]-1-propanesulfonate) and cocamidopropyl hydroxysultaine. Betaines such as cocamidopropyl betaine have a carboxylate with the ammonium. Some of the ampholytic surfactants may have a phosphate anion with an amine or ammonium, such as the phospholipids phosphatidylserine, phosphatidylethanolamine, phosphatidylcholine, and sphingomyelins.

Examples of surfactants also include, but are not limited to, dodecyl sulfate sodium salt, sodium lauryl sulfate, dodecyl sulfate ammonium salt, secondary alkane sulfonates, alcohol ethoxylate, acetylenic surfactant, and any combination thereof. Examples of suitable commercially available surfactants include TRITON^{™}, Tergitol^{™}, DOWFAX^{™} family of surfactants manufactured by Dow Chemicals and various surfactants in SURFYNOL^{™}, DYNOL^{™}, Zetasperse^{™}, Nonidet^{™}, and Tomadol^{™} surfactant families, manufactured by Air Products and Chemicals. Suitable surfactants of surfactants may also include polymers comprising ethylene oxide (EO) and propylene oxide (PO) groups. An example of EO-PO polymer is Tetronic^{™} 90R4 from BASF Chemicals.

When employed, the amount of surfactant typically ranges from 0.0001 wt.% to about 1.0 wt.% relative to the total weight of the barrier CMP composition. When employed, the preferred range is from about 0.010 wt.% to about 0.1 wt.%.

### Chelating Agent (Optional)

Chelating agents may optionally be employed in the compositions disclosed herein to enhance affinity of chelating ligands for metal cations. Chelating agents may also be used to prevent build-up of metal ions on pads which causes pad staining and instability in removal rates. Suitable chelating agents include, but are not limited to, for example, amine compounds such as ethylene diamine, amino poly-carboxylic acids such as ethylene diamine tetraacetic acid (EDTA), nitrilotriacetic acid (NTA); aromatic acids such as benzenesulfonic acid, 4-tolyl sulfonic acid, 2,4-diamino-benzosulfonic acid, and etc.; non-aromatic organic acids, such as itaconic acid, malic acid, malonic acid, tartaric acid, citric acid, oxalic acid, gluconic acid, lactic acid, mandelic acid, or salts thereof; various amino acids and their derivatives such as Glycine, Serine, Proline, Histidine, Isoleucine, Leucine, Lysine, Methionine, Phenylalanine, Threonine, Tryptophan, Valine, Arginine, Asparagine, Aspartic acid, cystein, Glutamic acid, Glutamine, Ornithine, Selenocystein, Tyrosine, Sarcosine, Bicine, Tricine, Aceglutamide, N-Acetylaspartic acid, Acetylcarnitine, Acetylcysteine, N-Acetylglutamic acid, Acetylleucine, Acivicin, S-Adenosyl-L-homocysteine, Agaritine, Alanosine, Aminohippuric acid, L-Arginine ethyl ester, Aspartame, Aspartylglucosamine, Benzylmercapturic acid, Biocytin, Brivanib alaninate, Carbocisteine, N(6)-Carboxymethyllysine, Carglumic acid, Cilastatin, Citiolone, Coprine, Dibromotyrosine, Dihydroxyphenylglycine, Eflornithine, Fenclonine, 4-Fluoro-L-threonine, N-Formylmethionine, Gamma-L-Glutamyl-L-cysteine, 4-(y-Glutamylamino)butanoic acid, Glutaurine, Glycocyamine, Hadacidin, Hepapressin, Lisinopril, Lymecycline, N-Methyl-D-aspartic acid, N-Methyl-L-glutamic acid, Milacemide, Nitrosoproline, Nocardicin A, Nopaline, Octopine, Ombrabulin, Opine, Orthanilic acid, Oxaceprol, Polylysine, Remacemide, Salicyluric acid, Silk amino acid, Stampidine, Tabtoxin, Tetrazolylglycine, Thiorphan, Thymectacin, Tiopronin, Tryptophan tryptophylquinone, Valaciclovir, Valganciclovir, and phosphonic acid and its derivatives such as, for example, octylphosphonic acid, aminobenzylphosphonic acid, and combinations thereof and salts thereof.

Chelating agents may be employed where there is a need to chemically bond, for example, copper cations and tantalum cations to accelerate the dissolution of copper oxide and tantalum oxide to yield the desirable removal rates of copper lines, vias, or trenches and barrier layer, or barrier films.

When employed, the amount of chelating agent preferably ranges from about 0.01 wt.% to about 3.0 wt.% relative to the total weight of the composition and, more preferably, from about 0.4 wt.% to about 1.5 wt.%.

### Biocide (Optional)

CMP formulations disclosed herein may also comprise additives to control biological growth such as biocides. Some of the additives to control biological growth are disclosed in U.S. Pat. No. 5,230,833 and U.S. patent application Publication No. 2002/0025762. Biological growth inhibitors include but are not limited to tetramethylammonium chloride, tetraethylammonium chloride, tetrapropylammonium chloride, alkylbenzyldimethylammonium chloride, and alkylbenzyldimethylammonium hydroxide, wherein the alkyl chain ranges from 1 to about 20 carbon atoms, sodium chlorite, sodium hypochlorite, isothiazolinone compounds such as methylisothiazolinone, methylchloroisothiazolinone and benzisothiazolinone. Some of the commercially available preservatives include KATHON^{™} and NEOLENE^{™} product families from Dow Chemicals and Preventol^{™} family from Lanxess.

The preferred biocides are isothiozilone compounds such as methylisothiazolinone, methylchloroisothiazolinone and benzisothiazolinone.

The CMP polishing compositions optionally contain a biocide ranging from 0.0001 wt.% to 0.10 wt.%, preferably from 0.0001 wt.% to 0.005 wt.%, and more preferably from 0.0002 wt.% to 0.0025 wt.% to prevent bacterial and fungal growth during storage.

Compositions disclosed herein may be manufactured in a concentrated form and subsequently diluted at the point of use with DI water. Other components such as, for example, the oxidizer, may be withheld in the concentrate form and added at the point of use to minimize incompatibilities between components in the concentrate form. The compositions disclosed herein may be manufactured in two or more components which can be mixed prior to use.

### Working Examples

### General Experimental Procedure

All percentages are weight percentages unless otherwise indicated.

### Part I Synthesis Imidazolium-based Poly(ionic liquid)s

The present disclosure encompasses several controlled radical polymerization techniques, such as reversible addition-fragmentation chain-transfer polymerization (RAFT). By using such controlled processes, the specific design of a material with optimized molecular weight and polydispersity is possible, which is a clear distinguishing feature from other described polymers in CMP applications.

All reagents and solvents were purchased from Sigma-Aldrich (Merck) of highest commercial grade and used as received unless otherwise specified.

### Characterization Methods

NMR spectra were recorded on a 500 MHz Bruker Avance II+ spectrometer using deuterated solvents from Sigma-Aldrich (Merck). Chemical shifts were reported as d values (ppm) and were calibrated according to internal standard Si(OMe)₄ (0.00 ppm).

Polymers were analyzed by size exclusion chromatography (SEC) running in H₂O/MeOH/EtOAc (54/23/23, v/v/v) containing 10 mM sodium acetate at 40 °C (flow rate: 0.5 mL/min). Measurements were carried out on an Agilent 1260 HPLC, equipped with a column set consisting of PSS Novema pre-column and PSS Novema MAX ultraheigh column. The samples were dissolved in the eluent with 0.1% ethylenglycol as internal standard at 50 °C. The average molar mass of polymers was derived from refractive index signals based on poly(2-vinylpyridine) calibration curve.

### Example 1

### Synthesis of poly(vinyl benzyl 1-butyl-1H-imidazol-3-ium) chloride:

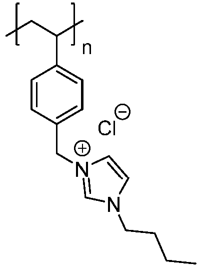

wherein n is 5 to 2000, 10 to 1000 or 20 to 500.

Monomer was synthesized as shown below:

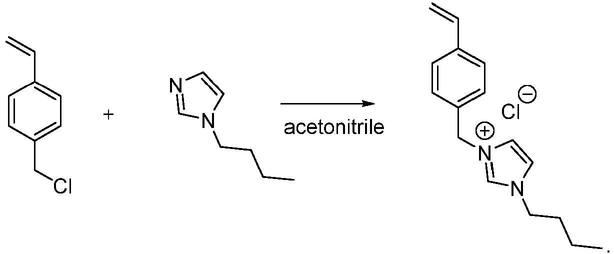

1-Butylimidazole (CAS: 4316-42-1, 6.2 g, 49 mmol), 4-vinylbenzyl chloride (CAS: 1592-20-7, 8.4 g, 55 mmol) and 2,6-di-*tert*-butyl-4-methylphenol (CAS: 128-37-0, 0.8 g, 3.6 mmol) were dissolved in acetonitrile (50 mL). The resulting solution was heated at 60 °C for 48 hours and then subsequently concentrated *in vacuo.* The viscous solution was added to methyl *tert*-butyl ether (MTBE, 200 mL). The white solid was separated, rinsed with MTBE and vacuum-dried resulting a white solid (10.5 g, 69% yield).

¹H NMR (500 MHz, Methanol-*d*₄): δ = 9.18 (d, *J =* 1.7 Hz, 1H), 7.68 (dt, *J =* 18.5, 2.0 Hz, 2H), 7.55 - 7.50 (m, 2H), 7.45 - 7.40 (m, 2H), 6.77 (dd, *J* = 17.6, 11.0 Hz, 1H), 5.85 (dd, *J* = 17.6, 0.9 Hz, 1H), 5.44 (s, 2H), 5.31 (dd, *J =* 11.0, 0.9 Hz, 1H), 4.26 (t, *J* = 7.3 Hz, 2H), 1.94 - 1.85 (m, 2H), 1.44 - 1.33 (m, 2H), 1.00 (t, *J* = 7.4 Hz, 3H) ppm.

The polymer was synthesized selected from the processes as shown below.

### Example 1-1:

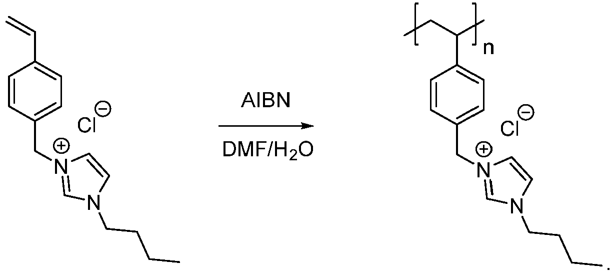

1-Butyl-3-(4-vinylbenzyl)-1*H*-imidazol-3-ium chloride (10.5 g, 38 mmol) and AIBN (CAS: 78-67-1, 32 mg, 0.19 mmol) were dissolved in 54 mL DMF/H₂O (1 : 1, v/v). The solution was purged with Ar for 30 min, heated at 65 °C for 24 h and then subsequently concentrated *in vacuo.* The crude product was dissolved in dichloromethane (10 mL) and precipitated by adding THF (100 mL) resulting a white solid after vacuum-drying (9.5 g, 90.5% yield).

¹H NMR (500 MHz, Methanol-*d*₄) δ: 9.58 - 9.48 (m, 1H), 7.75 - 7.60 (m, 2H), 7.36 - 7.13 (m, 2H), 6.50 - 6.33 (m, 2H), 5.55 - 5.42 (m, 2H), 4.29 - 4.26 (m, 2H), 1.93 - 1.86 (m, 2H), 1.65 - 1.24 (m, 5H), 1.02 - 0.93 (m, 3H) ppm.

SEC: Mn: 35.3 kDa; Mw: 106 kDa; PDI: 3.0.

### Example 1-2:

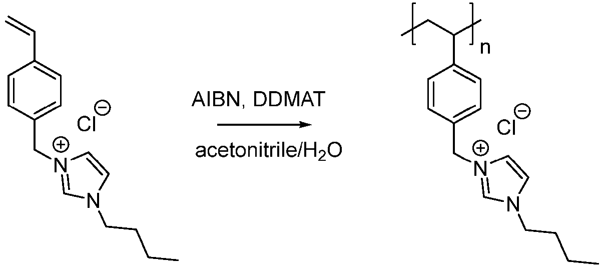

A Schlenk flask was charged with 1-butyl-3-(4-vinylbenzyl)-1*H*-imidazol-3-ium chloride (10.5 g, 38 mmol), AIBN (CAS: 78-67-1, 32 mg, 0.19 mmol) and 2-(dodecylthiocarbonothioylthio)-2-methylpropionic acid (DDMAT, CAS: 461642-78-4, 0.26 g, 0.7 mmol). The mixture was dissolved in acetonitrile/water (1 : 1, v/v), purged with Ar for 30 min and then heated at 65 °C for 16 h. The solution was freeze-dried, and the resulting solid was washed several times with acetonitrile and again freeze-dried (7.4 g, 70.5% yield).

SEC: Mn: 4.1 kDa; Mw: 5.6 kDa; PDI: 1.3.

### Example 1-3:

Following the same procedure as in Example 1-1 or Example 1-2 but using 0.077 g (0.21 mmol) DDMAT. 6.7 g (64 %) of a white polymer was obtained.

SEC: Mn: 10.3 kDa; Mw: 17.6 kDa; PDI: 1.7.

### Example 1-4:

Following the same procedure as in Example 1-1 or Example 1-2 but using 0.026 g (0.07 mmol) DDMAT. 8.2 g (78 %) of a white polymer was obtained.

SEC: Mn: 21.9 kDa; Mw: 40.3 kDa; PDI: 1.8.

### Example 2

### Synthesis of poly(vinyl 3-ethyl-1H-imidazol-3-ium) bromide

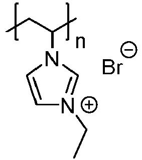

wherein n is 5 to 2000, 10 to 1000 or 20 to 500.

Monomer was synthesized as shown below:

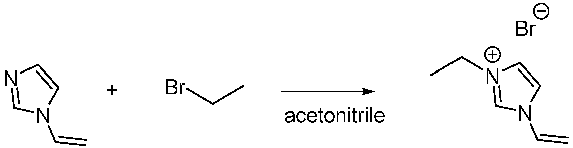

Bromoethane (CAS: 74-96-4, 45.8 g, 420.8 mmol) was dissolved in acetonitrile (100 mL). 1-Vinylimidazole (CAS: 1072-63-5, 20 g, 210 mmol) was added dropwise at room temperature. The reaction mixture was then stirred at 60 °C for 12 h, cooled to room temperature and added to ethyl acetate (1.2 L) whereby a white solid precipitated. The solid was washed 3 times with ethyl acetate and vacuum-dried (38 g, 89% yield).

¹H NMR (500 MHz, DMSO-d₆) δ: 9.60 (t, *J =* 1.6 Hz, 1H), 8.23 (t, *J =* 1.9 Hz, 1H), 7.98 (t, *J =* 1.8 Hz, 1H), 7.32 (dd, *J =* 15.7, 8.7 Hz, 1H), 5.99 (dd, *J =* 15.7, 2.4 Hz, 1H), 5.43 (dd, *J =* 8.7, 2.3 Hz, 1H), 4.25 (q, *J =* 7.3 Hz, 2H), 1.46 (t, *J =* 7.3 Hz, 3H) ppm.

The polymer was synthesized using the processes as shown below.

### Example 2-1:

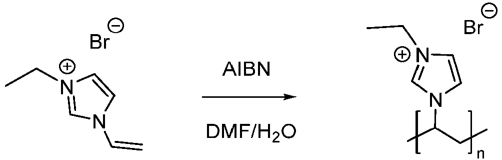

3-Ethyl-1-vinyl-1*H*-imidazole-3-ium bromide (7 g, 34.5 mmol) and AIBN (CAS: 78-67-1, 23 mg, 0.14 mmol) were dissolved in 40 mL DMF/H₂O (1 : 1, v/v). The solution was purged with Ar for 30 min, heated at 65 °C for 24 h, cooled to room temperature and precipitated by adding ethyl acetate resulting a white solid after vacuum-drying (6.4 g, 91 % yield).

¹H NMR (500 MHz, DMSO-d₆) δ: 9.44 (broad signal, 1H), 7.61 (broad signal, 2H), 4.31 (broad signal, 3H), 2.42 (broad signal, 2H), 1.40 (broad signal, 3H) ppm.

SEC: Mn: 19.6 kDa; Mw: 96.8 kDa, PDI: 5.0.

### Example 2-2:

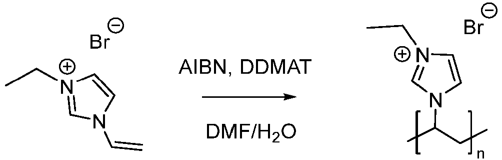

A Schlenk flask was charged with 3-ethyl-1-vinyl-1*H*-imidazole-3-ium bromide (5 g, 24.6 mmol), AIBN (CAS: 78-67-1, 5.4 mg, 0.03 mmol) and 2-(dodecylthio-carbonothioylthio)-2-methylpropionic acid (DDMAT, CAS: 461642-78-4, 36.5 mg, 0.1 mmol). The mixture was dissolved in acetonitrile/water (30 mL, 1 : 1, v/v), purged with Ar for 30 min and then heated at 65 °C for 18 h. Acetonitrile was removed, dichloromethane (10 mL) was added and the polymer was precipitated by adding THF. The precipitate was dried under vacuum, dissolved in water, and purified by crossflow filtration (PES, 10 kDa MWCO). The product was obtained as white solid after freeze-drying (4 g, 80 % yield).

SEC: Mn: 19.4 kDa; Mw: 32.1 kDa, PDI: 1.7.

### Example 2-3:

Following the same procedure as in Example 2-2 using 0.018 g (0.05 mmol) DDMAT. 2.9 g (58 %) of a white polymer was obtained.

SEC: Mn: 27.8 kDa; Mw: 47.8 kDa; PDI: 1.7.

### Example 3

### Synthesis of poly(vinyl benzyl 1-butyl-1H-imidazol-3-ium-co-acrylamide) chloride:

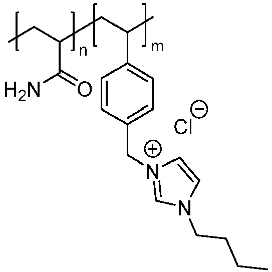

wherein n, m each independently is 5 to 2000, 10 to 1000 or 20 to 500.

Monomer obtained in Example 1 was used.

The polymer was synthesized using the processes as shown below.

### Example 3-1:

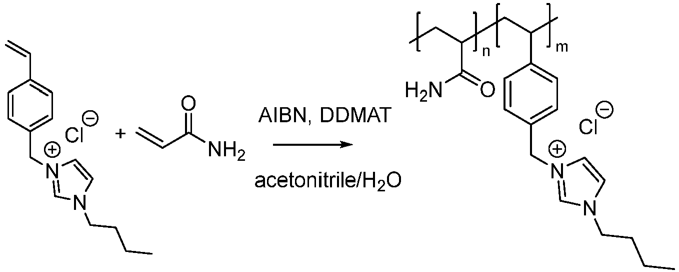

A Schlenk flask was charged with 1-butyl-3-(4-vinylbenzyl)-1*H*-imidazol-3-ium chloride (6 g, 21.7 mmol), acrylamide (CAS: 79-06-1, 1.56 g, 21.7 mmol), AIBN (CAS: 78-67-1, 36 mg, 0.217 mmol) and 2-(dodecylthiocarbonothioylthio)-2-methylpropionic acid (DDMAT, CAS: 461642-78-4, 0.18 g, 0.5 mmol). The mixture was dissolved in acetonitrile/water (1 : 1, v/v), purged with Ar for 30 min and then heated at 65 °C for 16 h. The solution was freeze-dried, and the resulting solid was washed several times with acetonitrile and again freeze-dried (5.2 g, 69 % yield).

SEC: Mn: 4.1 kDa; Mw: 5.9 kDa; PDI: 1.4.

### Example 3-2:

Following the same procedure as in Example 3-1 using 0.055 g (0.15 mmol) DDMAT. 7.1 g (94.2 %) of a white polymer was obtained.

SEC: Mn: 15.1 kDa; Mw: 27.4 kDa; PDI: 1.8.

### Example 3-3:

Following the same procedure as in Example 3 -1 using 0.028 g (0.077 mmol) DDMAT. 7.5 g (99.5 %) of a white polymer was obtained.

SEC: Mn: 20.9 kDa; Mw: 43.9 kDa; PDI: 2.1.

### Example 4

### Synthesis of poly(vinyl benzyl 1-butyl-1H-imidazol-3-ium-co-acrylomorpholine) chloride

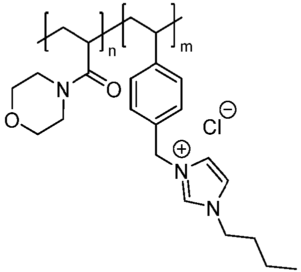

wherein n, m each independently is 5 to 2000, 10 to 1000 or 20 to 500.

Monomer obtained in Example 1 was used.

The polymer was synthesized using the processes as shown below.

### Example 4-1:

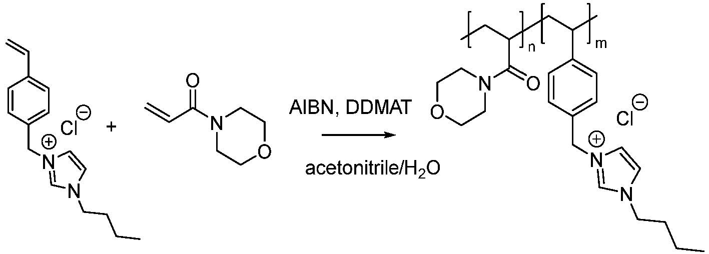

A Schlenk flask was charged with 1-butyl-3-(4-vinylbenzyl)-1*H*-imidazol-3-ium chloride (7 g, 25.3 mmol), 4-acryloylmorpholine (CAS: 5117-12-4, 3.68 g, 25.3 mmol), AIBN (CAS: 78-67-1, 41.3 mg, 0.25 mmol) and 2-(dodecylthiocarbonothioylthio)-2-methylpropionic acid (DDMAT, CAS: 461642-78-4, 0.26 g, 0.71 mmol). The mixture was dissolved in acetonitrile/water (1 : 1, v/v), purged with Ar for 30 min and then heated at 65 °C for 16 h. The solution was freeze-dried, and the resulting solid was washed several times with acetonitrile and again freeze-dried (8.4 g, 79 % yield).

SEC: Mn: 6.2 kDa; Mw: 14.3 kDa; PDI: 2.3.

### Example 4-2:

Following the same procedure as in Example 4-1 using 0.078 g (0.21 mmol) DDMAT. 7.3 g (68.9 %) of a white polymer was obtained.

SEC: Mn: 20.5 kDa; Mw: 43.6 kDa; PDI: 2.1.

### Example 4-3:

Following the same procedure as in Example 4-1 using 0.039 g (0.1 mmol) DDMAT. 8.7 g (82 %) of a white polymer was obtained.

SEC: Mn: 26.7 kDa; Mw: 73.4 kDa; PDI: 2.8.

### Example 5

### Synthesis of poly(vinyl 3-ethyl-1H-imidazol-3-ium-co-N-vinylpyrrolidone) bromide.

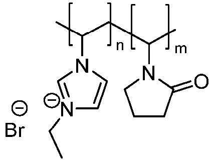

wherein n, m each independently is 5 to 2000, 10 to 1000 or 20 to 500.

### Example 5-1:

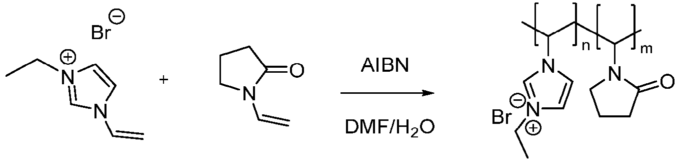

3-Ethyl-1-vinyl-1*H*-imidazole-3-ium bromide (5.25 g, 25.8 mmol), 1-vinyl-2-pyrrolidone (CAS: 88-12-0, 0.96 g, 8.6 mmol) and AIBN (CAS: 78-67-1, 19 mg, 0.12 mmol) were dissolved in 40 mL DMF/H₂O (1 : 1, v/v). The solution was purged with Ar for 30 min, heated at 65 °C for 24 h, cooled to room temperature and precipitated by adding ethyl acetate resulting a white solid after vacuum-drying (6 g, 97% yield).

¹H NMR (500 MHz, Deuterium Oxide) δ: 9.26 - 8.43 (m), 7.76 - 7.04 (m), 4.46 - 3.74 (m), signal, 2H), 2.91 (s), 2.44 (s), 2.18 - 1.78 (m), 1.58 - 1.02 (m) ppm.

SEC: Mn: 20 kDa; Mw: 107 kDa, PDI: 5.3

### Example 5-2:

Following the same procedure as example 5-1 using 4.67 g (23 mmol) 3-ethyl-1-vinyl-1*H*-imidazole-3-ium bromide and 1.28 g (11.5 mmol) 1-vinyl-2-pyrrolidone (CAS: 88-12-0). 5 g (84 %) of a white polymer was obtained.

SEC: Mn: 16 kDa; Mw: 110 kDa, PDI: 6.7

### Example 5-3:

Following the same procedure as example 5-1 using 4 g (19.7 mmol) 3-ethyl-1-vinyl-1*H*-imidazole-3-ium bromide and 2.19 g (19.7 mmol) 1-vinyl-2-pyrrolidone (CAS: 88-12-0). 5.3 g (86 %) of a white polymer was obtained.

SEC: Mn: 28 kDa; Mw: 144 kDa, PDI: 5.1

### Example 5-4:

Following the same procedure as example 5-1 using 3 g (14.8 mmol) 3-ethyl-1-vinyl-1*H*-imidazole-3-ium bromide and 3.3 g (29.5 mmol) 1-vinyl-2-pyrrolidone (CAS: 88-12-0). 4.5 g (71 %) of a white polymer was obtained.

SEC: Mn: 29 kDa; Mw: 160 kDa, PDI: 5.6

### Example 5-5:

Following the same procedure as example 5-1 using 2 g (9.5 mmol) 3-ethyl-1-vinyl-1*H*-imidazole-3-ium bromide and 4.4 g (39.4 mmol) 1-vinyl-2-pyrrolidone (CAS: 88-12-0). 5.2 g (81 %) of a white polymer was obtained.

SEC: Mn: 16 kDa; Mw: 192 kDa, PDI: 11.7

### Example 5-6:

A Schlenk flask was charged with 3-butyl-1-vinyl-1*H*-imidazol-3-ium bromide (5 g, 24.6 mmol), 1-vinyl-2-pyrrolidone (CAS:, 2.74 g, 24.6 mmol), AIBN (CAS: 78-67-1, 4.2 mg, 0.026 mmol) and 2-(dodecylthiocarbonothioylthio)-2-methylpropionic acid (DDMAT, CAS: 461642-78-4, 28 mg, 0.077 mmol). The mixture was dissolved in acetonitrile/water (60 mL, 1 : 1, v/v), purged with Ar for 30 min and then heated at 70 °C for 48 h. Acetonitrile was removed, dichloromethane (10 mL) was added, and the polymer was precipitated by adding THF. The precipitate was dried under vacuum, dissolved in water, and purified by crossflow filtration (PES, 10 kDa MWCO). The product was obtained as white solid after freeze-drying (6.7 g, 87 % yield).

SEC: Mn: 20.5 kDa; Mw: 86.4 kDa; PDI: 4.2.

### Example 5-7:

A Schlenk flask was filles with 3-butyl-1-vinyl-1*H*-imidazol-3-ium bromide (5 g, 24.6 mmol), AIBN (CAS: 78-67-1, 4.2 mg, 0.026 mmol) and 2-(dodecylthio-carbonothioylthio)-2-methylpropionic acid (DDMAT, CAS: 461642-78-4, 28 mg, 0.077 mmol). The mixture was dissolved in acetonitrile/water (60 mL, 1 : 1, v/v), purged with Ar for 30 min and then heated at 70 °C for 48 h. The reaction was cooled to room temperature, acetonitrile was removed, and the residue was treated with dichloromethane (10 mL) and precipitated into THF (100 mL). The precipitate was dried under vacuum, dissolved in water, and purified by crossflow filtration (PES, 10 kDa MWCO). The resulting polymer was concentrated to about 30 mL solution and treated with acetonitrile (30 mL). 1-Vinyl-2pyrrolidone (CAS:, 2.74 g, 24.6 mmol) and AIBN (CAS: 78-67-1, 4.2 mg, 0.026 mmol) were added and the mixture was purged with Ar for 30 min and then heated at 70 °C for 48 h. Acetonitrile was removed and the residue was treated with dichloromethane and precipitated into THF (100 mL). The crude product was purified by crossflow filtration (PES, 10 kDa MWCO) and freeze-dried to result 5.6 g, 73 %)

SEC: Mn: 17.8 kDa; Mw: 39.7 kDa; PDI: 2.2.

### Example 6

### Synthesis of poly(vinyl benzyl 1-butyl-1H-imidazol-3-ium-co-N-methyl maleimide) chloride

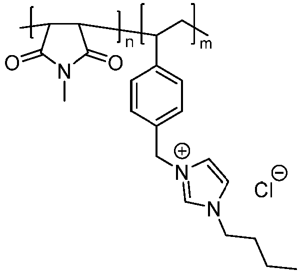

wherein n, m each independently is 5 to 2000, 10 to 1000 or 20 to 500.

### Example 6-1:

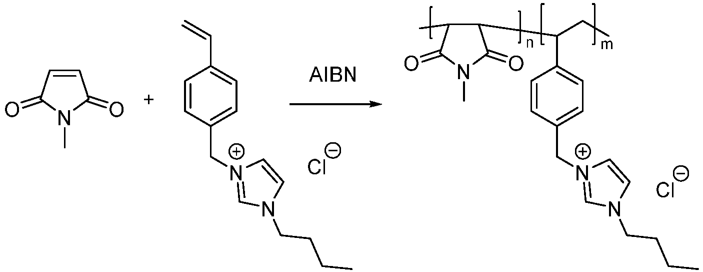

1-Butyl-3-(4-vinylbenzyl)-1*H*-imidazol-3-ium chloride (3.8 g, 13.7 mmol), *N-*methylmaleimide (CAS: 930-88-1, 1.53 g, 13.7 mmol) and AIBN (17.5 mg, 0.11 mmol) were dissolved in 32 mL acetonitrile/H₂O (1 : 1, v/v). The solution was purged with Ar for 30 min, heated at 65 °C for 24 h and subsequently concentrated *in vacuo.* The crude product was dissolved in dichloromethane (10 mL) and precipitated by adding THF (100 mL) resulting 4.8 g (90 %) polymer as a white solid.

¹H NMR (500 MHz, DMSO-*d*₆) δ: 8.54 - 7.82 (m), 7.47 - 7.38 (m), 7.08 - 6.24 (m), 5.99 - 5.30 (m), 4.23 (s), 1.22 (s), 0.83 (s) ppm.

SEC: Mn: 37.7 kDa; Mw: 242 kDa, PDI: 6.4

### Example 7

### Synthesis of poly 3-butyl-1H-imidazol-3-ium acetate.

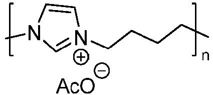

wherein n is 5 to 2000, 10 to 1000 or 20 to 500.

### Example 7-1:

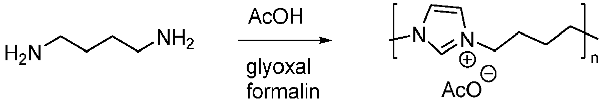

A solution of glyoxal (CAS: 107-22-2, 40% in water, 4.9 g, 34 mmol), formaldehyde (CAS: 50-00-0; 36.5-38% in water, 2.76 g, 34 mmol), acetic acid (CAS: 64-19-7, 4.1 g, 68 mmol) and water (35 mL) was prepared and purged with Ar for 30 min. 1,4-Diaminobutane (CAS: 110-60-1, 2.85 g, 32.3 mmol) was slowly added and the reaction mixture is subsequently heated at 100 °C for 18 h. After cooling to room temperature, the mixture was freeze-dried and the crude polymer was purified using crossflow filtration (PES, 10 kDa MWCO) resulting a dark oil (5.2 g, 98% after additional freeze-drying).

¹H NMR (500 MHz, DMSO-d₆) δ: 10.25 (s), 7.93 (d, *J =* 17.4 Hz), 4.37 - 4.16 (m), 1.81 (h, *J* = 7.8, 5.9 Hz), 1.65 (s) ppm.

SEC: Mn: 2.7 kDa; Mw: 8.4 kDa, PDI: 3.1

### Example 7-2:

Following the same procedure as example 7-1 using 2.55 g 1,4-diamino-butane (CAS: 110-60-1, 28.9 mmol). 4.8 g (79 %) of a dark oil was obtained.

SEC: Mn: 22.1 kDa; Mw: 34.9 kDa, PDI: 1.6

### Example 8

### Synthesis of poly 3-(2,2'-(ethane-1,2-diylbis(oxy))bis(ethane)-1H-imidazol-3-ium acetate

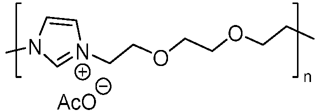

wherein n is 5 to 2000, 10 to 1000 or 20 to 500.

### Example 8-1:

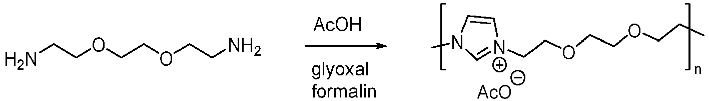

Following the same procedure as example 7-1 using 2,2'(ethylenedioxy)-bis(ethylamine) (CAS: 929-59-9, 4.3 g, 28.9 mmol). 5.2 g (85 %) of a dark oil was obtained.

¹H NMR (500 MHz, DMSO-d₆) δ: 10.01 (s), 7.87 (d, *J =* 1.6 Hz), 4.42 (t, J = 5.0 Hz), 3.76 (t, J = 5.1 Hz), 3.52 (d, J = 4.1 Hz), 1.61 (s) ppm.

SEC: Mn: 7.9 kDa; Mw: 30.0 kDa, PDI: 3.8

### Example 9

### Synthesis of poly(vinyl 3-butyl-1H-imidazol-3-ium) bromide

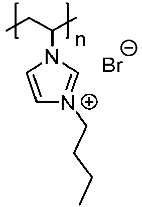

wherein n is 5 to 2000, 10 to 1000 or 20 to 500.

Monomer was synthesized as shown below:

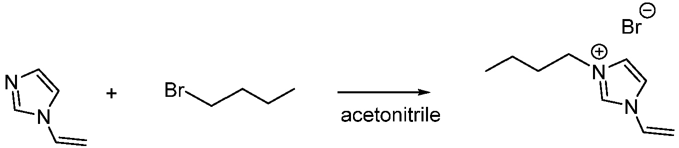

1-Bromobutane (CAS: 109-65-9, 59 g, 421 mmol) was dissolved in acetonitrile (100 mL). 1-vinylimidazole (CAS: 1072-63-5, 20 g, 210 mmol) was added dropwise at room temperature. The reaction mixture was then stirred at 60 °C for 12 h, cooled to room temperature and added to ethyl acetate (1 L) whereby an oily residue was formed. The residue was washed 3 times with ethyl acetate and vacuum-dried (40.8 g, 84% yield).

¹H NMR (500 MHz, DMSO-d₆) δ: 9.81 (d, *J =* 1.7 Hz, 1H), 8.31 (t, *J =* 1.8 Hz, 1H), 8.03 (t, *J* = 1.8 Hz, 1H), 7.36 (dd, *J* = 15.7, 8.7 Hz, 1H), 6.03 (dd, *J* = 15.6, 2.4 Hz, 1H), 5.41 (dd, *J =* 8.8, 2.4 Hz, 1H), 4.25 (t, *J =* 7.2 Hz, 2H), 1.86 - 1.76 (m, 2H), 1.32 - 1.21 (m, 2H), 0.89 (t, *J* = 7.4 Hz, 3H) ppm.

The polymer was synthesized using the process as shown below.

### Example 9-1:

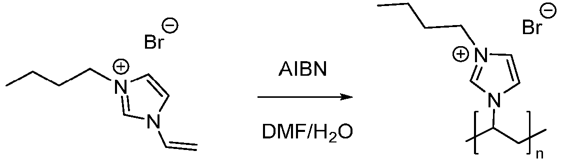

3-Butyl-1-vinyl-1*H*-imidazol-3-ium bromide (10 g, 44 mmol) and AIBN (CAS: 78-67-1, 42.6 mg, 0.26 mmol) were dissolved in 60 mL DMF/H₂O (1 : 1, v/v). The solution was purged with Ar for 30 min, heated at 65 °C for 24 h. Acetonitrile was removed, dichloromethane (10 mL) was added and the polymer was precipitated by adding THF. The precipitate was dried under vacuum, dissolved in water, and purified by crossflow filtration (PES, 10 kDa MWCO). The product was obtained as white solid after freeze-drying (8.1 g, 80 % yield).

SEC: Mn: 25.0 kDa, Mw: 52.5 kDa, PDI: 2.1

### Example 10

### Synthesis of poly(vinylbenzyl-1-ethyl-1H-imidazol-3-ium) chloride

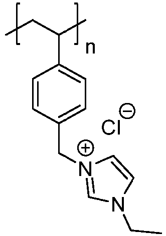

wherein n is 5 to 2000, 10 to 1000 or 20 to 500.

Monomer was synthesized as shown below:

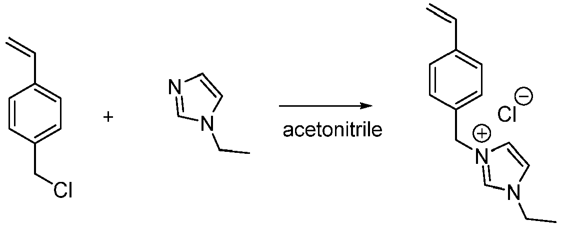

1-Ethylimidazole (abcr, CAS: 7098-07-9, 14.5 g, 147 mmol), 4-vinylbenzyl chloride (CAS: 1592-20-7, 25 g, 164 mmol) and 2,6-di-*tert*-butyl-4-methylphenol (CAS: 128-37-0, 2.4 g, 10.7 mmol) were dissolved in acetonitrile (150 mL). The resulting solution was heated at 60 °C for 48 h and then subsequently concentrated *in vacuo.* The viscous solution was added to methyl *tert*-butyl ether (MTBE, 200 mL). The white solid was separated, rinsed with MTBE and vacuum-dried resulting a white solid (34.5 g, 85% yield).

¹H NMR (500 MHz, Methanol-*d*₄): δ = 9.38 (d, *J =* 1.8 Hz, 1H), 7.77 (t, *J =* 1.8 Hz, 2H), 7.73 (t, *J =* 1.9 Hz, 1H), 7.51 (s, 4H), 6.75 (dd, *J =* 17.7, 10.9 Hz, 1H), 5.83 (dd, *J =* 17.6, 0.9 Hz, 1H), 5.52 (s, 2H), 5.29 (dd, *J =* 11.0, 0.9 Hz, 1H), 4.33 (q, *J =* 7.4 Hz, 2H), 1.55 (t, *J =* 7.4 Hz, 3H) ppm.

The polymer was synthesized using the processes as shown below.

### Example 10-1:

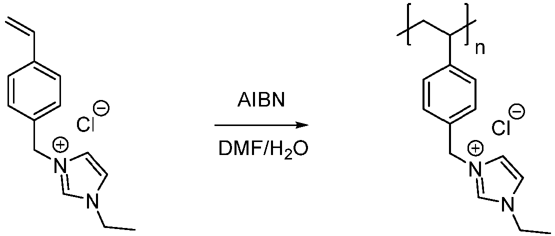

1-Ethyl-3-(4-vinylbenzyl)-1*H*-imidazol-3-ium chloride (7 g, 28 mmol) and AIBN (CAS: 78-67-1, 46 mg, 0.28 mmol) were dissolved in 40 mL acetonitrile/H₂O (1 : 1, v/v). The solution was purged with Ar for 30 min, heated at 65 °C for 24 h and then subsequently concentrated *in vacuo.* The crude product was dissolved in dichloromethane (10 mL) and precipitated by adding THF (100 mL) resulting a white solid after vacuum-drying (5.9 g, 79.5% yield).

¹H NMR (500 MHz, Methanol-*d*₄) δ = 9.47 (broad s), 7.87 - 7.50 (m), 7.49 - 7.04 (m), 6.43 (broad s), 5.52 (broad s), 4.31 (broad d, *J =* 13.4 Hz), 1.71 - 1.18 (m) ppm.

SEC: Mn: 26.4 kDa; Mw: 87.5 kDa; PDI: 3.3.

### Example 10-2:

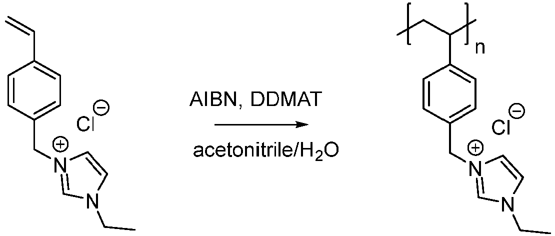

A Schlenk flask was charged with 1-ethyl-3-(4-vinylbenzyl)-1*H*-imidazol-3-ium chloride (7 g, 28 mmol), AIBN (CAS: 78-67-1, 46 mg, 0.28 mmol) and 2-(dodecylthiocarbonothioylthio)-2-methylpropionic acid (DDMAT, CAS: 461642-78-4, 0.05 g, 0.14 mmol). The mixture was dissolved in 40 mL acetonitrile/water (1 : 1, v/v), purged with Ar for 30 min and then heated at 65 °C for 16 h. The solution was freeze-dried, and the resulting solid was washed several times with acetonitrile and again freeze-dried (5.9 g, 79.5% yield).

¹H NMR (500 MHz, Methanol-*d*₄) δ = 9.47 (broad s), 7.80 - 7.50 (m), 7.46 - 7.02 (m), 6.72 - 6.28 (m), 5.63 - 5.34 (m), 4.31 (broad d, *J* = 11.1 Hz), 1.80 - 1.08 (m) ppm.

SEC: Mn: 14.1 kDa; Mw: 25.6 kDa; PDI: 1.81.

### Example 11

### Synthesis of poly(vinyl 3-ethyl-1H-imidazol-3-ium-co-vinyl 3,3'-butane-1H-imidazol-3-ium) bromide

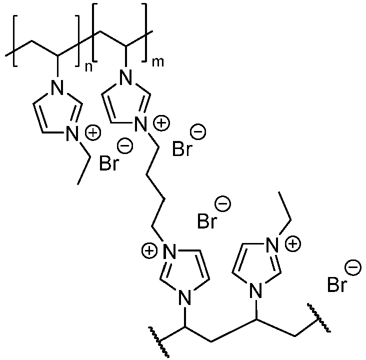

wherein n, m each independently is 5 to 2000, 10 to 1000 or 20 to 500.

Bifunctional monomer was synthesized as shown below:

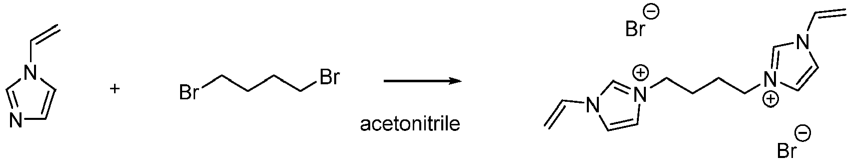

1,4-Dibromobutane (CAS: 110-52-1, 11.4 g, 52.6 mmol) was dissolved in acetonitrile (50 mL). 1-Vinylimidazole (CAS: 1072-63-5, 10 g, 105 mmol) was added dropwise at room temperature. The reaction mixture was then stirred at 60 °C for 12 h, cooled to room temperature and added to ethyl acetate (1.2 L) whereby an oily residue was formed. The residue was washed 3 times with ethyl acetate and vacuum-dried (40 g, 93 % yield).

¹H NMR (500 MHz, DMSO-*d*₆) δ: 9.69 (d, *J =* 1.7 Hz, 2H), 8.26 (t, *J =* 1.9 Hz, 2H), 8.00 (t, *J* = 1.9 Hz, 2H), 7.34 (dd, *J* = 15.6, 8.7 Hz, 2H), 6.00 (dd, *J* = 15.6, 2.4 Hz, 2H), 5.44 (dd, *J* = 8.8, 2.4 Hz, 2H), 4.33 - 4.25 (m, 4H), 1.91 - 1.84 (m, 4H) ppm.

The polymer was synthesized using the processes shown below.

### Example 11-1:

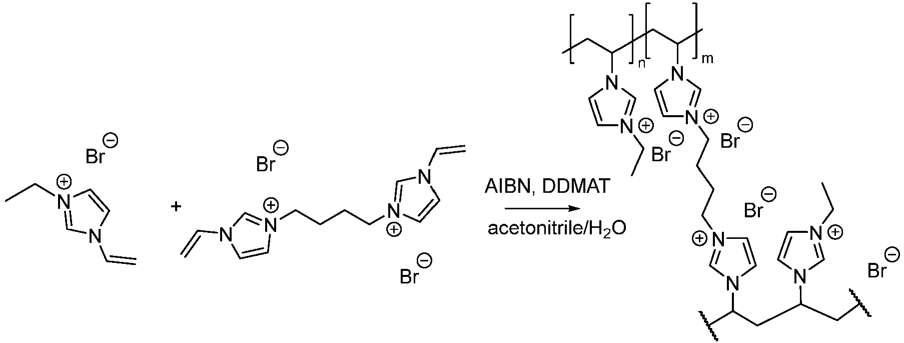

A Schlenk flask was charged with 3-ethyl-1-vinyl-1*H*-imidazol-3-ium bromide (5 g, 24.6 mmol), 3,3'-(butan-1,4-diyl)bis(1-vinyl-1*H*-imidazole-3-ium) bromide (0.1 g, 0.25 mmol), AIBN (CAS: 78-67-1, 5.5 mg, 0.033 mmol) and 2-(dodecylthiocarbonothioylthio)-2-methylpropionic acid (DDMAT, CAS: 461642-78-4, 0.036 g, 0.41 mmol). The mixture was dissolved in 30 mL acetonitrile/water (1 : 1, v/v), purged with Ar for 30 min and then heated at 65 °C for 16 h. The reaction mixture was cooled to room temperature, acetonitrile was removed and precipitated by adding 100 mL THF. The crude polymer was dissolved in water and purified by crossflow filtration (PES, 10 kDa MWCO) and freeze-dried resulting a pale yellow solid (4.6 g, 90%).

SEC: Mn: 15.7 kDa; Mw: 36.6 kDa; PDI: 2.3.

### Example 12

### Synthesis of poly(vinylbenzyl-1-ethyl-1H-imidazol-3-ium-co-vinyl-3-ethyl-1H-imidazol-3-ium) bromide chloride

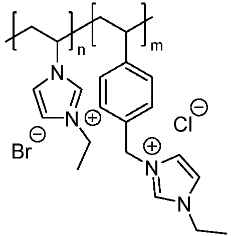

wherein n, m each independently is 5 to 2000, 10 to 1000 or 20 to 500.

Monomers obtained in Example 2 & Example 10 were used.

The polymer was synthesized from the process as shown below.

### Example 12-1:

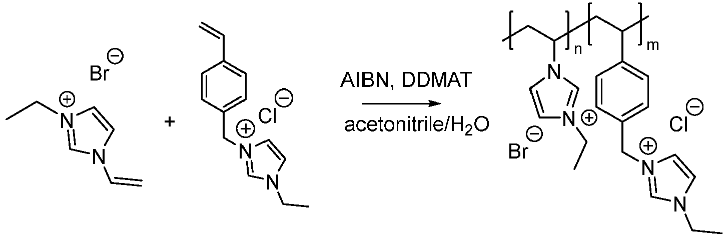

A Schlenk flask was charged with 3-ethyl-1-vinyl-1*H*-imidazole-3-ium bromide (3 g, 14.8 mmol), 1-ethyl-3-(4-vinylbenzyl)-1*H*-imidazol-3-ium chloride (3.68 g, 14.8 mmol), AIBN (CAS: 78-67-1, 3.7 mg, 0.02 mmol) and 2-(dodecylthiocarbonothioylthio)-2-methylpropionic acid (DDMAT, CAS: 461642-78-4, 24.3 mg, 0.07 mmol). The mixture was dissolved in 50 mL acetonitrile/water (1 : 1, v/v), purged with Ar for 30 min and then heated at 70 °C for 48 h. The reaction mixture was cooled to room temperature, acetonitrile was removed, and the residue was treated with dichloromethane (10 mL) and precipitated by adding 100 mL THF. The crude polymer was purified by crossflow filtration (PES, 10 kDa MWCO) to result 5.2 g (78 %) of a pale yellow solid after freeze-drying.

SEC: Mn: 19.3 kDa; Mw: 27.2 kDa; PDI: 1.4.

### Example 13

### Synthesis of poly(1-ethyl-3-propyl-1H-imidazol-3-ium acrylate) bromide

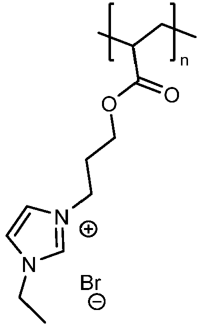

wherein n is 5 to 2000, 10 to 1000 or 10 to 500.

Monomer was synthesized as shown below:

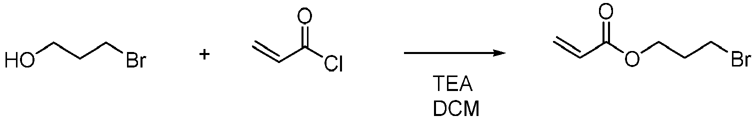

3-Bromo-1-propanol (CAS: 627-18-9, 42.2 g, 304 mmol) was dissolved in 345 mL dichloromethane, mixed with triethylamine (38 mL, 276 mmol) and treated dropwise at 0 °C with acryloyl chloride (CAS: 814-68-6, 25 g dissolved in 70 mL DCM, 276 mmol). The reaction mixture was stirred at room temperature for 4 h. After that, the organic layer was washed with water (3 x 200 mL) and brine (1 x 200 mL), dried over Na₂SO₄, filtered and finally reduced in vacuo to yield 42 g (79 %) of a liquid.
¹H NMR (500 MHz, DMSO-*d*₆) δ: 6.35 (dd, J = 17.3, 1.5 Hz, 1H), 6.18 (dd, *J =* 17.3, 10.4 Hz, 1H), 5.95 (dd, *J* = 10.4, 1.5 Hz, 1H), 4.22 (q, J = 6.1 Hz, 2H), 3.59 (t, *J* = 6.6 Hz, 2H), 2.17 (p, J = 6.4 Hz, 2H) ppm.

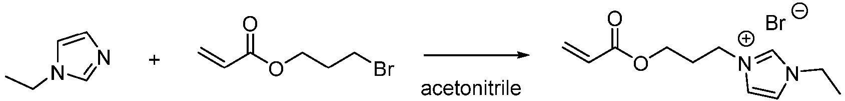

3-bromopropyl acrylate (product step 1, 9.9 g, 51.5 mmol) was dissolved in acetonitrile (30 mL), mixed with 1-ethylimidazole (CAS: 7098-07-9, 4.9 g, 51.5 mmol) and stirred at reflux overnight. The mixture was cooled to room temperature and treated with 500 mL ethyl acetate whereby the product crashed out. The oily solid was washed twice with ethyl acetate (each 100 mL), dissolved in water and freeze-dried resulting 12.2 g (82 %) of oily solid.

¹H NMR (500 MHz, DMSO-*d*₆) δ: 9.25 (s, 1H), 7.82 (d, *J =* 1.7 Hz, 2H), 6.31 (dd, *J =* 17.2, 1.5 Hz, 1H), 6.12 (dd, *J* = 17.2, 10.5 Hz, 1H), 5.97 (dd, *J =* 10.4, 1.6 Hz, 1H), 4.29 (t, *J* = 6.9 Hz, 2H), 4.22 - 4.13 (m, 4H), 2.20 (p, *J* = 6.6 Hz, 2H), 1.42 (t, *J =* 7.3 Hz, 3H) ppm.

The polymer was synthesized using the process as shown below.

### Example 13-1:

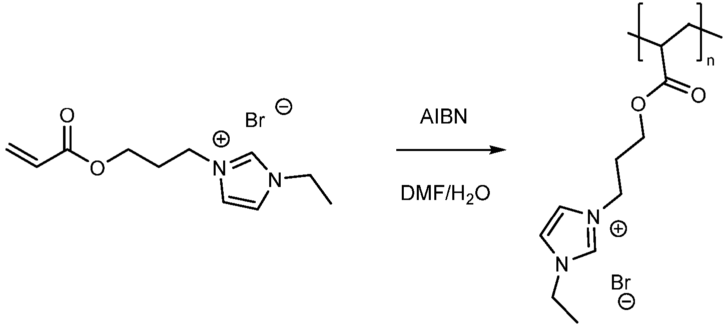

3-(3-acryloyloxy)propyl)-1-ethyl-1*H*-imidazol-3-ium bromide (3 g, 10.3 mmol) and AIBN (CAS: 78-67-1, 9.9 mg, 0.06 mmol) were dissolved in DMF (40 mL). The solution was purged with Ar for 30 min, heated for 24 h at 65 °C, cooled to room temperature and purified by cross-flow filtration (10 kDa MWCO). The retentate was freeze-dried to obtain 3 g (97 %) of a pale yellow oil.

¹H NMR (500 MHz, DMSO-*d*₆) δ: 9.67 (broad signal), 8.03 (broad signal), 7.87 (broad signal), 4.39 (broad signal), 4.04 (broad signal), 2.18 (broad signal), 1.64 (broad signal) ppm.

SEC: Mn: 4.8 kDa; Mw: 16.3 kDa, PDI: 3.4.

### Example 14 (prior art material)

### Synthesis of polyvinylimidazole

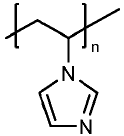

wherein n is 5 to 2000, 10 to 1000 or 20 to 500.

The polymer was synthesized using the process as shown below.

### Example 14-1:

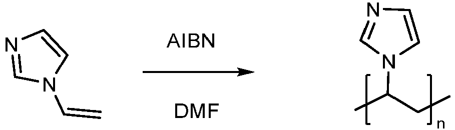

1-Vinylimidazole (CAS: 1072-63-5, 7 g, 75 mmol) was dissolved in DMF (30 mL) together with AIBN (CAS: 78-67-1, 63 mg, 0.39 mmol). The solution was purged with Ar for 30 min, heated at 65 °C for 48 h, cooled to room temperature and THF (250 mL) was added to precipitate the product. The precipitated polymer was filtered, washed twice with THF and dried under vacuum. The yield was 96%.

SEC: Mn: 13.7 kDa; Mw: 33.1 kDa; PDI: 2.4.

Example 14-2:

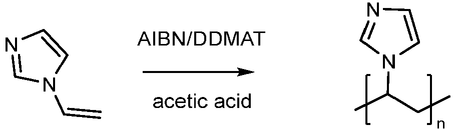

A Schlenk flask was charged with 1-vinylimidazole (CAS: 1072-63-5, 6 g, 64 mmol), AIBN (CAS: 78-67-1, 26 mg, 0.16 mmol) and 2-(dodecylthiocarbonothioylthio)-2-methylpropionic acid (DDMAT, CAS: 461642-78-4, 0.03 g, 0.08 mmol). The mixture was dissolved in 26 mL acetic acid, purged with Ar for 30 min and then heated at 70 °C for 48 h. The solution was cooled to room temperature and precipitated by adding acetone, washed with acetone and vacuum-dried (4.8 g, 80 % yield).

SEC: Mn: 7.1 kDa; Mw: 18.0 kDa; PDI: 2.5.

### Example 15

### Synthesis of poly(vinyl 3-isopropyl-1H-imidazol-3-ium) bromide

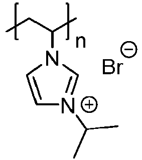

wherein n is 5 to 2000, 10 to 1000 or 20 to 500.

Monomer was synthesized as shown below:

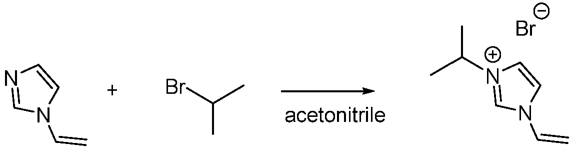

2-Bromopropane (CAS: 75-26-3, 36 g, 289 mmol) was dissolved in acetonitrile (125 mL). 1-Vinylimidazole (CAS: 1072-63-5, 25 g, 263 mmol) was added dropwise at room temperature. The reaction mixture was then stirred at 60 °C for 12 h, cooled to room temperature and added to ethyl acetate (1 L) whereby an oily residue was formed. The residue was washed 3 times with ethyl acetate and vacuum-dried (45.6 g, 80% yield).

¹H NMR (500 MHz, DMSO-*d*₆) δ: 9.67 (t, *J* = 1.7 Hz, 1H), 8.26 (t, *J* = 1.9 Hz, 1H), 8.09 (t, *J =* 1.9 Hz, 1H), 7.30 (dd, *J =* 15.7, 8.7 Hz, 1H), 5.43 (dd, *J* = 8.8, 2.4 Hz, 1H), 4.68 (hept, *J =* 6.7 Hz, 1H), 1.51 (d, *J =* 6.7 Hz, 6H) ppm.

The polymer was synthesized using the process as shown below.

### Example 15-1:

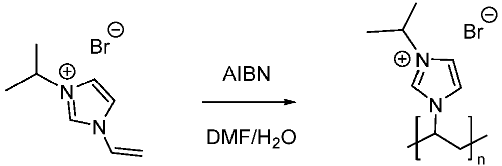

3-Isopropyl-1-vinyl-1H-imidazole-3-ium bromide (5 g, 23 mmol) and AIBN (CAS: 78-67-1, 27 mg, 0.12 mmol) were dissolved in 40 mL DMF/H₂O (1 : 1, v/v). The solution was purged with Ar for 30 min, heated at 65 °C for 24 h, cooled to room temperature and precipitated by adding ethyl acetate resulting a white solid after vacuum-drying (4.5 g, 90% yield).

¹H NMR (500 MHz, DMSO-d6) δ: 9.65 (broad signal, 1H), 7.61 (broad signal, 2H), 4.50 (broad signal, 2H), 2.74 (broad signal, 2H), 1.50 (broad signal, 6H) ppm.

SEC: Mn: 16.3 kDa; Mw: 56.6 kDa, PDI: 3.5.

### Example 16

### Synthesis of poly(vinyl 3-isopropyl-1H-imidazol-3-ium-co-N-vinylpyrrolidone) bromide.

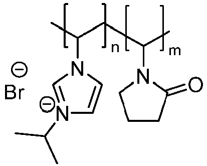

wherein n, m each independently is 5 to 2000, 10 to 1000 or 20 to 500.

### Example 16-1:

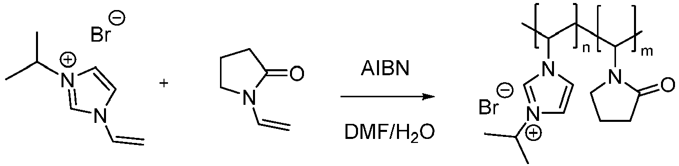

3-Isopropyl-1-vinyl-1*H*-imidazole-3-ium bromide (4.9 g, 22.5 mmol). 1-vinyl-2-pyrrolidone (CAS: 88-12-0, 0.9 g, 8 mmol) and AIBN (CAS: 78-67-1, 18.9 mg, 0.12 mmol) were dissolved in 40 mL DMF/H₂O (1 : 1, v/v). The solution was purged with Ar for 30 min, heated at 65 °C for 24 h, cooled to room temperature and precipitated by adding ethyl acetate resulting a white solid after vacuum-drying (5.0 g, 86% yield).

¹H NMR (500 MHz, DMSO-d6) δ: 9.77 - 9.45(m), 7.84 (broad signal), 4.52 (broad signal), 3.11 (broad signal), 2.91 (broad signal), 2.44 (broad signal), 1.97 (broad signal), 1.50 (broad signal) ppm.

SEC: Mn: 24.8 kDa; Mw: 138.1 kDa, PDI: 5.6.

### Example 17

### Synthesis of poly(vinyl 3-butyl-1H-imidazol-3-ium-co-N-vinylpyrrolidone) bromide.

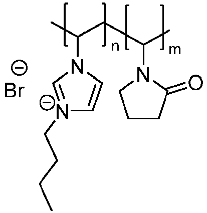

wherein n, m each independently is 5 to 2000, 10 to 1000 or 20 to 500.

### Example 17-1:

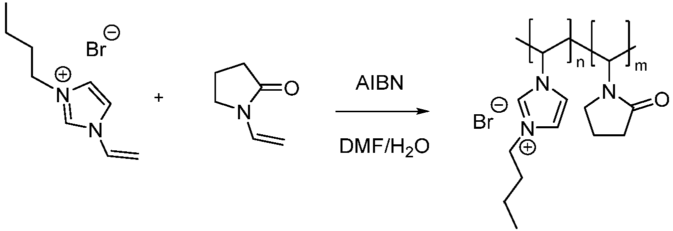

3-Butyl-1-vinyl-1*H*-imidazole-3-ium bromide (6.2 g, 27 mmol), 1-vinyl-2-pyrrolidone (CAS: 88-12-0, 1 g, 9 mmol) and AIBN (CAS: 78-67-1, 10 mg, 0.06 mmol) were dissolved in 40 mL DMF/H₂O (1 : 1, v/v). The solution was purged with Ar for 30 min, heated at 65 °C for 24 h, cooled to room temperature and precipitated by adding ethyl acetate resulting a white solid after vacuum-drying (6.6 g, 90% yield).

¹H NMR (500 MHz, DMSO-d6) δ: 9.63 (broad signal), 7.79 (broad signal), 4.47 - 4.10 (broad signal), 3.13 (broad signal), 1.82 (broad signal), 1.31 (broad signal), 0.93 (broad signal) ppm.

SEC: Mn: 44.4 kDa; Mw: 152.6 kDa, PDI: 3.4.

### Example 18

### Synthesis of poly(vinyl 3-ethyl-1H-imidazol-3-ium) acetate

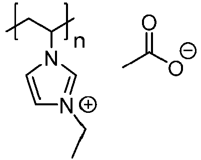

wherein n is 5 to 2000, 10 to 1000 or 20 to 500.

Monomer was synthesized as shown below:

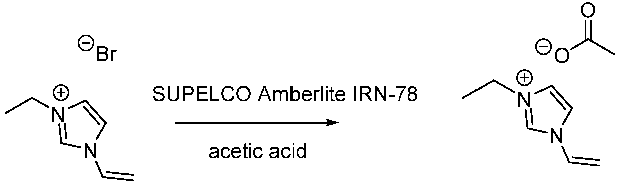

An aqueous solution of 3-ethyl-1-vinyl-1*H*-imidazole-3-ium bromide (monomer Example 2, 30 g dissolved in 100 mL water) was passed through a column filled with anion exchange resin in the hydroxide form (120 g, SUPELCO Amberlite IRN-78). Subsequently, the prepared basic solution was neutralized by dropwise addition of a slight excess of acetic acid. The mixture was stirred at ambient temperature for 12 h. Excess of water was then removed by lyophilization. The resulting products were washed with ethyl acetate in order to remove unreacted acid, re-dissolved in water, additionally purified by cross-flow filtration (10 MWCO, PES) and freeze-dried resulting the corresponding 3-ethyl-1-vinyl-1H-imidazole acetate (24.3 g, 90%).

¹H NMR (500 MHz, DMSO-d6) δ: 10.07 (t, *J =* 1.7 Hz, 1H), 8.27 (t, *J =* 1.9 Hz, 1H), 7.99 (t, *J =* 1.9 Hz), 7.39 (dd, *J* = 15.7, 8.8 Hz, 1H), 6.01 (dd, *J* = 15.7, 2.4, 1H), 5.37 (dd, *J =* 8.7, 2.4 1H), 4.26 (q, *J =* 7.3 Hz, 2H), 1.74 (s, 3H), 1.44 (t, *J =* 7.3 Hz, 3H) ppm.

The polymer was synthesized using the process as shown below.

### Example 18-1:

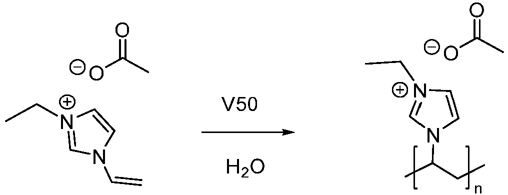

3-Ethyl-1-vinyl-1*H*-imidazole acetate (7 g, 38.4 mmol) and 2,2'-azobis(2-methylpropionamidine)dihydrochloride (V50, CAS: 2997-92-4, 19 mg, 0.07 mmol) were dissolved in 40 mL H₂O. The solution was purged with Ar for 10 min, heated at 70 °C for 24 h, cooled to room temperature and precipitated by adding THF, dissolved in water and purified by cross-flow filtration (10 MWCO, PES). The purified polymer was freeze-dried resulting 5.8 g (83 %) of a white solid.

¹H NMR (500 MHz, DMSO-*d*₆) δ: 9.33 (broad signal), 7.55 (broad signal), 4.57 (broad signal), 3.89 (broad signal), 2.51 (broad signal), 1.66 (broad signal), 1.31 (broad signal) ppm.

SEC: Mn: 36.0 kDa; Mw: 73.5 kDa, PDI: 2.04.

### Example 19

### Synthesis of poly(vinyl 3-ethyl-1H-imidazol-3-ium) malonate

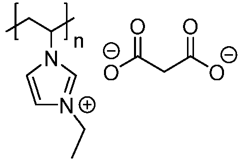

wherein n is 5 to 2000, 10 to 1000 or 20 to 500.

### Example 19-1:

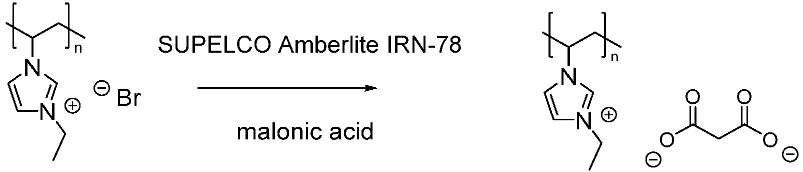

An aqueous solution of the bromide polymer (30 g dissolved in 100 mL water) was passed through a column filled with anion exchange resin in the hydroxide form (SUPELCO Amberlite IRN-78). Subsequently, the prepared basic polymer solution was neutralized by dropwise addition of a slight excess of the corresponding carboxylic acid (10% aqueous solution of malonic acid). The mixture was stirred at ambient temperature for 12 h. Excess of water was then removed by lyophilization. The resulting products were washed with ethyl acetate in order to remove unreacted acid, re-dissolved in water, additionally purified by cross-flow filtration and freeze-dried resulting the corresponding polymer with malonate counterions.

SEC: Mn: 39.8 kDa; Mw: 99.7 kDa, PDI: 2.5.

### Example 20

### Synthesis of poly(vinyl 3-ethyl-1H-imidazol-3-ium) nitrate

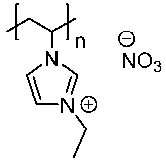

wherein n is 5 to 2000, 10 to 1000 or 20 to 500.

### Example 20-1:

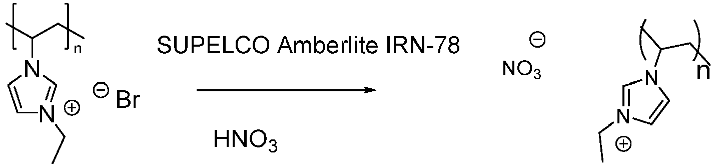

An aqueous solution of the bromide polymer (30 g dissolved in 100 mL water) was passed through a column filled with anion exchange resin in the hydroxide form (SUPELCO Amberlite IRN-78). Subsequently, the prepared basic polymer solution was neutralized by dropwise addition of a slight excess of the corresponding carboxylic acid (10% aqueous solution of nitric acid). The mixture was stirred at ambient temperature for 12 h. Excess of water was then removed by lyophilization. The resulting product was re-dissolved in water and purified by cross-flow filtration (10 MWCO, PES), freeze-dried again resulting the corresponding polymer with nitrate counterions.

SEC: Mn: 35.4 kDa; Mw: 91.8 kDa, PDI: 2.6.

### Part II CMP experiments using synthesized Imidazolium-based poly(ionic liquid)s in Part I

The polishing composition and associated methods described herein are effective for CMP of a wide variety of substrates, including most of substrates, particularly useful for polishing tungsten substrates.

In the examples presented below, CMP experiments were run using the procedures and experimental conditions given below.

### PARAMETERS:

Å: angstrom(s) - a unit of length
BP: back pressure, in psi units
CMP: chemical mechanical planarization = chemical mechanical polishing
CS: carrier speed
DF: Down force: pressure applied during CMP, unit: psi
min: minute(s)
ml: milliliter(s)
mV: millivolt(s)
psi: pounds per square inch
PS: platen rotational speed of polishing tool, in rpm (revolution(s) per minute)
SF: polishing composition flow, ml/min
TEOS: silicon oxide films by Chemical Vapor Deposition (CVD) using tetraethyl orthosilicate as the precursor
Wt.%: weight percentage (of a listed component) 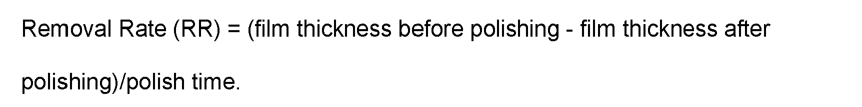 Removal Rate (RR) = (film thickness before polishing - film thickness after polishing)/polish time.
Removal Rates and Selectivity
Tungsten Removal Rates: Measured tungsten removal rate at 2.5 psi down pressure of the CMP tool.
TEOS Removal Rates: Measured TEOS removal rate at a given down pressure. The down pressure of the CMP tool was 2.5 psi.
SiN Removal Rates: Measured SiN removal rate at a given down pressure. The down pressure of the CMP tool was 2.5 psi.

The CMP tool that was used in the examples is a AMAT 200mm Mirra^{®}, manufactured by Applied Materials, Inc. 3050 Bowers Avenue, Santa Clara, California, 95054. IC1010 polishing pad, supplied by Dow Chemicals was used on the platen for the polishing studies.

200mm diameter silicon wafers coated with tungsten films, TEOS films, SiN films or tungsten containing SKW patterned structures were obtained from SKW Associate, Inc. 2920 Scott Blvd, Santa Clara, CA 95054. Polish time for blanket films was one minute. Tungsten removal rates were measured using sheet resistance measurement techniques. TEOS removal was measured using optical techniques. Patterned wafers were polished for time based on eddy current technique on the Ebara polisher. Polishing time for patterned wafer was 15 seconds past the end point identified by the eddy current end point technique. Patterned wafers were analyzed with a KLA Tencor P15 Profiler (large feature sizes) or an AFM tool (small feature sizes).

The polishing was performed using at 2.5 psi downforce, 111 RPM table speed, 113 RPM carrier speed and 200 ml/min slurry flow rate.

In the polishing process, a substrate (e.g., a wafer with W) was placed face-down on a polishing pad which was fixedly attached to a rotatable platen of a CMP polisher. In this manner, the substrate to be polished and planarized was placed in direct contact with the polishing pad. A wafer carrier system or polishing head was used to hold the substrate in place and to apply a downward pressure against the backside of the substrate during CMP processing while the platen and the substrate were rotated. The polishing composition (slurry) was applied (usually continuously) on the pad during CMP processing for effective removal of material and planarizing the substrate.

A CMP base slurry (with no additive) comprising 0.01 wt.% ferric nitrate, 0.08 wt.% malonic acid (stabilizer), 2.0 wt.% hydrogen peroxide, 0.1 wt.% glycine and 0.25 wt.% Fuso PL-2C silica particles in water with pH adjusted to 2.3 with nitric acid was prepared. Performance of the base slurry was tested.

The removal rates (Å/min) for W, TEOS and SiN; and removal rate selectivity of W:TEOS and W:SiN were shown in Table A.

**Table A**

| | WRR | TEOS RR | W:TEOS selectivity | SiN RR | W:SiN selectivity |
|---|---|---|---|---|---|
| Base slurry | 2914 | 44 | 66 | 32 | 91 |

Dishing of tungsten was tested on different arrays including, 50 X 50 micron array (tungsten line width/trench separated by dielectric line width/spacer in micron) (50/50 µm), 1 X 1 micron (1/1 µm), 0.5 X 0.5 micron (0.5/0.5 µm), 0.25 X 0.25 micron (0.25/0.25 µm), and 0.18 X 0.18 micron array (0.18/0.18 µm), when the wafer was polished for 15 seconds additional time or over polishing (OP) time after the pattern wafer polish end point was detected by using eddy current measurement. Results were shown in Table B.

**Table B W Line Dishing [Å]**

| | 50/50µm | 1/1µm | 0.5/0.5µm | 0.25/0.25µm | 0.18/0.18µm |
|---|---|---|---|---|---|
| Base slurry | 905 | 232 | 151 | 137 | 121 |

Erosion was tested on 7/3 µm, 1/1 µm, 0.5/0.5 µm, 0.25/0.25 µm, 0.18/0.18 µm arrays at 20% over-polish for various formulations. Results were shown in Table C.

**Table C Erosion [Å]**

| | 7/3µm | 1/1µm | 0.5/0.5µm | 0.25/0.25µm | 0.18/0.18µm |
|---|---|---|---|---|---|
| Base slurry | 314 | 111 | 50 | 109 | 112 |

In the following working examples, different additives with different amounts were added to the base slurry to make the working examples.

Different imidazolium-based poly(ionic liquid)s made in Example 1-1, Example 1-2, Example 1-3 and Example 1-4; Example 2-1; Example 3-2 and Example 3-3; and Example 5-1, Example 5-2, Example 5-3 and Example 5-4, Example 6-1, Example 8-1, Example 9-1, and Example 12-1 in Part I at different concentrations were added to the base slurry to obtain the working slurries.

Effects of imidazolium-based poly(ionic liquid)s on tungsten removal, erosion and dishing were tested under the same condition as tested on the base slurry.

The tungsten removal results were shown in Table 1. First, various quantities of imidazolium-based poly(ionic liquid)s were used to identify a general concentration window, which was then used for tests to identify the effects on erosion and dishing.

**Table 1 W RR**

| Example | Concentration | W RR [Å/min] |
|---|---|---|
| 1-1 | 10 ppm | 2525 |
| 1-1 | 50 ppm | 1246 |
| 1-1 | 100 ppm | 760 |
| 1-2 | 10 ppm | 4129 |
| 1-2 | 50 ppm | 1736 |
| 1-2 | 100 ppm | 151 |
| 1-3 | 10 ppm | 4257 |
| 1-3 | 50 ppm | 1479 |
| 1-3 | 100 ppm | 377 |
| 1-4 | 10 ppm | 4141 |
| 1-4 | 50 ppm | 1973 |
| 1-4 | 100 ppm | 1072 |
| 2-1 | 10 ppm | 2434 |
| 2-1 | 50 ppm | 924 |
| 2-1 | 100 ppm | 177 |
| 3-2 | 10 ppm | 4343 |
| 3-2 | 50 ppm | 1858 |
| 3-2 | 100 ppm | 1005 |
| 3-3 | 10 ppm | 4354 |
| 3-3 | 50 ppm | 1812 |
| 3-3 | 100 ppm | 1036 |
| 5-1 | 10 ppm | 3032 |
| 5-1 | 50 ppm | 1268 |
| 5-1 | 100 ppm | 792 |
| 5-2 | 10 ppm | 4384 |
| 5-2 | 50 ppm | 2045 |
| 5-2 | 100 ppm | 1113 |
| 5-3 | 10 ppm | 2951 |
| 5-3 | 50 ppm | 1539 |
| 5-3 | 100 ppm | 916 |
| 5-4 | 10 ppm | 4410 |
| 5-4 | 50 ppm | 2068 |
| 5-4 | 100 ppm | 1439 |
| 8-1 | 5 ppm | 4004 |
| 8-1 | 25 ppm | 3809 |
| 8-1 | 50 ppm | 3381 |
| 9-1 | 10 ppm | 3949 |
| 9-1 | 50 ppm | 1416 |
| 9-1 | 100 ppm | 947 |
| 12-1 | 10 ppm | 4303 |
| 12-1 | 50 ppm | 2061 |
| 12-1 | 100 ppm | 1097 |

As shown in Table 1, working CMP slurries with a small amount of synthesized imidazolium-based poly(ionic liquid)s provided high tungsten removal rates, with an increase in concentration inhibiting the effect on tungsten removal.

Table 2 summarized tungsten, TEOS and SiN removal rate for working CMP slurries comprising various amount of synthesized imidazolium-based poly(ionic liquid)s.

As shown in Table 2, working CMP slurries have high W:TEOS RR and W:SiN RR selectivities. The removal rate of TEOS or SiN is extremely low while the removal rate for tungsten is still high.

**Table 2 RR and selectivity**

| Examples | WRR [Å/min] | TEOS RR [Å/min] | W:TEOS RR selectivity | SiN RR [Å/min] | W:SiN RR selectivity |
|---|---|---|---|---|---|
| 1-1 (10 ppm) | 2593 | 35 | 74 | 22 | 118 |
| 1-2 (20 ppm) | 2546 | 36 | 71 | 25 | 102 |
| 1-3 (20 ppm) | 2418 | 31 | 78 | 23 | 105 |
| 2-1 (10 ppm) | 2282 | 36 | 63 | 24 | 95 |
| 2-1 (20 ppm) | 1748 | 24 | 73 | 25 | 70 |
| 2-1 (30 ppm) | 1073 | 17 | 63 | 22 | 63 |
| 5-1 (12.5 ppm) | 2263 | 35 | 65 | 26 | 87 |
| 5-2 (25 ppm) | 2182 | 24 | 91 | 17 | 128 |
| 5-2 (35 ppm) | 1864 | 22 | 86 | 16 | 118 |
| 5-3 (15 ppm) | 2668 | 28 | 95 | 16 | 107 |
| 5-3 (30 ppm) | 1778 | 17 | 105 | 22 | 81 |
| 5-4 (25 ppm) | 2521 | 22 | 115 | 19 | 133 |
| 5-5 (15 ppm) | 2854 | 23 | 124 | 23 | 124 |
| 5-5 (30 ppm) | 2737 | 16 | 152 | 21 | 130 |
| 6-1 (15 ppm) | 3190 | 30 | 106 | 20 | 160 |
| 6-1 (30 ppm) | 3131 | 21 | 149 | 18 | 174 |
| 9-1 (10 ppm) | 2779 | 18 | 154 | 17 | 163 |
| 9-1 (20 ppm) | 2626 | 17 | 154 | 15 | 175 |
| 11-1 (15 ppm) | 2537 | 33 | 77 | 27 | 94 |
| 12-1 (10 ppm) | 2941 | 28 | 68 | 18 | 116 |
| 12-1 (20 ppm) | 2693 | 23 | 72 | 16 | 121 |

Dishing of tungsten was tested under the same condition as tested on the base slurry: on different arrays including, 50 X 50 micron array (tungsten line width/trench separated by dielectric line width/spacer in micron) (50/50 µm), 1 X 1 micron (1/1 µm), 0.5 X 0.5 micron (0.5/0.5 µm), 0.25 X 0.25 micron (0.25/0.25 µm), and 0.18 X 0.18 micron array (0.18/0.18 µm), when the wafer was polished for 15 seconds additional time or over polishing (OP) time after the pattern wafer polish end point was detected by using eddy current measurement.

The W line dishing data was shown in Table 3.

**Table 3 W Line Dishing [Å]**

| Examples | 50/50µm | 1/1µm | 0.5/0.5µm | 0.25/0.25µm | 0.18/0.18µm |
|---|---|---|---|---|---|
| 1-1 (10 ppm) | 1208 | 226 | 152 | 135 | 114 |
| 1-2 (20 ppm) | 1299 | 170 | 92 | 81 | 79 |
| 1-3 (20 ppm) | 1308 | 170 | 75 | 72 | 76 |
| 2-1 (10 ppm) | 994 | 202 | 104 | 94 | 79 |
| 2-1 (20 ppm) | 537 | 151 | 64 | 75 | 72 |
| 2-1 (30 ppm) | 387 | 94 | 66 | 81 | 62 |
| 5-1 (12.5 ppm) | 934 | 193 | 98 | 81 | 75 |
| 5-2 (25 ppm) | 575 | 144 | 75 | 68 | 67 |
| 5-2 (35 ppm) | 382 | -91 | -92 | -82 | -88 |
| 5-3 (15 ppm) | 666 | 195 | -237 | -97 | -79 |
| 5-4 (25 ppm) | 693 | 159 | -76 | -77 | -66 |
| 5-5 (15 ppm) | 848 | 212 | 116 | 92 | 64 |
| 5-5 (25 ppm) | 998 | 173 | 72 | 64 | 63 |
| 6-1 (15 ppm) | 780 | 219 | -126 | 136 | 102 |
| 6-1 (30 ppm) | 708 | 181 | 105 | 113 | 87 |
| 11-1 (15 ppm) | 842 | 189 | 82 | 114 | 63 |

Dishing of lines typically increases for wider lines. Negative values on W line dishing basically mean that no W line dishing was seen (protrusion of W line).

In a typical tungsten CMP process, it is desirable that the tungsten dishing for wider line features lines is less than 1500 Angstroms[Å].

Erosion was tested under the same condition as tested on the base slurry; on 7/3 µm, 1/1 µm, 0.5/0.5 µm, 0.25/0.25 µm, 0.18/0.18 µm arrays at 20% over-polish for various formulations.

Results were summarized in Table 4.

**Table 4 Erosion [Å]**

| Examples | 7/3µm | 1/1µm | 0.5/0.5µm | 0.25/0.25µm | 0.18/0.18µm |
|---|---|---|---|---|---|
| 1-1 (10 ppm) | 466 | 340 | 198 | 368 | 308 |
| 1-2 (20 ppm) | 671 | 542 | 448 | 612 | 567 |
| 1-3 (20 ppm) | 767 | 429 | 325 | 505 | 404 |
| 2-1 (10 ppm) | 432 | 274 | 163 | 209 | 221 |
| 2-1 (20 ppm) | 451 | 306 | 56 | 161 | 54 |
| 2-1 (30 ppm) | 474 | 387 | 63 | 57 | 52 |
| 5-1 (12.5 ppm) | 460 | 338 | 154 | 322 | 199 |
| 5-2 (25 ppm) | 432 | 324 | 242 | 176 | 32 |
| 5-2 (35 ppm) | 502 | 241 | 23 | -10 | 15 |
| 5-3 (15 ppm) | 297 | 108 | -210 | -85 | -57 |
| 5-4 (25 ppm) | 431 | 381 | 256 | 146 | 45 |
| 5-5 (15 ppm) | 347 | 259 | 86 | 189 | 182 |
| 5-5 (25 ppm) | 496 | 365 | 272 | 404 | 357 |
| 6-1 (15 ppm) | 176 | 9 | -114 | 30 | -9 |
| 6-1 (30 ppm) | 228 | 31 | -65 | -28 | -56 |
| 11-1 (15 ppm) | 501 | 237 | 56 | 192 | 100 |

Erosion of arrays typically increases with an increase in pattern density. Negative values on erosion describe protrusions. Basically, no erosion was seen.

In a typical tungsten CMP process, it is desirable to have erosion on high density features such as 70% and 90% density <1000 A.

As is apparent from the results depicted in Table 3 and Table 4 respectively, the use of imidazolium-based poly(ionic liquid)s significantly reduces both erosion and dishing while providing maintain desirable removal rate in polishing tungsten.

## Claims

1. A chemical mechanical planarization composition comprising an abrasive and an imidazolium-based poly(ionic liquid) comprising at least one monomer having at least one imidazolium group with structure (I): 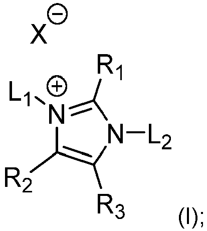 wherein
(a) the at least one imidazolium group with structure (I) is in a side chain or side chains of the imidazolium-based poly(ionic liquid);
wherein
one of L₁ and L₂ is a covalent bond or a spacer connecting imidazolium-ring to main chain of the imidazolium-based poly(ionic liquid), and comprises a substituted or unsubstituted aliphatic; cyclic or branched aliphatic, aromatic, heteroaromatic or siloxane moiety; wherein the main chain is formed after polymerization of a polymerizable group selected from the group consisting of vinyl, allyl, styrenic, acrylic, methacrylic, acrylamide, methacrylamide, siloxane, maleimide, norbornene, and combinations thereof;
another one of L₁ and L₂ is an alkyl group selected from the group consisting of linear, branched, and cyclic alkyl group; wherein CH₂ thereof can be replaced by O, S or N in a way that no heteroatoms are connected to each other; hydrogen can be replaced by F, Cl or CN;
each of R₁, R₂, R₃ can be independently H or an alkyl group selected from the group consisting of linear, branched, and cyclic alkyl group; where CH₂ thereof can be replaced by O, S or N in a way that no heteroatoms are connected to each other; and hydrogen can be replaced by F, Cl or CN; R₂ and R₃ can also be connected to a cyclic unit; preferably, R₁= R₂ = H;
and
anion X⁻ is selected from the group consisting of halide (F-, Cl-, Br-, I-), BF₄-, PF₆-, [C₂F₅BF₃]-, carboxylate RCOO- with R = H, alkyl or aryl; malonate, citrate, fumarate, MeOSO₃-, MeSO₃-, CF₃COO-, CF₃SO₃-, nitrate, and sulfate; wherein Me is methyl;
(b) the at least one imidazolium group with structure (I) is in main chain of the imidazolium-based poly(ionic liquid);
wherein
L₁ and L₂ each independently comprises a substituted or unsubstituted aliphatic, cyclic or branched aliphatic, aromatic, heteroaromatic, and siloxane moiety; wherein CH₂ thereof can be replaced by O, S or N in a way that no heteroatoms are connected to each other; hydrogen can be replaced by F, Cl or CN;
L₁, L₂ or both L₁ and L₂ can connect the at least one imidazolium group via suitable functional group to the main chain to form the imidazolium-based poly(ionic liquid); wherein the suitable functional group is selected from group consisting of esters, amides, urethanes, ethers, thioethers, imides, and combinations thereof;
each of R₁, R₂, R₃ can be independently H or an alkyl group selected from the group consisting of linear, branched, and cyclic alkyl group; where CH₂ can be replaced by O, S or N in a way that no heteroatoms are connected to each other; and hydrogen can be replaced by F, Cl or CN; R₂ and R₃ can also be connected to a cyclic unit; preferably, R₁= R₂ = H;
and
anion X⁻ is selected from the group consisting of halide (F-, Cl-, Br-, I-), BF₄-, PF₆-, [C₂F₅BF₃]-, carboxylate RCOO- with R = H, alkyl or aryl; malonate, citrate, fumarate, MeOSO₃-, MeSO₃-, CF₃COO-, CF₃SO₃-, nitrate, and sulfate, wherein Me is methyl;
and
(c) the at least one imidazolium group with structure (I) are in both the side chain or the side chains of the imidazolium-based poly(ionic liquid) as defined in above (a) and in the main chain of the imidazolium-based poly(ionic liquid) as defined in above (b).

2. The chemical mechanical planarization composition of Claim 1, wherein the imidazolium-based poly(ionic liquid) comprises a cross-linkable monomer with polymerizable groups for L₁ and L₂ of (a).

3. The chemical mechanical planarization composition of Claim 1, wherein the imidazolium-based poly(ionic liquid) is a copolymer comprising at least two different monomers selected from (a), (b), and (e) a non-ionic monomer which can form copolymers with the monomer in (a) or the monomer in (b) and is selected from the group consisting of acrylate or methacrylate, acrylamide or methacrylamide, maleimide, vinyl benzene, vinyl-type monomer, ethylene glycol, siloxane, norbornene, and combinations thereof.

4. The chemical mechanical planarization composition of Claim 1, wherein the imidazolium-based poly(ionic liquid) is a block-copolymer.

5. The chemical mechanical planarization composition of Claim 1, wherein the imidazolium-based poly(ionic liquid) comprises at least one of a functional anion as a reducing agent or complexation agent.

6. The chemical mechanical planarization composition of Claim 1, wherein polymerization of the imidazolium-based poly(ionic liquid) is selected from the group consisting of free radical polymerization, reversible addition-fragmentation chain-transfer polymerization (RAFT), nitroxide-mediated polymerization (NMP), atomic transfer reaction polymerization (ATRP), ring opening polymerization (ROMP), polycondensation reaction, and combinations thereof.

7. The chemical mechanical planarization composition of Claim 1, wherein the imidazolium-based poly(ionic liquid) is selected from the group consisting of poly(vinyl benzyl 1-butyl-1*H*-imidazol-3-ium) chloride, poly(vinyl 3-ethyl-1*H*-imidazol-3-ium) bromide, poly(vinyl benzyl 1-butyl-1*H*-imidazol-3-ium-co-acrylamide) chloride, poly(vinyl benzyl 1-butyl-1*H*-imidazol-3-ium-co-acrylomorpholine) chloride, poly(vinyl 3-ethyl-1*H*-imidazol-3-ium-co-*N*-vinylpyrrolidone) bromide, poly(vinyl benzyl 1-butyl-1*H*-imidazol-3-ium-co-*N*-methyl maleimide) chloride, poly 3-butyl-1*H*-imidazol-3-ium acetate, and poly 3-(2,2'-(ethane-1,2-diylbis(oxy))bis(ethane)-1*H*-imidazol-3-ium acetate, poly(vinyl 3-butyl-1*H*-imidazol-3-ium) bromide, poly(vinylbenzyl-1-ethyl-1*H-*imidazol-3-ium) chloride, poly(vinyl 3-ethyl-1*H*-imidazol-3-ium-co-vinyl 3,3'-butane-1*H*-imidazol-3-ium) bromide, poly(vinylbenzyl-1-ethyl-1*H*-imidazol-3-ium-co-vinyl-3-ethyl-1*H*-imidazol-3-ium) bromide chloride, poly(1-ethyl-3-propyl-1*H*-imidazol-3-ium acrylate) bromide, poly(vinyl 3-isopropyl-1*H*-imidazol-3-ium) bromide, poly(vinyl 3-isopropyl-1*H*-imidazol-3-ium-co-*N*-vinylpyrrolidone) bromide, poly(vinyl 3-butyl-1*H-*imidazol-3-ium-co-*N*-vinylpyrrolidone) bromide, poly(vinyl 3-ethyl-1*H*-imidazol-3-ium) acetate, poly(vinyl 3-ethyl-1*H*-imidazol-3-ium) malonate, poly(vinyl 3-ethyl-1*H-*imidazol-3-ium) nitrate, and combinations thereof.

8. The chemical mechanical planarization composition of claim 1, wherein the concentration of the imidazolium-based cationic polymer preferably ranges from 0.00001 wt.% to 1 wt.%, 0.0001 wt.% to 0.5 wt., or 0.0005 wt.% to 0.1 wt.%; and the composition further comprises
water; and
an abrasive, which is preferably selected from the group consisting of inorganic oxide particles, metal oxide-coated inorganic oxide particles, organic polymer particles, metal oxide-coated organic polymer particles, and combinations thereof, wherein the abrasive preferably ranges from 0.01 wt.% to 30 wt.%, 0.05 wt.% to 20 wt.%, 0.01 wt.% to 10 wt.%, or from 0.1 wt.% to 2 wt.%;
and optionally
an activator, which is preferably selected from the group consisting of
(1) inorganic oxide particle with transition metal coated onto its surface; and the transition metal is selected from the group consisting of Fe, Cu, Mn, Co, Ce, and combinations thereof;
(2) soluble catalyst selected from the group consisting of ammonium iron (III) oxalate trihydrate, iron (III) citrate tribasic monohydrate, iron (III) acetylacetonate and ethylenediamine tetraacetic acid, iron (III) sodium salt hydrate;
(3) a metal compound having multiple oxidation states selected from the group consisting of Ag, Co, Cr, Cu, Fe, Mo, Mn, Nb, Ni, Os, Pd, Ru, Sn, Ti, V; and combinations thereof,
wherein the activator preferably ranges from 0.00001 wt.% to 5.0 wt.%, 0.0001 wt.% to 2.0 wt.%, 0.0005 wt.% to 1.0 wt.%, or 0.001 wt.% to 0.5 wt. %;
an oxidizing agent, which is preferably selected from the group consisting of peroxy compound selected from the group consisting of hydrogen peroxide, urea peroxide, peroxyformic acid, peracetic acid, propaneperoxoic acid, substituted or unsubstituted butaneperoxoic acid, hydroperoxy-acetaldehyde, potassium periodate, ammonium peroxymonosulfate; and non-peroxy compound selected from the group consisting of ferric nitrite, KClO₄, KBrO₄, KMnO₄; and combinations thereof, wherein the oxidizing agent preferably ranges from 0.01 wt.% to 30 wt.%, 0.1 wt.% to 20 wt.%, or 0.5 wt.% to 10 wt.%;
a corrosion inhibitor, which is preferably selected from the group consisting of 1,2,3-triazole, 1,2,4-triazole, 1,2,3-benzotriazole, 5-methylbenzotriazole, benzotriazole, 1-hydroxybenzotriazole, 4-hydroxybenzotriazole, 3-amino-1,2,4-triazole, 4-amino-4H-1,2,4-triazole, 5-amino-triazole, benzimidazole, 2,1,3-benzothiadiazole, triazinethiol, triazinedithiol, and triazinetrithiol, pyrazoles, imidazoles, isocyanurate such as 1,3,5-tris(2-hydroxyethyl), and combinations thereof, wherein the corrosion inhibitor preferably ranges from less than 1.0 wt.%, less than 0.5 wt.%, or less than 0.25 wt.%;
a dishing reducing agent, which is preferably selected from the group consisting of sarcosinate and related carboxylic compounds; hydrocarbon substituted sarcosinate; amino acids; organic polymers and copolymers having molecules containing ethylene oxide repeating units, such as polyethylene oxide (PEO); ethoxylated surfactants; nitrogen containing heterocycles without nitrogen-hydrogen bonds; sulfide; oxazolidine or mixture of functional groups in one compound; nitrogen containing compounds having three or more carbon atoms that form alkylammonium ions; amino alkyls having three or more carbon atoms; polymeric corrosion inhibitor comprising a repeating group of at least one nitrogen-containing heterocyclic ring or a tertiary or quaternary nitrogen atom; polycationic amine compound; cyclodextrin compound; polyethyleneimine compound; glycolic acid; chitosan; sugar alcohols; polysaccharides; alginate compound; phosphonium compound; and sulfonic acid polymer; and combinations thereof, wherein the dishing reducing agent preferably ranges from 0.001 wt.% to 2.0 wt. %, 0.005 wt.% to 1.5 wt. %, or 0.01 wt.% to 1.0 wt. %;
a stabilizer, which is preferably selected from the group consisting of adipic acid, phthalic acid, citric acid, malonic acid, orthophthalic acid; phosphoric acid; substituted or unsubstituted phosphonic acids; nitriles; and combinations thereof, wherein the stabilizer preferably ranges from 0.0001 to 5 wt.%, 0.0005 to 2 wt.%, or 0.001 to 1 wt.%;
a pH adjusting agent, which is preferably selected from the group consisting of
(a) nitric acid, sulfuric acid, tartaric acid, succinic acid, citric acid, malic acid, malonic acid, various fatty acids, various polycarboxylic acids, and mixtures thereof to lower the pH; and
(b) potassium hydroxide, sodium hydroxide, ammonia, tetraethylammonium hydroxide, ethylenediamine, piperazine, polyethyleneimine, modified polyethyleneimine, and mixtures thereof to raise the pH; and
pH of the composition is preferably between 1 and 14, 1 and 7, 1 and 6, or 1 and 4.

9. The chemical mechanical planarization composition of Claim 1, wherein the chemical mechanical planarization composition comprises
silica particles; and the imidazolium-based poly(ionic liquid) selected from the group consisting of poly(vinyl benzyl 1-butyl-1*H*-imidazol-3-ium) chloride, poly(vinyl 3-ethyl-1*H*-imidazol-3-ium) bromide, poly(vinyl benzyl 1-butyl-1*H*-imidazol-3-ium-co-acrylamide) chloride, poly(vinyl benzyl 1-butyl-1*H*-imidazol-3-ium-co-acrylomorpholine) chloride, poly(vinyl 3-ethyl-1*H*-imidazol-3-ium-co-*N-*vinylpyrrolidone) bromide, poly(vinyl benzyl 1-butyl-1*H*-imidazol-3-ium-co-*N*-methyl maleimide) chloride, poly 3-butyl-1*H*-imidazol-3-ium acetate, and poly 3-(2,2'-(ethane-1,2-diylbis(oxy))bis(ethane)-1*H*-imidazol-3-ium acetate, poly(vinyl 3-butyl-1*H-*imidazol-3-ium) bromide, poly(vinylbenzyl-1-ethyl-1*H*-imidazol-3-ium) chloride, poly(vinyl 3-ethyl-1*H*-imidazol-3-ium-co-vinyl 3,3'-butane-1*H*-imidazol-3-ium) bromide, poly(vinylbenzyl-1-ethyl-1*H*-imidazol-3-ium-co-vinyl-3-ethyl-1*H*-imidazol-3-ium) bromide chloride, poly(1-ethyl-3-propyl-1*H*-imidazol-3-ium acrylate) bromide, poly(vinyl 3-isopropyl-1*H*-imidazol-3-ium) bromide, poly(vinyl 3-isopropyl-1*H-*imidazol-3-ium-co-*N*-vinylpyrrolidone) bromide, poly(vinyl 3-butyl-1*H*-imidazol-3-ium-co-*N*-vinylpyrrolidone) bromide, poly(vinyl 3-ethyl-1*H*-imidazol-3-ium) acetate, poly(vinyl 3-ethyl-1*H*-imidazol-3-ium) malonate, poly(vinyl 3-ethyl-1*H*-imidazol-3-ium) nitrate, and combinations thereof; or
the chemical mechanical planarization composition comprises silica particles; ferric nitrate, malonic acid, hydrogen peroxide, the imidazolium-based poly(ionic liquid) selected from the group consisting of poly(vinyl benzyl 1-butyl-1*H*-imidazol-3-ium) chloride, poly(vinyl 3-ethyl-1*H-*imidazol-3-ium) bromide, poly(vinyl benzyl 1-butyl-1*H-*imidazol-3-ium-co-acrylamide) chloride, poly(vinyl benzyl 1-butyl-1*H*-imidazol-3-ium-co-acrylomorpholine) chloride, poly(vinyl 3-ethyl-1*H*-imidazol-3-ium-co-*N-*vinylpyrrolidone) bromide, poly(vinyl benzyl 1-butyl-1*H*-imidazol-3-ium-co-*N*-methyl maleimide) chloride, poly 3-butyl-1*H*-imidazol-3-ium acetate, and poly 3-(2,2'-(ethane-1,2-diylbis(oxy))bis(ethane)-1*H*-imidazol-3-ium acetate, poly(vinyl 3-butyl-1*H-*imidazol-3-ium) bromide, poly(vinylbenzyl-1-ethyl-1*H*-imidazol-3-ium) chloride, poly(vinyl 3-ethyl-1*H*-imidazol-3-ium-co-vinyl 3,3'-butane-1*H*-imidazol-3-ium) bromide, poly(vinylbenzyl-1-ethyl-1*H*-imidazol-3-ium-co-vinyl-3-ethyl-1*H*-imidazol-3-ium) bromide chloride, poly(1-ethyl-3-propyl-1*H*-imidazol-3-ium acrylate) bromide, poly(vinyl 3-isopropyl-1*H*-imidazol-3-ium) bromide, poly(vinyl 3-isopropyl-1*H-*imidazol-3-ium-co-*N*-vinylpyrrolidone) bromide, poly(vinyl 3-butyl-1*H*-imidazol-3-ium-co-*N*-vinylpyrrolidone) bromide, poly(vinyl 3-ethyl-1*H*-imidazol-3-ium) acetate, poly(vinyl 3-ethyl-1*H*-imidazol-3-ium) malonate, poly(vinyl 3-ethyl-1*H*-imidazol-3-ium) nitrate, and combinations thereof.

10. A polishing method for chemical mechanical planarization of a semiconductor substrate comprising at least one surface containing tungsten,
the polishing method comprising the following steps:
a) providing a polishing pad;
b) providing a chemical mechanical planarization composition comprising:
an additive comprising the imidazolium-based poly(ionic liquid) according to any one of claims 1 to 7, wherein the additive comprising an imidazolium-based cationic polymer preferably ranges from 0.00001 wt.% to 1 wt.%, 0.0001 wt.% to 0.5 wt., or 0.0005 wt.% to 0.1 wt.%;
water; and
an abrasive preferably selected from the group consisting of inorganic oxide particles, metal oxide-coated inorganic oxide particles, organic polymer particles, metal oxide-coated organic polymer particles, and combinations thereof, wherein the abrasive preferably ranges from 0.01 wt.% to 30 wt.%, 0.05 wt.% to 20 wt.%, 0.01 wt.% to 10 wt.%, or from 0.1 wt.% to 2 wt.%;
and optionally
an activator preferably selected from the group consisting of
(1) inorganic oxide particle with transition metal coated onto its surface; and the transition metal is selected from the group consisting of Fe, Cu, Mn, Co, Ce, and combinations thereof;
(2) soluble catalyst selected from the group consisting of ammonium iron (III) oxalate trihydrate, iron (III) citrate tribasic monohydrate, iron (III) acetylacetonate and ethylenediamine tetraacetic acid, iron (III) sodium salt hydrate;
(3) a metal compound having multiple oxidation states selected from the group consisting of Ag, Co, Cr, Cu, Fe, Mo, Mn, Nb, Ni, Os, Pd, Ru, Sn, Ti, V; and combinations thereof,
wherein the activator preferably ranges from 0.00001 wt.% to 5.0 wt.%, 0.0001 wt.% to 2.0 wt.%, 0.0005 wt.% to 1.0 wt.%, or 0.001 wt.% to 0.5 wt.%;
an oxidizing agent preferably selected from the group consisting of peroxy compound selected from the group consisting of hydrogen peroxide, urea peroxide, peroxyformic acid, peracetic acid, propaneperoxoic acid, substituted or
unsubstituted butaneperoxoic acid, hydroperoxy-acetaldehyde, potassium periodate, ammonium peroxymonosulfate; and non-peroxy compound selected from the group consisting of ferric nitrite, KClO₄, KBrO₄, KMnO₄; and combinations thereof, wherein the oxidizing agent preferably ranges from 0.01 wt.% to 30 wt.%, 0.1 wt.% to 20 wt.%, or 0.5 wt.% to 10 wt.%;
a corrosion inhibitor preferably selected from the group consisting of 1,2,3-triazole, 1,2,4-triazole, 1,2,3-benzotriazole, 5-methylbenzotriazole, benzotriazole, 1-hydroxybenzotriazole, 4-hydroxybenzotriazole, 3-amino-1,2,4-triazole, 4-amino-4H-1,2,4-triazole, 5-aminotriazole, benzimidazole, 2,1,3-benzothiadiazole, triazinethiol, triazinedithiol, and triazinetrithiol, pyrazoles, imidazoles, isocyanurate such as 1,3,5-tris(2-hydroxyethyl), and combinations thereof, wherein the corrosion inhibitor preferably ranges from less than 1.0 wt.%, less than 0.5 wt.%, or less than 0.25 wt.%;
a dishing reducing agent preferably selected from the group consisting of sarcosinate and related carboxylic compounds; hydrocarbon substituted sarcosinate; amino acids; organic polymers and copolymers having molecules containing ethylene oxide repeating units, such as polyethylene oxide (PEO); ethoxylated surfactants; nitrogen containing heterocycles without nitrogen-hydrogen bonds; sulfide; oxazolidine or mixture of functional groups in one compound; nitrogen containing compounds having three or more carbon atoms that form alkylammonium ions; amino alkyls having three or more carbon atoms; polymeric corrosion inhibitor comprising a repeating group of at least one nitrogen-containing heterocyclic ring or a tertiary or quaternary nitrogen atom; polycationic amine compound; cyclodextrin compound; polyethyleneimine compound; glycolic acid; chitosan; sugar alcohols; polysaccharides; alginate compound; phosphonium compound; and sulfonic acid polymer; and combinations thereof, wherein the dishing reducing agent preferably ranges from 0.001 wt.% to 2.0 wt. %, 0.005 wt.% to 1.5 wt. %, or 0.01 wt.% to 1.0 wt. %;
a stabilizer preferably selected from the group consisting of adipic acid, phthalic acid, citric acid, malonic acid, orthophthalic acid; phosphoric acid; substituted or unsubstituted phosphonic acids; nitriles; and combinations thereof, wherein the stabilizer preferably ranges from 0.0001 to 5 wt.%, 0.0005 to 2 wt.%, or 0.001 to 1 wt.%;
a pH adjusting agent, wherein the pH adjusting agent is preferably selected from the group consisting of
(a) nitric acid, sulfuric acid, tartaric acid, succinic acid, citric acid, malic acid, malonic acid, various fatty acids, various polycarboxylic acids, and mixtures thereof to lower the pH; and
(b) potassium hydroxide, sodium hydroxide, ammonia, tetraethylammonium hydroxide, ethylenediamine, piperazine, polyethyleneimine, modified polyethyleneimine, and mixtures thereof to raise the pH; and
pH of the composition is preferably between 1 and 14, 1 and 7, 1 and 6, or 1 and 4;
and
c) polishing the at least one surface containing tungsten with the chemical mechanical planarization composition.

11. The polishing method of Claim 10, wherein the chemical mechanical planarization composition comprises the abrasive; and
the imidazolium-based poly(ionic liquid) selected from the group consisting of poly(vinyl benzyl 1-butyl-1*H*-imidazol-3-ium) chloride, poly(vinyl 3-ethyl-1*H*-imidazol-3-ium) bromide, poly(vinyl benzyl 1-butyl-1*H*-imidazol-3-ium-co-acrylamide) chloride, poly(vinyl benzyl 1-butyl-1*H*-imidazol-3-ium-co-acrylomorpholine) chloride, poly(vinyl 3-ethyl-1*H*-imidazol-3-ium-co-N-vinylpyrrolidone) bromide, poly(vinyl benzyl 1-butyl-1*H*-imidazol-3-ium-co-*N*-methyl maleimide) chloride, poly 3-butyl-1*H*-imidazol-3-ium acetate, and poly 3-(2,2'-(ethane-1,2-diylbis(oxy))bis(ethane)-1*H*-imidazol-3-ium acetate, poly(vinyl 3-butyl-1*H*-imidazol-3-ium) bromide, *poly(vinylbenzyl-1-ethyl-1H-*imidazol-3-ium) chloride, poly(vinyl 3-ethyl-1*H*-imidazol-3-ium-co-vinyl 3,3'-butane-1*H-*imidazol-3-ium) bromide, poly(vinylbenzyl-1-ethyl-1*H*-imidazol-3-ium-co-vinyl-3-ethyl-1*H*-imidazol-3-ium) bromide chloride, poly(1-ethyl-3-propyl-1*H*-imidazol-3-ium acrylate) bromide, poly(vinyl 3-isopropyl-1*H*-imidazol-3-ium) bromide, poly(vinyl 3-isopropyl-1*H*-imidazol-3-ium-co-*N*-vinylpyrrolidone) bromide, poly(vinyl 3-butyl-1*H-*imidazol-3-ium-co-*N*-vinylpyrrolidone) bromide, poly(vinyl 3-ethyl-1*H*-imidazol-3-ium) acetate, poly(vinyl 3-ethyl-1*H*-imidazol-3-ium) malonate, poly(vinyl 3-ethyl-1*H-*imidazol-3-ium) nitrate, and combinations thereof or
wherein the chemical mechanical planarization composition comprises silica particles; ferric nitrate, malonic acid, hydrogen peroxide, the imidazolium-based poly(ionic liquid) selected from the group consisting of poly(vinyl benzyl 1-butyl-1*H-*imidazol-3-ium) chloride, poly(vinyl 3-ethyl-1*H*-imidazol-3-ium) bromide, poly(vinyl benzyl 1-butyl-1*H*-imidazol-3-ium-co-acrylamide) chloride, poly (vinyl benzyl 1-butyl-1*H*-imidazol-3-ium-co-acrylomorpholine) chloride, poly(vinyl 3-ethyl-1*H*-imidazol-3-ium-co-*N*-vinylpyrrolidone) bromide, poly (vinyl benzyl 1-butyl-1*H*-imidazol-3-ium-co*N*-methyl maleimide) chloride, poly 3-butyl-1*H*-imidazol-3-ium acetate, poly 3-(2,2'-(ethane-1,2-diylbis(oxy))bis(ethane)-1*H*-imidazol-3-ium acetate, poly(vinyl 3-butyl-1*H-*imidazol-3-ium) bromide, poly(vinylbenzyl-1-ethyl-1*H*-imidazol-3-ium) chloride, poly(vinyl 3-ethyl-1*H*-imidazol-3-ium-co-vinyl 3,3'-butane-1*H*-imidazol-3-ium) bromide, poly(vinylbenzyl-1-ethyl-1*H*-imidazol-3-ium-co-vinyl-3-ethyl-1*H*-imidazol-3-ium) bromide chloride, poly(1-ethyl-3-propyl-1*H*-imidazol-3-ium acrylate) bromide, poly(vinyl 3-isopropyl-1*H*-imidazol-3-ium) bromide, poly(vinyl 3-isopropyl-1*H-*imidazol-3-ium-co-*N*-vinylpyrrolidone) bromide, poly(vinyl 3-butyl-1*H*-imidazol-3-ium-co-*N*-vinylpyrrolidone) bromide, poly(vinyl 3-ethyl-1*H*-imidazol-3-ium) acetate, poly(vinyl 3-ethyl-1*H*-imidazol-3-ium) malonate, poly(vinyl 3-ethyl-1*H*-imidazol-3-ium) nitrate, and combinations thereof.

12. The polishing method of Claim 10, wherein at least one surface containing tungsten comprises a dishing topography of less than 2000 or less than 1000 Angstroms and an erosion topography of less than 2000 or less than 1000 Angstroms.

13. A system for chemical mechanical planarization of a semiconductor substrate comprising at least one surface containing tungsten, comprising:
a) a polishing pad; and
b) a chemical mechanical planarization composition comprising:
an additive comprising the imidazolium-based poly(ionic liquid) of any one of claims 1 to 7, wherein the additive comprising an imidazolium-based cationic polymer preferably ranges from 0.00001 wt.% to 1 wt.%, 0.0001 wt.% to 0.5 wt., or 0.0005 wt.% to 0.1 wt.%;
water; and
an abrasive preferably selected from the group consisting of inorganic oxide particles, metal oxide-coated inorganic oxide particles, organic polymer particles, metal oxide-coated organic polymer particles, and combinations thereof, wherein the abrasive preferably ranges from 0.01 wt.% to 30 wt.%, 0.05 wt.% to 20 wt.%, 0.01 wt.% to 10 wt.%, or from 0.1 wt.% to 2 wt.%;
and optionally
an activator preferably selected from the group consisting of
(1) inorganic oxide particle with transition metal coated onto its surface; and the transition metal is selected from the group consisting of Fe, Cu, Mn, Co, Ce, and combinations thereof;
(2) soluble catalyst selected from the group consisting of ammonium iron (III) oxalate trihydrate, iron (III) citrate tribasic monohydrate, iron (III) acetylacetonate and ethylenediamine tetraacetic acid, iron (III) sodium salt hydrate;
(3) a metal compound having multiple oxidation states selected from the group consisting of Ag, Co, Cr, Cu, Fe, Mo, Mn, Nb, Ni, Os, Pd, Ru, Sn, Ti, V; and combinations thereof,
wherein the activator preferably ranges from 0.00001 wt.% to 5.0 wt.%, 0.0001 wt.% to 2.0 wt.%, 0.0005 wt.% to 1.0 wt.%, or 0.001 wt.% to 0.5 wt.%;
an oxidizing agent preferably selected from the group consisting of peroxy compound selected from the group consisting of hydrogen peroxide, urea peroxide, peroxyformic acid, peracetic acid, propaneperoxoic acid, substituted or unsubstituted butaneperoxoic acid, hydroperoxy-acetaldehyde, potassium periodate, ammonium peroxymonosulfate; and non-peroxy compound selected from the group consisting of ferric nitrite, KClO₄, KBrO₄, KMnO₄; and combinations thereof, wherein the oxidizing agent preferably ranges from 0.01 wt.% to 30 wt.%, 0.1 wt.% to 20 wt.%, or 0.5 wt.% to 10 wt.%;
a corrosion inhibitor preferably selected from the group consisting of 1,2,3-triazole, 1,2,4-triazole, 1,2,3-benzotriazole, 5-methylbenzotriazole, benzotriazole, 1-hydroxybenzotriazole, 4-hydroxybenzotriazole, 3-amino-1,2,4-triazole, 4-amino-4H-1,2,4-triazole, 5-aminotriazole, benzimidazole, 2,1,3-benzothiadiazole, triazinethiol, triazinedithiol, and triazinetrithiol, pyrazoles, imidazoles, isocyanurate such as 1,3,5-tris(2-hydroxyethyl), and combinations thereof, wherein the corrosion inhibitor preferably ranges from less than 1.0 wt.%, less than 0.5 wt.%, or less than 0.25 wt.%;
a dishing reducing agent preferably selected from the group consisting of sarcosinate and related carboxylic compounds; hydrocarbon substituted sarcosinate; amino acids; organic polymers and copolymers having molecules containing ethylene oxide repeating units, such as polyethylene oxide (PEO); ethoxylated surfactants; nitrogen containing heterocycles without nitrogen-hydrogen bonds; sulfide; oxazolidine or mixture of functional groups in one compound; nitrogen containing compounds having three or more carbon atoms that form alkylammonium ions; amino alkyls having three or more carbon atoms; polymeric corrosion inhibitor comprising a repeating group of at least one nitrogen-containing heterocyclic ring or a tertiary or quaternary nitrogen atom; polycationic amine compound; cyclodextrin compound; polyethyleneimine compound; glycolic acid; chitosan; sugar alcohols; polysaccharides; alginate compound; phosphonium compound; and sulfonic acid polymer; and combinations thereof, wherein the dishing reducing agent preferably ranges from 0.001 wt.% to 2.0 wt. %, 0.005 wt.% to 1.5 wt. %, or 0.01 wt.% to 1.0 wt. %
a stabilizer preferably selected from the group consisting of adipic acid, phthalic acid, citric acid, malonic acid, orthophthalic acid; phosphoric acid; substituted or unsubstituted phosphonic acids; nitriles; and combinations thereof, wherein the stabilizer preferably ranges from 0.0001 to 5 wt.%, 0.0005 to 2 wt.%, or 0.001 to 1 wt.%;
a pH adjusting agent preferably selected from the group consisting of
(a) nitric acid, sulfuric acid, tartaric acid, succinic acid, citric acid, malic acid, malonic acid, various fatty acids, various polycarboxylic acids, and mixtures thereof to lower the pH; and
(b) potassium hydroxide, sodium hydroxide, ammonia, tetraethylammonium hydroxide, ethylenediamine, piperazine, polyethyleneimine, modified polyethyleneimine, and mixtures thereof to raise the pH; and
pH of the composition is preferably between 1 and 14, 1 and 7, 1 and 6, or 1 and 4; and
wherein the at least one surface containing tungsten is in contact with the polishing pad and the chemical mechanical planarization composition polishing the at least one surface containing tungsten with the chemical mechanical planarization composition.

14. The system of Claim 13, wherein the chemical mechanical planarization composition comprises
silica particles; and the imidazolium-based poly(ionic liquid) selected from the group consisting of poly(vinyl benzyl 1-butyl-1H-imidazol-3-ium) chloride, poly(vinyl 3-ethyl-1H-imidazol-3-ium) bromide, poly(vinyl benzyl 1-butyl-1H-imidazol-3-ium-co-acrylamide) chloride, poly(vinyl benzyl 1-butyl-1*H*-imidazol-3-ium-co-acrylomorpholine) chloride, poly(vinyl 3-ethyl-1*H*-imidazol-3-ium-co-N-vinylpyrrolidone) bromide, poly(vinyl benzyl 1-butyl-1*H*-imidazol-3-ium-co-*N*-methyl maleimide) chloride, poly 3-butyl-1*H*-imidazol-3-ium acetate, and poly 3-(2,2'-(ethane-1,2-diylbis(oxy))bis(ethane)-1*H*-imidazol-3-ium acetate, poly(vinyl 3-butyl-1*H*-imidazol-3-ium) bromide, poly(vinylbenzyl-1-ethyl-1*H*-imidazol-3-ium) chloride, poly(vinyl 3-ethyl-1*H*-imidazol-3-ium-co-vinyl 3,3'-butane-1*H*-imidazol-3-ium) bromide, poly(vinylbenzyl-1-ethyl-1*H*-imidazol-3-ium-co-vinyl-3-ethyl-1H-imidazol-3-ium) bromide chloride, poly(1-ethyl-3-propyl-1*H*-imidazol-3-ium acrylate) bromide, poly(vinyl 3-isopropyl-1*H*-imidazol-3-ium) bromide, poly(vinyl 3-isopropyl-1*H-*imidazol-3-ium-co-*N*-vinylpyrrolidone) bromide, poly(vinyl 3-butyl-1*H*-imidazol-3-ium-co-*N*-vinylpyrrolidone) bromide, poly(vinyl 3-ethyl-1*H*-imidazol-3-ium) acetate, poly(vinyl 3-ethyl-1*H*-imidazol-3-ium) malonate, poly(vinyl 3-ethyl-1*H*-imidazol-3-ium) nitrate, and combinations thereof; or
the chemical mechanical planarization composition comprises silica particles; ferric nitrate, malonic acid, hydrogen peroxide, the imidazolium-based poly(ionic liquid) selected from the group consisting of poly(vinyl benzyl 1-butyl-1*H*-imidazol-3-ium) chloride, poly(vinyl 3-ethyl-1*H*-imidazol-3-ium) bromide, poly(vinyl benzyl 1-butyl-1*H-*imidazol-3-ium-co-acrylamide) chloride,, poly(vinyl benzyl 1-butyl-1*H*-imidazol-3-ium-co-acrylomorpholine) chloride, poly(vinyl 3-ethyl-1*H*-imidazol-3-ium-co-N-vinylpyrrolidone) bromide, poly(vinyl benzyl 1-butyl-1*H*-imidazol-3-ium-co-*N*-methyl maleimide) chloride, poly 3-butyl-1*H*-imidazol-3-ium acetate, poly 3-(2,2'-(ethane-1,2-diylbis(oxy))bis(ethane)-1*H*-imidazol-3-ium acetate, poly(vinyl 3-butyl-1*H*-imidazol-3-ium) bromide, poly(vinylbenzyl-1-ethyl-1*H*-imidazol-3-ium) chloride, poly(vinyl 3-ethyl-1*H*-imidazol-3-ium-co-vinyl 3,3'-butane-1*H*-imidazol-3-ium) bromide, poly(vinylbenzyl-1-ethyl-1*H*-imidazol-3-ium-co-vinyl-3-ethyl-1*H*-imidazol-3-ium) bromide chloride, poly(1-ethyl-3-propyl-1*H*-imidazol-3-ium acrylate) bromide, poly(vinyl 3-isopropyl-1*H-*imidazol-3-ium) bromide, poly(vinyl 3-isopropyl-1*H*-imidazol-3-ium-co-*N-*vinylpyrrolidone) bromide, poly(vinyl 3-butyl-1*H*-imidazol-3-ium-co-*N*-vinylpyrrolidone) bromide, poly(vinyl 3-ethyl-1*H*-imidazol-3-ium) acetate, poly(vinyl 3-butyl-1*H-*imidazol-3-ium-co-*N*-vinylpyrrolidone) bromide, poly(vinyl 3-ethyl-1*H*-imidazol-3-ium) malonate, poly(vinyl 3-ethyl-1*H-*imidazol-3-ium) nitrate, and combinations thereof.

## Patentansprüche

1. Zusammensetzung für die chemisch-mechanische Planarisierung enthaltend ein Abrasivmittel und eine imidazoliumbasierte Poly(ionische Flüssigkeit) enthaltend mindestens ein Monomer mit mindestens einer Imidazoliumgruppe mit der Struktur (I): 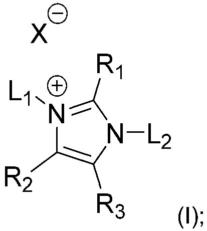 wobei
(a) die mindestens eine Imidazoliumgruppe mit der Struktur (I) in einer Seitenkette oder Seitenketten der imidazoliumbasierten Poly(ionischen Flüssigkeit) vorliegt;
wobei
einer von L₁ und L₂ eine kovalente Bindung oder ein Spacer ist, die/der den Imidazoliumring mit der Hauptkette der imidazoliumbasierten Poly(ionischen Flüssigkeit) verbindet, und eine substituierte oder unsubstituierte aliphatische, cyclische oder verzweigte aliphatische, aromatische, heteroaromatische oder Siloxan-Grupppierung enthält; wobei die Hauptkette nach der Polymerisation einer polymerisierbaren Gruppe gebildet wird, die ausgewählt ist aus der Gruppe bestehend aus Vinyl, Allyl, Styrol, Acryl, Methacryl, Acrylamid, Methacrylamid, Siloxan, Maleinimid, Norbornen und Kombinationen davon; ein anderer von L₁ und L₂ eine Alkylgruppe ist, die ausgewählt ist aus der Gruppe bestehend aus linearer, verzweigter und cyclischer Alkylgruppe; wobei CH₂ davon so durch O, S oder N ersetzt sein kann, dass keine Heteroatome miteinander verbunden sind; Wasserstoff durch F, Cl oder CN ersetzt sein kann;
R₁, R₂, R₃ jeweils unabhängig H oder eine Alkylgruppe sein können, die ausgewählt ist aus der Gruppe bestehend aus linearer, verzweigter und cyclischer Alkylgruppe; wo CH₂ davon so durch O, S oder N ersetzt sein kann, dass keine Heteroatome miteinander verbunden sind; und Wasserstoff durch F, Cl oder CN ersetzt sein kann; R₂ und R₃ auch zu einer cyclischen Einheit verbunden sein können; vorzugsweise R₁= R₂ = H;
und
Anion X⁻ ausgewählt ist aus der Gruppe bestehend aus Halogenid (F-, Cl-, Br-, I-), BF₄-, PF₆-, [C₂F₅BF₃]-, Carboxylat RCOO- mit R = H, Alkyl oder Aryl; Malonat, Citrat, Fumarat, MeOSO₃-, MeSO₃-, CF₃COO-, CF₃SO₃-, Nitrat und Sulfat; bei denen Me Methyl ist;
(b) die mindestens eine Imidazoliumgruppe mit der Struktur (I) in der Hauptkette der imidazoliumbasierten Poly(ionischen Flüssigkeit) vorliegt;
wobei
L₁ and L₂ jeweils unabhängig eine substituierte oder unsubstituierte aliphatische, cyclische oder verzweigte aliphatische, aromatische, heteroaromatische oder Siloxan-Grupppierung enthalten; wobei CH₂ davon so durch O, S oder N ersetzt sein kann, dass keine Heteroatome miteinander verbunden sind; Wasserstoff durch F, Cl oder CN ersetzt sein kann;
L₁, L₂ oder sowohl L₁ als auch L₂ die mindestens eine Imidazoliumgruppe über eine geeignete funktionelle Gruppe mit der Hauptkette verbinden können, so dass die imidazolimbasierte Poly(ionische Flüssigkeit) gebildet wird; wobei die geeignete funktionelle Gruppe ausgewählt ist aus der Gruppe bestehend aus Estern, Amiden, Urethanen, Ethern, Thioethern, Imiden und Kombinationen davon;
R₁, R₂, R₃ jeweils unabhängig H oder eine Alkylgruppe sein können, die ausgewählt ist aus der Gruppe bestehend aus linearer, verzweigter und cyclischer Alkylgruppe; wo CH₂ so durch O, S oder N ersetzt sein kann, dass keine Heteroatome miteinander verbunden sind; und Wasserstoff durch F, Cl oder CN ersetzt sein kann; R₂ und R₃ auch zu einer cyclischen Einheit verbunden sein können; vorzugsweise R₁= R₂ = H;
und
Anion X⁻ ausgewählt ist aus der Gruppe bestehend aus Halogenid (F-, Cl-, Br-, I-), BF₄-, PF₆-, [C₂F₅BF₃]-, Carboxylat RCOO- mit R = H, Alkyl oder Aryl; Malonat, Citrat, Fumarat, MeOSO₃-, MeSO₃-, CF₃COO-, CF₃SO₃-, Nitrat und Sulfat, wobei Me Methyl ist;
und
(c) die mindestens eine Imidazoliumgruppe mit der Struktur (I) sowohl in der Seitenkette oder den Seitenketten der imidazoliumbasierten Poly(ionischen Flüssigkeit) wie vorstehend in (a) definiert und in der Hauptkette der imidazoliumbasierten Poly(ionischen Flüssigkeit) wie vorstehend in (b) definiert vorliegt.

2. Zusammensetzung für die chemisch-mechanische Planarisierung des Anspruchs 1, wobei die imidazoliumbasierte Poly(ionische Flüssigkeit) ein vernetzbares Monomer mit polymerisierbaren Gruppen für L₁ und L₂ von (a) enthält.

3. Zusammensetzung für die chemisch-mechanische Planarisierung des Anspruchs 1, wobei es sich bei der imidazoliumbasierten Poly(ionischen Flüssigkeit) um ein Copolymer handelt, das mindestens zwei verschiedene aus (a), (b) ausgewählte Monomere und (e) ein nichtionisches Monomer enthält, das mit dem Monomer in (a) oder dem Monomer in (b) Copolymere bilden kann und ausgewählt ist aus der Gruppe bestehend aus Acrylat oder Methacrylat, Acrylamid oder Methacrylamid, Maleinimid, Vinylbenzol, Monomer des Vinyltyps, Ethylenglykol, Siloxan, Norbornen und Kombinationen davon.

4. Zusammensetzung für die chemisch-mechanische Planarisierung des Anspruchs 1, wobei es sich bei der imidazoliumbasierten Poly(ionischen Flüssigkeit) um ein Blockcopolymer handelt.

5. Zusammensetzung für die chemisch-mechanische Planarisierung des Anspruchs 1, wobei die imidazolimbasierte Poly(ionische Flüssigkeit) mindestens eines von einem funktionellen Anion als Reduktionsmittel oder Komplexierungsmittel enthält.

6. Zusammensetzung für die chemisch-mechanische Planarisierung des Anspruchs 1, wobei die Polymerisation der imidazolimbasierten Poly(ionischen Flüssigkeit) ausgewählt ist aus der Gruppe bestehend aus radikalischer Polymerisation, RAFT-Polymerisation (Reversible Additions-Fragmentierungs-Kettenübertragungspolymerisation), Nitroxid-vermittelter Polymerisation (nitroxide-mediated polymerization - NMP), ATRP (radikalische Atomtransferpolymerisation), Ringöffnungspolymerisation (ROMP), Polykondensationsreaktion und Kombinationen davon.

7. Zusammensetzung für die chemisch-mechanische Planarisierung des Anspruchs 1, wobei die imidazolimbasierte Poly(ionische Flüssigkeit) ausgewählt ist aus der Gruppe bestehend aus Poly(vinyl-benzyl-1-butyl-1*H*-imidazol-3-ium)-chlorid, Poly(vinyl-3-ethyl-1*H*-imidazol-3-ium)-bromid, Poly(vinyl-benzyl-1-butyl-1*H*-imidazol-3-ium-co-acrylamid)-chlorid, Poly(vinyl-benzyl-1-butyl-1*H*-imidazol-3-ium-co-acrylomorpholin)-chlorid, Poly(vinyl-3-ethyl-1*H*-imidazol-3-ium-co-*N*-vinylpyrrolidon)-bromid, Poly(vinyl-benzyl-1-butyl-1*H*-imidazol-3-ium-co-*N*-methyl-maleinimid)-chlorid, Poly-3-butyl-1*H*-imidazol-3-ium-acetat und Poly-3-(2,2'-(ethan-1,2-diylbis(oxy))-bis(ethan)-1*H*-imidazol-3-ium-acetat, Poly(vinyl-3-butyl-1*H*-imidazol-3-ium)-bromid, Poly(vinylbenzyl-1-ethyl-1*H*-imidazol-3-ium)-chlorid, Poly(vinyl-3-ethyl-1*H*-imidazol-3-ium-co-vinyl-3,3'-butan-1*H*-imidazol-3-ium)-bromid, Poly(vinylbenzyl-1-ethyl-1*H-*imidazol-3-ium-co-vinyl-3-ethyl-1*H*-imidazol-3-ium)-bromid-chlorid, Poly(1-ethyl-3-propyl-1H-imidazol-3-ium-acrylat)-bromid, Poly(vinyl-3-isopropyl-1*H*-imidazol-3-ium)-bromid, Poly(vinyl-3-isopropyl-1*H*-imidazol-3-ium-co-*N*-vinylpyrrolidon)-bromid, Poly(vinyl-3-butyl-1*H*-imidazol-3-ium-co-*N*-vinylpyrrolidon)-bromid, Poly(vinyl-3-ethyl-1*H*-imidazol-3-ium)-acetat, Poly(vinyl-3-ethyl-1*H*-imidazol-3-ium)-malonat, Poly(vinyl-3-ethyl-1*H*-imidazol-3-ium)-nitrat und Kombinationen davon.

8. Zusammensetzung für die chemisch-mechanische Planarisierung des Anspruchs 1, wobei die Konzentration des imidazoliumbasierten kationischen Polymers vorzugsweise im Bereich von 0,00001 Gew.-% bis 1 Gew., 0,0001 Gew.-% bis 0,5 Gew.-% oder 0,0005 Gew.-% bis 0,1 Gew.-% liegt und die Zusammensetzung ferner enthält:
Wasser; und
ein Abrasivmittel, das vorzugsweise ausgewählt ist aus der Gruppe bestehend aus anorganischen Oxidpartikeln, metalloxidbeschichteten anorganischen Oxidpartikeln, organischen Polymerpartikeln, metalloxidbeschichteten organischen Polymerpartikeln und Kombinationen davon; wobei das Abrasivmittel vorzugsweise im Bereich von 0,01 Gew.-% bis 30 Gew.-%, 0,05 Gew.-% bis 20 Gew.-%, 0,01 Gew.-% bis 10 Gew.-% oder von 0,1 Gew.-% bis 2 Gew.-% liegt;
und gegebenenfalls
einen Aktivator, der vorzugsweise ausgewählt ist aus der Gruppe bestehend aus
(1) anorganischem Oxidpartikel, dessen Oberfläche mit Übergangsmetall beschichtet ist; und das Übergangsmetall ist ausgewählt aus der Gruppe bestehend aus Fe, Cu, Mn, Co, Ce und Kombinationen davon;
(2) löslichem Katalysator ausgewählt aus der Gruppe bestehend aus Ammoniumeisen(III)-oxalat Trihydrat, Eisen(III)-citrat tribasisch Monohydrat, Eisen(III)-acetylacetonat und Ethylendiamin-tetraessigsäure, Eisen(III)-natriumsalz Hydrat;
(3) einer Metallverbindung mit mehreren Oxidationsstufen ausgewählt aus der Gruppe bestehend aus Ag, Co, Cr, Cu, Fe, Mo, Mn, Nb, Ni, Os, Pd, Ru, Sn, Ti, V und Kombinationen davon,
wobei der Aktivator vorzugsweise im Bereich von 0,00001 Gew.-% bis 5,0 Gew.-%, 0,0001 Gew.-% bis 2,0 Gew.-%, 0,0005 Gew.-% bis 1,0 Gew.-% oder 0,001 Gew.-% bis 0,5 Gew.-% liegt;
ein Oxidationsmittel, das vorzugsweise ausgewählt ist aus der Gruppe bestehend aus Peroxyverbindung ausgewählt aus der Gruppe bestehend aus Wasserstoffperoxid, Harnstoffperoxid, Peroxyameisensäure, Peressigsäure, Propanperoxosäure, substituierter oder unsubstituierter Butanperoxosäure, Hydroperoxy-acetaldehyd, Kaliumperiodat, Ammoniumperoxy-monosulfat; und Nicht-Peroxyverbindung ausgewählt aus der Gruppe bestehend aus Eisennitrit, KClO₄, KBrO₄, KMnO₄, und Kombinationen davon; wobei das Oxidationsmittel vorzugsweise im Bereich von 0,01 Gew.-% bis 30 Gew.-%, 0,1 Gew.-% bis 20 Gew.-% oder 0,5 Gew.-% bis 10 Gew.-% liegt;
einen Korrosionshemmer, der vorzugsweise ausgewählt ist aus der Gruppe bestehend aus 1,2,3-Triazol, 1,2,4-Triazol, 1,2,3-Benzotriazol, 5-Methylbenzotriazol, Benzotriazol, 1-Hydroxybenzotriazf, 4-Hydroxybenzotriazol, 3-Amino-1,2,4-triazol, 4-Amino-4H-1,2,4-triazol, 5-Amino-triazol, Benzimidazol, 2,1,3-Benzothiadiazol, Triazinthiol, Triazindithiol und Triazintrithiol, Pyrazolen, Imidazolen, Isocyanurat wie 1,3,5-Tris(2-hydroxyethyl)-isocyanurat und Kombinationen davon; wobei der Korrosionshemmer vorzugsweise im Bereich von weniger als 1,0 Gew.-%, weniger als 0,5 Gew.-% oder weniger als 0,25 Gew.-% liegt;
einen Dishing-Verminderer, der vorzugsweise ausgewählt ist aus der Gruppe bestehend aus Sarkosinat und verwandten Carbonsäureverbindungen; kohlenwasserstoffsubstituiertem Sarkosinat; Aminosäuren; organischen Polymeren und Copolymeren mit Molekülen, die Ethylenoxid-Wiederholungseinheiten, wie Polyethylenoxid (PEO), enthalten; ethoxylierten Tensiden; stickstoffhaltigen Heterocyclen ohne Stickstoff-Wasserstoff-Bindungen; Sulfid; Oxazolidin oder Mischung von funktionellen Gruppen in einer Verbindung; stickstoffhaltigen Verbindungen mit drei oder mehr Kohlenstoffatomen, die Alkylammoniumionen bilden; Aminoalkylen mit drei oder mehr Kohlenstoffatomen; polymerem Korrosionshemmer mit einer wiederholenden Gruppe aus mindestens einem stickstoffhaltigen heterocyclischen Ring oder einem tertiären oder quaternären Stickstoffatom; polykationischer Aminverbindung; Cyclodextrinverbindung; Polyethyleniminverbindung; Glykolsäure; Chitosan; Zuckeralkoholen; Polysacchariden; Alginatverbindung; Phosphoniumverbindung und Sulfonsäurepolymer und Kombinationen davon, wobei der Dishing-Verminderer vorzugsweise im Bereich von 0,001 Gew.-% bis 2,0 Gew.-%, 0,005 Gew.-% bis 1,5 Gew.-% oder 0,01 Gew.-% bis 1,0 Gew.-% liegt;
einen Stabilisator, der vorzugsweise ausgewählt ist aus der Gruppe bestehend aus Adipinsäure, Phthalsäure, Zitronensäure, Malonsäure, Orthophthalsäure; Phosphorsäure; substituierten oder unsubstituierten Phosphonsäuren; Nitrilen und Kombinationen davon, wobei der Stabilisator vorzugsweise im Bereich von 0,0001 bis 5 Gew.₋%, 0,0005 bis 2 Gew.-% oder 0,001 bis 1 Gew.-% liegt;
einen pH-Regulator, der vorzugsweise ausgewählt ist aus der Gruppe bestehend aus
(a) Salpetersäure, Schwefelsäure, Weinsäure, Bernsteinsäure, Zitronensäure, Äpfelsäure, Malonsäure, verschiedenen Fettsäuren, verschiedenen Polycarbonsäuren und Mischungen davon zur Absenkung des pH; und
(b) Kaliumhydroxid, Natriumhydroxid, Ammoniak, Tetraethylammoniumhydroxid, Ethylendiamin, Piperazin, Polyethylenimin, modifiziertem Polyethylenimin and Mischungen davon zur Erhöhung des pH; und
wobei der pH der Zusammensetzung vorzugsweise zwischen 1 und 14, 1 und 7, 1 und 6 oder 1 und 4 liegt.

9. Zusammensetzung für die chemisch-mechanische Planarisierung des Anspruchs 1,
wobei die Zusammensetzung für die chemisch-mechanische Planarisierung Kieselsäurepartikel und die imidazoliumbasierte Poly(ionische Flüssigkeit) ausgewählt aus der Gruppe bestehend aus Poly(vinyl-benzyl-1-butyl-1*H*-imidazol-3-ium)-chlorid, Poly(vinyl-3-ethyl-1*H*-imidazol-3-ium)-bromid, Poly(vinyl-benzyl-1-butyl-1*H-*imidazol-3-ium-co-acrylamid)-chlorid, Poly(vinyl-benzyl-1-butyl-1*H*-imidazol-3-ium-co-acrylomorpholin)-chlorid, Poly(vinyl-3-ethyl-1*H*-imidazol-3-ium-co-*N*-vinylpyrrolidon)-bromid, Poly(vinyl-benzyl-1-butyl-1*H*-imidazol-3-ium-co-*N*-methyl-maleinimid)-chlorid, Poly-3-butyl-1*H*-imidazol-3-ium-acetat und Poly-3-(2,2'-(ethan-1,2-diylbis(oxy))bis-(ethan)-1*H*-imidazol-3-ium-acetat, Poly(vinyl-3-butyl-1*H*-imidazol-3-ium)-bromid, Poly(vinylbenzyl-1-ethyl-1*H*-imidazol-3-ium)-chlorid, Poly(vinyl-3-ethyl-1*H*-imidazol-3-ium-co-vinyl-3,3'-butan-1*H*-imidazol-3-ium)-bromid, Poly(vinylbenzyl-1-ethyl-1*H-*imidazol-3-ium-co-vinyl-3-ethyl-1*H*-imidazol-3-ium)-bromid-chlorid, Poly(1-ethyl-3-propyl-1H-imidazol-3-ium-acrylat)-bromid, Poly(vinyl-3-isopropyl-1*H*-imidazol-3-ium)-bromid, Poly(vinyl-3-isopropyl-1*H*-imidazol-3-ium-co-*N*-vinylpyrrolidon)-bromid, Poly(vinyl-3-butyl-1*H*-imidazol-3-ium-co-*N*-vinylpyrrolidon)-bromid, Poly(vinyl-3-ethyl-1*H*-imidazol-3-ium)-acetat, Poly(vinyl-3-ethyl-1*H*-imidazol-3-ium)-malonat, Poly(vinyl-3-ethyl-1*H*-imidazol-3-ium)-nitrat und Kombinationen davon enthält; oder
die Zusammensetzung für die chemisch-mechanische Planarisierung Kieselsäurepartikel; Eisen(III)-nitrat, Malonsäure, Wasserstoffperoxid, die imidazoliumbasierte Poly(ionische Flüssigkeit) ausgewählt aus der Gruppe bestehend aus Poly(vinylbenzyl-1-butyl-1*H*-imidazol-3-ium)-chlorid, Poly(vinyl-3-ethyl-1*H*-imidazol-3-ium)-bromid, Poly(vinyl-benzyl-1-butyl-1*H*-imidazol-3-ium-co-acrylamid)-chlorid, Poly(vinylbenzyl-1-butyl-1*H*-imidazol-3-ium-co-acrylomorpholin)-chlorid, Poly(vinyl-3-ethyl-1*H-*imidazol-3-ium-co-*N*-vinylpyrrolidon)-bromid, Poly(vinyl-benzyl-1-butyl-1*H*-imidazol-3-ium-co-*N*-methyl-maleinimid)-chlorid, Poly-3-butyl-1*H*-imidazol-3-ium-acetat und Poly-3-(2,2'-(ethan-1,2-diylbis(oxy))bis(ethan)-1*H*-imidazol-3-ium-acetat, Poly(vinyl-3-butyl-1*H*-imidazol-3-ium)-bromid, Poly(vinylbenzyl-1-ethyl-1*H*-imidazol-3-ium)-chlorid, Poly(vinyl-3-ethyl-1*H*-imidazol-3-ium-co-vinyl-3,3'-butan-1*H*-imidazol-3-ium)-bromid, Poly(vinylbenzyl-1-ethyl-1*H*-imidazol-3-ium-co-vinyl-3-ethyl-1*H*-imidazol-3-ium)-bromid-chlorid, Poly(1-ethyl-3-propyl-1H-imidazol-3-ium-acrylat)-bromid, Poly(vinyl-3-isopropyl-1*H*-imidazol-3-ium)-bromid, Poly(vinyl-3-isopropyl-1*H*-imidazol-3-ium-co-*N-*vinylpyrrolidon)-bromid, Poly(vinyl-3-butyl-1*H*-imidazol-3-ium-co-*N*-vinylpyrrolidon)-bromid, Poly(vinyl-3-ethyl-1*H*-imidazol-3-ium)-acetat, Poly(vinyl-3-ethyl-1*H*-imidazol-3-ium)-malonat, Poly(vinyl-3-ethyl-1*H*-imidazol-3-ium)-nitrat und Kombinationen davon enthält.

10. Polierverfahren zur chemisch-mechanischen Planarisierung eines Halbleitersubstrats umfassend mindestens eine wolframhaltige Oberfläche,
wobei das Polierverfahren die folgenden Schritte umfasst:
a) Bereitstellen eines Polierkissens;
b) Bereitstellen einer Zusammensetzung für die chemisch-mechanische Planarisierung enthaltend:
einen Zusatz enthaltend die imidazoliumbasierte Poly(ionische Flüssigkeit) nach irgendeinem der Ansprüche 1 bis 7, wobei der Zusatz enthaltend ein imidazoliumbasiertes kationisches Polymer vorzugsweise im Bereich von 0,00001 Gew.-% bis 1 Gew., 0,0001 Gew.-% bis 0,5 Gew.-% oder 0,0005 Gew.-% bis 0,1 Gew.-% liegt;
Wasser; und
ein Abrasivmittel, vorzugsweise ausgewählt aus der Gruppe bestehend aus anorganischen Oxidpartikeln, metalloxidbeschichteten anorganischen Oxidpartikeln, organischen Polymerpartikeln, metalloxidbeschichteten organischen Polymerpartikeln und Kombinationen davon; wobei das Abrasivmittel vorzugsweise im Bereich von 0,01 Gew.-% bis 30 Gew.-%, 0,05 Gew.-% bis 20 Gew.-%, 0,01 Gew.-% bis 10 Gew.-% oder von 0,1 Gew.-% bis 2 Gew.-% liegt;
und gegebenenfalls
einen Aktivator, vorzugsweise ausgewählt aus der Gruppe bestehend aus
(1) anorganischem Oxidpartikel, dessen Oberfläche mit Übergangsmetall beschichtet ist; und das Übergangsmetall ist ausgewählt aus der Gruppe bestehend aus Fe, Cu, Mn, Co, Ce und Kombinationen davon;
(2) löslichem Katalysator ausgewählt aus der Gruppe bestehend aus Ammoniumeisen(III)-oxalat Trihydrat, Eisen(III)-citrat tribasisch Monohydrat, Eisen(III)-acetylacetonat und Ethylendiamin-tetraessigsäure, Eisen(III)-natriumsalz Hydrat;
(3) einer Metallverbindung mit mehreren Oxidationsstufen ausgewählt aus der Gruppe bestehend aus Ag, Co, Cr, Cu, Fe, Mo, Mn, Nb, Ni, Os, Pd, Ru, Sn, Ti, V und Kombinationen davon,
wobei der Aktivator vorzugsweise im Bereich von 0,00001 Gew.-% bis 5,0 Gew.- %, 0,0001 Gew.-% bis 2,0 Gew.-%, 0,0005 Gew.-% bis 1,0 Gew.-% oder 0,001 Gew.-% bis 0,5 Gew.-% liegt;
ein Oxidationsmittel, vorzugsweise ausgewählt aus der Gruppe bestehend aus Peroxyverbindung ausgewählt aus der Gruppe bestehend aus Wasserstoffperoxid, Harnstoffperoxid, Peroxyameisensäure, Peressigsäure, Propanperoxosäure, substituierter oder unsubstituierter Butanperoxosäure, Hydroperoxy-acetaldehyd, Kaliumperiodat, Ammoniumperoxy-monosulfat; und Nicht-Peroxyverbindung ausgewählt aus der Gruppe bestehend aus Eisennitrit, KClO₄, KBrO₄, KMnO₄, und Kombinationen davon; wobei das Oxidationsmittel vorzugsweise im Bereich von 0,01 Gew.-% bis 30 Gew.-%, 0,1 Gew.-% bis 20 Gew.-% oder 0,5 Gew.-% bis 10 Gew.-% liegt;
einen Korrosionshemmer, vorzugsweise ausgewählt aus der Gruppe bestehend aus 1,2,3-Triazol, 1,2,4-Triazol, 1,2,3-Benzotriazol, 5-Methylbenzotriazol, Benzotriazol, 1-Hydroxybenzotriazol, 4-Hydroxybenzotriazol, 3-Amino-1,2,4-triazol, 4-Amino-4H-1,2,4-triazol, 5-Aminotriazol, Benzimidazol, 2,1,3-Benzothiadiazol, Triazinthiol, Triazindithiol und Triazintrithiol, Pyrazolen, Imidazolen, Isocyanurat wie 1,3,5-Tris(2-hydroxyethyl)-isocyanurat und Kombinationen davon; wobei der Korrosionshemmer vorzugsweise im Bereich von weniger als 1,0 Gew.-%, weniger als 0,5 Gew.-% oder weniger als 0,25 Gew.-% liegt;
einen Dishing-Verminderer, vorzugsweise ausgewählt aus der Gruppe bestehend aus Sarkosinat und verwandten Carbonsäureverbindungen; kohlenwasserstoffsubstituiertem Sarkosinat; Aminosäuren; organischen Polymeren und Copolymeren mit Molekülen, die Ethylenoxid-Wiederholungseinheiten, wie Polyethylenoxid (PEO), enthalten; ethoxylierten Tensiden; stickstoffhaltigen Heterocyclen ohne Stickstoff-Wasserstoff-Bindungen; Sulfid; Oxazolidin oder Mischung von funktionellen Gruppen in einer Verbindung; stickstoffhaltigen Verbindungen mit drei oder mehr Kohlenstoffatomen, die Alkylammoniumionen bilden; Aminoalkylen mit drei oder mehr Kohlenstoffatomen; polymerem Korrosionshemmer mit einer wiederholenden Gruppe aus mindestens einem stickstoffhaltigen heterocyclischen Ring oder einem tertiären oder quaternären Stickstoffatom; polykationischer Aminverbindung; Cyclodextrinverbindung; Polyethyleniminverbindung; Glykolsäure; Chitosan; Zuckeralkoholen; Polysacchariden; Alginatverbindung; Phosphoniumverbindung und Sulfonsäurepolymer und Kombinationen davon, wobei der Dishing-Verminderer vorzugsweise im Bereich von 0,001 Gew.-% bis 2,0 Gew.-%, 0,005 Gew.-% bis 1,5 Gew.-% oder 0,01 Gew.-% bis 1,0 Gew.-% liegt;
einen Stabilisator, vorzugsweise ausgewählt aus der Gruppe bestehend aus Adipinsäure, Phthalsäure, Zitronensäure, Malonsäure, Orthophthalsäure; Phosphorsäure; substituierten oder unsubstituierten Phosphonsäuren; Nitrilen und Kombinationen davon, wobei der Stabilisator vorzugsweise im Bereich von 0,0001 bis 5 Gew.-%, 0,0005 bis 2 Gew.-% oder 0,001 bis 1 Gew.-% liegt;
einen pH-Regulator, wobei der pH-Regulator vorzugsweise ausgewählt ist aus der Gruppe bestehend aus
(a) Salpetersäure, Schwefelsäure, Weinsäure, Bernsteinsäure, Zitronensäure, Äpfelsäure, Malonsäure, verschiedenen Fettsäuren, verschiedenen Polycarbonsäuren und Mischungen davon zur Absenkung des pH; und
(b) Kaliumhydroxid, Natriumhydroxid, Ammoniak, Tetraethylammoniumhydroxid, Ethylendiamin, Piperazin, Polyethylenimin, modifiziertem Polyethylenimin and Mischungen davon zur Erhöhung des pH; und
wobei der pH der Zusammensetzung vorzugsweise zwischen 1 und 14, 1 und 7, 1 und 6 oder 1 und 4 liegt;
und
c) Polieren der mindestens einen wolframhaltigen Oberfläche mit der Zusammensetzung für die chemisch-mechanische Planarisierung.

11. Polierverfahren des Anspruchs 10, wobei die Zusammensetzung für die chemisch-mechanische Planarisierung das Abrasivmittel und
die imidazoliumbasierte Poly(ionische Flüssigkeit) ausgewählt aus der Gruppe bestehend aus Poly(vinyl-benzyl-1-butyl-1*H*-imidazol-3-ium)-chlorid, Poly(vinyl-3-ethyl-1*H*-imidazol-3-ium)-bromid, Poly(vinyl-benzyl-1-butyl-1*H*-imidazol-3-ium-co-acrylamid)-chlorid, Poly(vinyl-benzyl-1-butyl-1*H*-imidazol-3-ium-co-acrylomorpholin)-chlorid, Poly(vinyl-3-ethyl-1*H*-imidazol-3-ium-co-*N*-vinylpyrrolidon)-bromid, Poly(vinylbenzyl-1-butyl-1*H*-imidazol-3-ium-co-*N*-methyl-maleinimid)-chlorid, Poly-3-butyl-1*H-*imidazol-3-ium-acetat und Poly-3-(2,2'-(ethan-1,2-diylbis(oxy))bis(ethan)-1*H-*imidazol-3-ium-acetat, Poly(vinyl-3-butyl-1*H*-imidazol-3-ium)-bromid, Poly(vinylbenzyl-1-ethyl-1*H*-imidazol-3-ium)-chlorid, Poly(vinyl-3-ethyl-1*H*-imidazol-3-ium-co-vinyl-3,3'-butan-1*H*-imidazol-3-ium)-bromid, Poly(vinylbenzyl-1-ethyl-1*H*-imidazol-3-ium-co-vinyl-3-ethyl-1*H*-imidazol-3-ium)-bromid-chlorid, Poly(1-ethyl-3-propyl-1H-imidazol-3-ium-acrylat)-bromid, Poly(vinyl-3-isopropyl-1*H*-imidazol-3-ium)-bromid, Poly(vinyl-3-isopropyl-1*H*-imidazol-3-ium-co-*N*-vinylpyrrolidon)-bromid, Poly(vinyl-3-butyl-1*H*-imidazol-3-ium-co-*N*-vinylpyrrolidon)-bromid, Poly(vinyl-3-ethyl-1*H*-imidazol-3-ium)-acetat, Poly(vinyl-3-ethyl-1*H*-imidazol-3-ium)-malonat, Poly(vinyl-3-ethyl-1*H-*imidazol-3-ium)-nitrat und Kombinationen davon enthält; oder
wobei die Zusammensetzung für die chemisch-mechanische Planarisierung Kieselsäurepartikel; Eisen(III)-nitrat, Malonsäure, Wasserstoffperoxid, die imidazoliumbasierte Poly(ionische Flüssigkeit) ausgewählt aus der Gruppe bestehend aus Poly(vinyl-benzyl-1-butyl-1*H*-imidazol-3-ium)-chlorid, Poly(vinyl-3-ethyl-1*H*-imidazol-3-ium)-bromid, Poly(vinyl-benzyl-1-butyl-1*H*-imidazol-3-ium-co-acrylamid)-chlorid, Poly(vinyl-benzyl-1-butyl-1*H*-imidazol-3-ium-co-acrylomorpholin)-chlorid, Poly(vinyl-3-ethyl-1*H*-imidazol-3-ium-co-*N*-vinylpyrrolidon)-bromid, Poly(vinyl-benzyl-1-butyl-1*H-*imidazol-3-ium-co-*N*-methyl-maleinimid)-chlorid, Poly-3-butyl-1*H*-imidazol-3-ium-acetat, Poly-3-(2,2'-(ethan-1,2-diylbis(oxy))bis(ethan)-1*H*-imidazol-3-ium-acetat, Poly(vinyl-3-butyl-1*H*-imidazol-3-ium)-bromid, Poly(vinylbenzyl-1-ethyl-1*H*-imidazol-3-ium)-chlorid, Poly(vinyl-3-ethyl-1*H*-imidazol-3-ium-co-vinyl-3,3'-butan-1*H*-imidazol-3-ium)-bromid, Poly(vinylbenzyl-1-ethyl-1*H*-imidazol-3-ium-co-vinyl-3-ethyl-1*H-*imidazol-3-ium)-bromid-chlorid, Poly(1-ethyl-3-propyl-1H-imidazol-3-ium-acrylat)-bromid, Poly(vinyl-3-isopropyl-1*H*-imidazol-3-ium)-bromid, Poly(vinyl-3-isopropyl-1*H-*imidazol-3-ium-co-*N*-vinylpyrrolidon)-bromid, Poly(vinyl-3-butyl-1*H*-imidazol-3-ium-co-*N*-vinylpyrrolidon)-bromid, Poly(vinyl-3-ethyl-1*H*-imidazol-3-ium)-acetat, Poly(vinyl-3-ethyl-1*H*-imidazol-3-ium)-malonat, Poly(vinyl-3-ethyl-1*H*-imidazol-3-ium)-nitrat und Kombinationen davon enthält.

12. Polierverfahren des Anspruchs 10, wobei mindestens eine wolframhaltige Oberfläche eine Dishing-Topographie von weniger als 2000 oder weniger als 1000 Angström und eine Erosionstopographie von weniger als 200 oder weniger als 1000 Angström aufweist.

13. System zur chemisch-mechanischen Planarisierung eines Halbleitersubstrats umfassend mindestens eine wolframhaltige Oberfläche, umfassend:
a) ein Polierkissen; und
b) eine Zusammensetzung für die chemisch-mechanische Planarisierung enthaltend:
einen Zusatz enthaltend die imidazoliumbasierte Poly(ionische Flüssigkeit) irgendeines der Ansprüche 1 bis 7, wobei der Zusatz enthaltend ein imidazoliumbasiertes kationisches Polymer vorzugsweise im Bereich von 0,00001 Gew.-% bis 1 Gew., 0,0001 Gew.-% bis 0,5 Gew.-% oder 0,0005 Gew.-% bis 0,1 Gew.-% liegt;
Wasser; und
ein Abrasivmittel, vorzugsweise ausgewählt aus der Gruppe bestehend aus anorganischen Oxidpartikeln, metalloxidbeschichteten anorganischen Oxidpartikeln, organischen Polymerpartikeln, metalloxidbeschichteten organischen Polymerpartikeln und Kombinationen davon; wobei das Abrasivmittel vorzugsweise im Bereich von 0,01 Gew.-% bis 30 Gew.-%, 0,05 Gew.-% bis 20 Gew.-%, 0,01 Gew.-% bis 10 Gew.-% oder von 0,1 Gew.-% bis 2 Gew.-% liegt;
und gegebenenfalls
einen Aktivator, vorzugsweise ausgewählt aus der Gruppe bestehend aus
(1) anorganischem Oxidpartikel, dessen Oberfläche mit Übergangsmetall beschichtet ist; und das Übergangsmetall ist ausgewählt aus der Gruppe bestehend aus Fe, Cu, Mn, Co, Ce und Kombinationen davon;
(2) löslichem Katalysator ausgewählt aus der Gruppe bestehend aus Ammoniumeisen(III)-oxalat Trihydrat, Eisen(III)-citrat tribasisch Monohydrat, Eisen(III)-acetylacetonat und Ethylendiamin-tetraessigsäure, Eisen(III)-natriumsalz Hydrat;
(3) einer Metallverbindung mit mehreren Oxidationsstufen ausgewählt aus der Gruppe bestehend aus Ag, Co, Cr, Cu, Fe, Mo, Mn, Nb, Ni, Os, Pd, Ru, Sn, Ti, V und Kombinationen davon,
wobei der Aktivator vorzugsweise im Bereich von 0,00001 Gew.-% bis 5,0 Gew.- %, 0,0001 Gew.-% bis 2,0 Gew.-%, 0,0005 Gew.-% bis 1,0 Gew.-% oder 0,001 Gew.-% bis 0,5 Gew.-% liegt;
ein Oxidationsmittel, vorzugsweise ausgewählt aus der Gruppe bestehend aus Peroxyverbindung ausgewählt aus der Gruppe bestehend aus Wasserstoffperoxid, Harnstoffperoxid, Peroxyameisensäure, Peressigsäure, Propanperoxosäure, substituierter oder unsubstituierter Butanperoxosäure, Hydroperoxy-acetaldehyd, Kaliumperiodat, Ammoniumperoxy-monosulfat; und Nicht-Peroxyverbindung ausgewählt aus der Gruppe bestehend aus Eisennitrit, KClO₄, KBrO₄, KMnO₄, und Kombinationen davon; wobei das Oxidationsmittel vorzugsweise im Bereich von 0,01 Gew.-% bis 30 Gew.-%, 0,1 Gew.-% bis 20 Gew.-% oder 0,5 Gew.-% bis 10 Gew.-% liegt;
einen Korrosionshemmer, vorzugsweise ausgewählt aus der Gruppe bestehend aus 1,2,3-Triazol, 1,2,4-Triazol, 1,2,3-Benzotriazol, 5-Methylbenzotriazol, Benzotriazol, 1-Hydroxybenzotriazol, 4-Hydroxybenzotriazol, 3-Amino-1,2,4-triazol, 4-Amino-4H-1,2,4-triazol, 5-Aminotriazol, Benzimidazol, 2,1,3-Benzothiadiazol, Triazinthiol, Triazindithiol und Triazintrithiol, Pyrazolen, Imidazolen, Isocyanurat wie 1,3,5-Tris(2-hydroxyethyl)-isocyanurat und Kombinationen davon; wobei der Korrosionshemmer vorzugsweise im Bereich von weniger als 1,0 Gew.-%, weniger als 0,5 Gew.-% oder weniger als 0,25 Gew.-% liegt;
einen Dishing-Verminderer, vorzugsweise ausgewählt aus der Gruppe bestehend aus Sarkosinat und verwandten Carbonsäureverbindungen; kohlenwasserstoffsubstituiertem Sarkosinat; Aminosäuren; organischen Polymeren und Copolymeren mit Molekülen, die Ethylenoxid-Wiederholungseinheiten, wie Polyethylenoxid (PEO), enthalten; ethoxylierten Tensiden; stickstoffhaltigen Heterocyclen ohne Stickstoff-Wasserstoff-Bindungen; Sulfid; Oxazolidin oder Mischung von funktionellen Gruppen in einer Verbindung; stickstoffhaltigen Verbindungen mit drei oder mehr Kohlenstoffatomen, die Alkylammoniumionen bilden; Aminoalkylen mit drei oder mehr Kohlenstoffatomen; polymerem Korrosionshemmer mit einer wiederholenden Gruppe aus mindestens einem stickstoffhaltigen heterocyclischen Ring oder einem tertiären oder quaternären Stickstoffatom; polykationischer Aminverbindung; Cyclodextrinverbindung; Polyethyleniminverbindung; Glykolsäure; Chitosan; Zuckeralkoholen; Polysacchariden; Alginatverbindung; Phosphoniumverbindung und Sulfonsäurepolymer und Kombinationen davon, wobei der Dishing-Verminderer vorzugsweise im Bereich von 0,001 Gew.-% bis 2,0 Gew.-%, 0,005 Gew.-% bis 1,5 Gew.-% oder 0,01 Gew.-% bis 1,0 Gew.-% liegt;
einen Stabilisator, vorzugsweise ausgewählt aus der Gruppe bestehend aus Adipinsäure, Phthalsäure, Zitronensäure, Malonsäure, Orthophthalsäure; Phosphorsäure; substituierten oder unsubstituierten Phosphonsäuren; Nitrilen und Kombinationen davon, wobei der Stabilisator vorzugsweise im Bereich von 0,0001 bis 5 Gew.-%, 0,0005 bis 2 Gew.-% oder 0,001 bis 1 Gew.-% liegt;
einen pH-Regulator, vorzugsweise ausgewählt aus der Gruppe bestehend aus
(a) Salpetersäure, Schwefelsäure, Weinsäure, Bernsteinsäure, Zitronensäure, Äpfelsäure, Malonsäure, verschiedenen Fettsäuren, verschiedenen Polycarbonsäuren und Mischungen davon zur Absenkung des pH; und
(b) Kaliumhydroxid, Natriumhydroxid, Ammoniak, Tetraethylammoniumhydroxid, Ethylendiamin, Piperazin, Polyethylenimin, modifiziertem Polyethylenimin and Mischungen davon zur Erhöhung des pH; und
wobei der pH der Zusammensetzung vorzugsweise zwischen 1 und 14, 1 und 7, 1 und 6 oder 1 und 4 liegt; und
wobei die mindestens eine wolframhaltige Oberfläche mit dem Polierkissen in Kontakt ist und die Zusammensetzung für die chemisch-mechanische Planarisierung die mindestens eine wolframhaltige Oberfläche mit der Zusammensetzung für die chemisch-mechanische Planarisierung poliert.

14. System des Anspruchs 13, wobei die Zusammensetzung für die chemisch-mechanische Planarisierung
Kieselsäurepartikel und die imidazoliumbasierte Poly(ionische Flüssigkeit) ausgewählt aus der Gruppe bestehend aus Poly(vinyl-benzyl-1-butyl-1*H*-imidazol-3-ium)-chlorid, Poly(vinyl-3-ethyl-1*H*-imidazol-3-ium)-bromid, Poly(vinyl-benzyl-1-butyl-1*H-*imidazol-3-ium-co-acrylamid)-chlorid, Poly(vinyl-benzyl-1-butyl-1*H*-imidazol-3-iumco-acrylomorpholin)-chlorid, Poly(vinyl-3-ethyl-1*H*-imidazol-3-ium-co-*N*-vinylpyrrolidon)-bromid, Poly(vinyl-benzyl-1-butyl-1*H*-imidazol-3-ium-co-*N*-methyl-maleinimid)-chlorid, Poly-3-butyl-1*H*-imidazol-3-ium-acetat und Poly-3-(2,2'-(ethan-1,2-diylbis(oxy))bis(ethan)-1*H*-imidazol-3-ium-acetat, Poly(vinyl-3-butyl-1*H*-imidazol-3-ium)-bromid, Poly(vinylbenzyl-1-ethyl-1*H*-imidazol-3-ium)-chlorid, Poly(vinyl-3-ethyl-1*H*-imidazol-3-ium-co-vinyl-3,3'-butan-1*H*-imidazol-3-ium)-bromid, Poly(vinylbenzyl-1-ethyl-1*H*-imidazol-3-ium-co-vinyl-3-ethyl-1*H*-imidazol-3-ium)-bromid-chlorid, Poly(1-ethyl-3-propyl-1H-imidazol-3-ium-acrylat)-bromid, Poly(vinyl-3-isopropyl-1*H*-imidazol-3-ium)-bromid, Poly(vinyl-3-isopropyl-1*H*-imidazol-3-ium-co-*N*-vinylpyrrolidon)-bromid, Poly(vinyl-3-butyl-1*H*-imidazol-3-ium-co-*N*-vinylpyrrolidon)-bromid, Poly(vinyl-3-ethyl-1*H*-imidazol-3-ium)-acetat, Poly(vinyl-3-ethyl-1*H*-imidazol-3-ium)-malonat, Poly(vinyl-3-ethyl-1*H*-imidazol-3-ium)-nitrat und Kombinationen davon enthält; oder
die Zusammensetzung für die chemisch-mechanische Planarisierung Kieselsäurepartikel; Eisen(III)-nitrat, Malonsäure, Wasserstoffperoxid, die imidazoliumbasierte Poly(ionische Flüssigkeit) ausgewählt aus der Gruppe bestehend aus Poly(vinylbenzyl-1-butyl-1*H*-imidazol-3-ium)-chlorid, Poly(vinyl-3-ethyl-1*H*-imidazol-3-ium)-bromid, Poly(vinyl-benzyl-1-butyl-1*H*-imidazol-3-ium-co-acrylamid)-chlorid, Poly(vinylbenzyl-1-butyl-1*H*-imidazol-3-ium-co-acrylomorpholin)-chlorid, Poly(vinyl-3-ethyl-1*H-*imidazol-3-ium-co-*N*-vinylpyrrolidon)-bromid, Poly(vinyl-benzyl-1-butyl-1*H*-imidazol-3-ium-co-*N*-methyl-maleinimid)-chlorid, Poly-3-butyl-1*H*-imidazol-3-ium-acetat, Poly-3-(2,2'-(ethan-1,2-diylbis(oxy))bis(ethan)-1*H*-imidazol-3-ium-acetat, Poly(vinyl-3-butyl-1*H*-imidazol-3-ium)-bromid, Poly(vinylbenzyl-1-ethyl-1*H*-imidazol-3-ium)-chlorid, Poly(vinyl-3-ethyl-1*H*-imidazol-3-ium-co-vinyl-3,3'-butan-1*H*-imidazol-3-ium)-bromid, Poly(vinylbenzyl-1-ethyl-1*H*-imidazol-3-ium-co-vinyl-3-ethyl-1*H*-imidazol-3-ium)-bromid-chlorid, Poly(1-ethyl-3-propyl-1H-imidazol-3-ium-acrylat)-bromid, Poly(vinyl-3-isopropyl-1*H*-imidazol-3-ium)-bromid, Poly(vinyl-3-isopropyl-1*H*-imidazol-3-ium-co-*N-*vinylpyrrolidon)-bromid, Poly(vinyl-3-butyl-1*H*-imidazol-3-ium-co-*N*-vinylpyrrolidon)-bromid, Poly(vinyl-3-ethyl-1*H*-imidazol-3-ium)-acetat, Poly(vinyl-3-ethyl-1*H*-imidazol-3-ium)-malonat, Poly(vinyl-3-ethyl-1*H*-imidazol-3-ium)-nitrat und Kombinationen davon enthält.

## Revendications

1. Composition de planarisation chimico-mécanique comprenant un abrasif et un poly(liquide ionique) à base d'imidazolium comprenant au moins un monomère ayant au moins un groupement imidazolium répondant à la structure (I) : 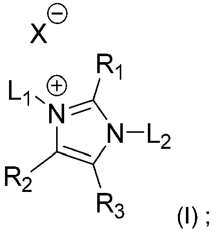 dans laquelle
(a) le au moins un groupement imidazolium répondant à la structure (I) se trouve dans une chaîne latérale ou des chaînes latérales du poly(liquide ionique) à base d'imidazolium ;
où
l'un parmi L₁ et L₂ est une liaison covalente ou un espaceur reliant le cycle imidazolium à la chaîne principale du poly(liquide ionique) à base d'imidazolium, et comprend un motif substitué ou non substitué aliphatique, cyclique ou ramifié aliphatique, aromatique, hétéroaromatique ou siloxane ; où la chaîne principale est formée après polymérisation d'un groupement polymérisable choisi dans le groupe constitué par vinyle, allyle, styrénique, acrylique, méthacrylique, acrylamide, méthacrylamide, siloxane, maléimide, norbornène, et des combinaisons de ceux-ci ;
un autre parmi L₁ et L₂ est un groupement alkyle choisi dans le groupe constitué par un groupement alkyle linéaire, ramifié, et cyclique ; dont les groupements CH₂ peuvent être remplacés par O, S ou N de telle sorte qu'aucun hétéroatome ne soit relié les uns aux autres ; hydrogène peut être remplacé par F, Cl ou CN ;
chacun parmi R₁, R₂, R₃ peut être indépendamment H ou un groupement alkyle choisi dans le groupe constitué par un groupement alkyle linéaire, ramifié, et cyclique ; dont les groupements CH₂ peuvent être remplacés par O, S ou N de telle sorte qu'aucun hétéroatome ne soit relié les uns aux autres ; et hydrogène peut être remplacé par F, Cl ou CN ; R₂ et R₃ peuvent également être reliés à un motif cyclique ; préférablement, R₁= R₂ = H ;
et
l'anion X⁻ est choisi dans le groupe constitué par halogénure (F-, Cl-, Br-, I-), BF₄-, PF₆-, [C₂F₅BF₃]-, carboxylate RCOO- avec R = H, alkyle ou aryle ; malonate, citrate, fumarate, MeOSO₃-, MeSO₃-, CF₃COO-, CF₃SO₃-, nitrate, et sulfate ; où Me est méthyle ;
(b) le au moins un groupement imidazolium répondant à la structure (I) se trouve dans la chaîne principale du poly(liquide ionique) à base d'imidazolium ;
où
L₁ et L₂ comprennent chacun indépendamment un motif substitué ou non substitué aliphatique, cyclique ou ramifié aliphatique, aromatique, hétéroaromatique, ou siloxane ; dont les groupements CH₂ peuvent être remplacés par O, S ou N de telle sorte qu'aucun hétéroatome ne soit relié les uns aux autres ; hydrogène peut être remplacé par F, Cl ou CN ;
L₁, L₂, ou L₁ ainsi que L₂ peuvent relier le au moins un groupement imidazolium via un groupement fonctionnel convenable à la chaîne principale pour former le poly(liquide ionique) à base d'imidazolium ; où le groupement fonctionnel convenable est choisi dans le groupe constitué par les esters, amides, uréthanes, éthers, thioéthers, imides, et des combinaisons de ceux-ci ;
chacun parmi R₁, R₂, R₃ peut être indépendamment H ou un groupement alkyle choisi dans le groupe constitué par un groupement alkyle linéaire, ramifié, et cyclique ; dont les groupements CH₂ peuvent être remplacés par O, S ou N de telle sorte qu'aucun hétéroatome ne soit relié les uns aux autres ; et hydrogène peut être remplacé par F, Cl ou CN ; R₂ et R₃ peuvent également être reliés à un motif cyclique ; préférablement, R₁= R₂ = H ;
et
l'anion X⁻ est choisi dans le groupe constitué par halogénure (F-, Cl-, Br-, I-), BF₄-, PF₆-, [C₂F₅BF₃]-, carboxylate RCOO- avec R = H, alkyle ou aryle ; malonate, citrate, fumarate, MeOSO₃-, MeSO₃-, CF₃COO-, CF₃SO₃-, nitrate, et sulfate, où Me est méthyle ;
et
(c) le au moins un groupement imidazolium répondant à la structure (I) se trouve à la fois dans la chaîne latérale ou les chaînes latérales du poly(liquide ionique) à base d'imidazolium tel que défini dans (a) ci-dessus ainsi que dans la chaîne principale du poly(liquide ionique) à base d'imidazolium tel que défini dans (b) ci-dessus.

2. Composition de planarisation chimico-mécanique selon la revendication 1, dans laquelle le poly(liquide ionique) à base d'imidazolium comprend un monomère réticulable ayant des groupements polymérisables pour L₁ et L₂ de (a).

3. Composition de planarisation chimico-mécanique selon la revendication 1, dans laquelle le poly(liquide ionique) à base d'imidazolium est un copolymère comprenant au moins deux monomères différents choisis parmi (a), (b), et (e) un monomère non ionique qui peut former des copolymères avec le monomère dans (a) ou le monomère dans (b) et est choisi dans le groupe constitué par acrylate ou méthacrylate, acrylamide ou méthacrylamide, maléimide, vinylbenzène, un monomère de type vinyle, éthylène glycol, siloxane, norbornène, et des combinaisons de ceux-ci.

4. Composition de planarisation chimico-mécanique selon la revendication 1, dans laquelle le poly(liquide ionique) à base d'imidazolium est un copolymère bloc.

5. Composition de planarisation chimico-mécanique selon la revendication 1, dans laquelle le poly(liquide ionique) à base d'imidazolium comprend au moins l'un parmi un anion fonctionnel comme agent réducteur ou agent de complexation.

6. Composition de planarisation chimico-mécanique selon la revendication 1, dans laquelle la polymérisation du poly(liquide ionique) à base d'imidazolium est choisie dans le groupe constitué par la polymérisation radicalaire, la polymérisation par transfert de chaîne par addition-fragmentation réversible (RAFT), la polymérisation médiée par nitroxyde (NMP), la polymérisation par réaction de transfert d'atomes (ATRP), la polymérisation par ouverture de cycle (ROMP), la réaction de polycondensation, et des combinaisons de ceux-ci.

7. Composition de planarisation chimico-mécanique selon la revendication 1, dans laquelle le poly(liquide ionique) à base d'imidazolium est choisi dans le groupe constitué par le chlorure de poly(vinylbenzyl-1-butyl-1*H*-imidazol-3-ium), le bromure de poly(vinyl-3-éthyl-1*H*-imidazol-3-ium), le chlorure de poly(vinylbenzyl-1-butyl-1*H-*imidazol-3-ium-co-acrylamide), le chlorure de poly(vinylbenzyl-1-butyl-1*H*-imidazol-3-ium-co-acrylomorpholine), le bromure de poly(vinyl-3-éthyl-1*H*-imidazol-3-ium-co-*N-*vinylpyrrolidone), le chlorure de poly(vinylbenzyl-1-butyl-1*H*-imidazol-3-ium-co-*N-*méthyl-maléimide), l'acétate de poly-3-butyl-1*H*-imidazol-3-ium, et l'acétate de poly-3-(2,2'-(éthane-1,2-diylbis(oxy))bis(éthane)-1*H*-imidazol-3-ium, le bromure de poly(vinyl-3-butyl-1*H*-imidazol-3-ium), le chlorure de poly(vinylbenzyl-1-éthyl-1*H-*imidazol-3-ium), le bromure de poly(vinyl-3-éthyl-1*H*-imidazol-3-ium-co-vinyl-3,3'-butane-1*H*-imidazol-3-ium), le chlorure-bromure de poly(vinylbenzyl-1-éthyl-1*H-*imidazol-3-ium-co-vinyl-3-éthyl-1*H*-imidazol-3-ium), le bromure de poly(acrylate de 1-éthyl-3-propyl-1*H*-imidazol-3-ium), le bromure de poly(vinyl-3-isopropyl-1*H*-imidazol-3-ium), le bromure de poly(vinyl-3-isopropyl-1*H*-imidazol-3-ium-co-*N*-vinyl-pyrrolidone), le bromure de poly(vinyl-3-butyl-1*H*-imidazol-3-ium-co-*N*-vinyl-pyrrolidone), l'acétate de poly(vinyl-3-éthyl-1*H*-imidazol-3-ium), le malonate de poly(vinyl-3-éthyl-1*H*-imidazol-3-ium), le nitrate de poly(vinyl-3-éthyl-1*H*-imidazol-3-ium), et des combinaisons de ceux-ci.

8. Composition de planarisation chimico-mécanique selon la revendication 1, dans laquelle la concentration en polymère cationique à base d'imidazolium va préférablement de 0,00001% en poids à 1% en poids, de 0,0001% en poids à 0,5 % en poids, ou de 0,0005% en poids à 0,1% en poids ; et la composition comprend en outre
de l'eau ; et
un abrasif, qui est préférablement choisi dans le groupe constitué par les particules d'oxyde inorganique, les particules d'oxyde inorganique revêtues d'oxyde métallique, les particules de polymère organique, les particules de polymère organique revêtues d'oxyde métallique, et des combinaisons de celles-ci, l'abrasif étant préférablement présent de 0,01% en poids à 30% en poids, de 0,05% en poids à 20% en poids, de 0,01% en poids à 10% en poids, ou de 0,1% en poids à 2% en poids ;
et éventuellement
un activateur, qui est préférablement choisi dans le groupe constitué par
(1) une particule d'oxyde inorganique dont la surface est revêtue d'un métal de transition ; et le métal de transition est choisi dans le groupe constitué par Fe, Cu, Mn, Co, Ce, et des combinaisons de ceux-ci ;
(2) un catalyseur soluble choisi dans le groupe constitué par l'oxalate d'ammonium et de fer (III) trihydraté, le citrate de fer (III) tribasique monohydraté, l'acétylacétonate de fer (III) et l'acide éthylènediaminetétraacétique, le sel de sodium de fer (III) hydraté ;
(3) un composé métallique présentant plusieurs états d'oxydation choisi dans le groupe constitué par Ag, Co, Cr, Cu, Fe, Mo, Mn, Nb, Ni, Os, Pd, Ru, Sn, Ti, V ; et des combinaisons de ceux-ci,
l'activateur étant préférablement présent de 0,00001% en poids à 5,0% en poids, de 0,0001% en poids à 2,0% en poids, de 0,0005% en poids à 1,0% en poids, ou de 0,001% en poids à 0,5% en poids ;
un agent oxydant, qui est préférablement choisi dans le groupe constitué par un composé péroxy choisi dans le groupe constitué le peroxyde d'hydrogène, le peroxyde d'urée, l'acide peroxyformique, l'acide peracétique, l'acide propaneperoxoïque, l'acide butaneperoxoïque substitué ou non substitué, l'hydroperoxy-acétaldéhyde, le périodate de potassium, le peroxymonosulfate d'ammonium ; et un composé non péroxy choisi dans le groupe constitué par le nitrite ferrique, KClO₄, KBrO₄, KMnO₄ ; et des combinaisons de ceux-ci, l'agent oxydant étant préférablement présent de 0,01% en poids à 30% en poids, de 0,1% en poids à 20% en poids, ou de 0,5% en poids à 10% en poids ;
un inhibiteur de corrosion, qui est préférablement choisi dans le groupe constitué par le 1,2,3-triazole, le 1,2,4-triazole, le 1,2,3-benzotriazole, le 5-méthylbenzotriazole, le benzotriazole, le 1-hydroxybenzotriazole, le 4-hydroxybenzotriazole, le 3-amino-1,2,4-triazole, le 4-amino-4H-1,2,4-triazole, le 5-amino-triazole, le benzimidazole, le 2,1,3-benzothiadiazole, le triazinéthiol, le triazinedithiol, et le triazinetrithiol, les pyrazoles, les imidazoles, un isocyanurate tel que le 1,3,5-tris(2-hydroxyéthyl)-isocyanurate, et des combinaisons de ceux-ci, l'inhibiteur de corrosion étant préférablement présent à moins de 1,0% en poids, moins de 0,5% en poids, ou moins de 0,25% en poids ;
un agent réducteur de déformation, qui est préférablement choisi dans le groupe constitué par le sarcosinate et les composés carboxyliques apparentés ; le sarcosinate substitué par des hydrocarbures ; les acides aminés ; les polymères et copolymères organiques dont les molécules contiennent des motifs répétitifs d'oxyde d'éthylène, tels que le poly(oxyde d'éthylène) (PEO) ; les agents tensioactifs éthoxylés ; les hétérocycles azotés sans liaison azote-hydrogène ; les sulfures ; l'oxazolidine ou un mélange de groupements fonctionnels au sein d'un même composé ; les composés azotés comportant trois, ou plus, atomes de carbone et formant des ions alkylammonium ; les aminoalkyles comportant trois, ou plus, atomes de carbone ; un inhibiteur de corrosion polymère comprenant un motif répétitif d'au moins un cycle hétérocyclique azoté ou un atome d'azote tertiaire ou quaternaire ; un composé d'amine polycationique ; un composé de cyclodextrine ; un composé de polyéthylèneimine ; un acide glycolique ; un chitosane ; les alcools de sucre ; les polysaccharides ; un composé d'alginate ; un composé de phosphonium ; et un polymère d'acide sulfonique ; et des combinaisons de ceux-ci, l'agent réducteur de déformation étant préférablement présent de 0,001% en poids à 2,0% en poids, de 0,005% en poids à 1,5% en poids, ou de 0,01% en poids à 1,0% en poids ;
un stabilisant, qui est préférablement choisi dans le groupe constitué par l'acide adipique, l'acide phtalique, l'acide citrique, l'acide malonique, l'acide orthophtalique ; l'acide phosphorique ; les acides phosphoniques substitués ou non substitués ; les nitriles ; et des combinaisons de ceux-ci, le stabilisant étant préférablement présent de 0,0001 à 5% en poids, de 0,0005 à 2% en poids, ou de 0,001 à 1% en poids ;
un agent d'ajustement du pH, qui est préférablement choisi dans le groupe constitué par
(a) l'acide nitrique, l'acide sulfurique, l'acide tartrique, l'acide succinique, l'acide citrique, l'acide malique, l'acide malonique, divers acides gras, divers acides polycarboxyliques et des mélanges de ceux-ci, destinés à abaisser le pH ; et
(b) l'hydroxyde de potassium, l'hydroxyde de sodium, l'ammoniaque, l'hydroxyde de tétraéthylammonium, l'éthylènediamine, la pipérazine, la polyéthylèneimine, la polyéthylèneimine modifiée, et des mélanges de ceux-ci, destinés à augmenter le pH ; et
le pH de la composition étant préférablement entre 1 et 14, 1 et 7, 1 et 6, ou 1 et 4.

9. Composition de planarisation chimico-mécanique selon la revendication 1, la composition de planarisation chimico-mécanique comprenant
des particules de silice ; et le poly(liquide ionique) à base d'imidazolium choisi dans le groupe constitué par le chlorure de poly(vinylbenzyl-1-butyl-1*H*-imidazol-3-ium), le bromure de poly(vinyl-3-éthyl-1*H*-imidazol-3-ium), le chlorure de poly(vinylbenzyl-1-butyl-1*H*-imidazol-3-ium-co-acrylamide), le chlorure de poly(vinylbenzyl-1-butyl-1*H-*imidazol-3-ium-co-acrylomorpholine), le bromure de poly(vinyl-3-éthyl-1*H*-imidazol-3-ium-co-*N*-vinylpyrrolidone), le chlorure de poly(vinylbenzyl-1-butyl-1*H*-imidazol-3-iumco-*N*-méthyl-maléimide), l'acétate de poly-3-butyl-1*H*-imidazol-3-ium, et l'acétate de poly-3-(2,2'-(éthane-1,2-diylbis(oxy))bis(éthane)-1*H*-imidazol-3-ium, le bromure de poly(vinyl-3-butyl-1*H*-imidazol-3-ium), le chlorure de poly(vinylbenzyl-1-éthyl-1*H-*imidazol-3-ium), le bromure de poly(vinyl-3-éthyl-1*H*-imidazol-3-ium-co-vinyl-3,3'-butane-1*H*-imidazol-3-ium), le bromure-chlorure de poly(vinylbenzyl-1-éthyl-1*H-*imidazol-3-ium-co-vinyl-3-éthyl-1*H*-imidazol-3-ium), le bromure de poly(acrylate de 1-éthyl-3-propyl-1*H*-imidazol-3-ium), le bromure de poly(vinyl-3-isopropyl-1*H*-imidazol-3-ium), le bromure de poly(vinyl-3-isopropyl-1*H*-imidazol-3-ium-co-*N*-vinyl-pyrrolidone), le bromure de poly(vinyl-3-butyl-1*H*-imidazol-3-ium-co-*N*-vinyl-pyrrolidone), l'acétate de poly(vinyl-3-éthyl-1*H*-imidazol-3-ium), le malonate de poly(vinyl-3-éthyl-1*H*-imidazol-3-ium), le nitrate de poly(vinyl-3-éthyl-1*H*-imidazol-3-ium), et des combinaisons de ceux-ci ; ou
la composition de planarisation chimico-mécanique comprend des particules de silice ; du nitrate ferrique, de l'acide malonique, du peroxyde d'hydrogène, le poly(liquide ionique) à base d'imidazolium choisi dans le groupe constitué par le chlorure de poly(vinylbenzyl-1-butyl-1*H*-imidazol-3-ium), le bromure de poly(vinyl-3-éthyl-1*H*-imidazol-3-ium), le chlorure de poly(vinylbenzyl-1-butyl-1*H*-imidazol-3-iumco-acrylamide), le chlorure de poly(vinylbenzyl-1-butyl-1*H*-imidazol-3-ium-coacrylomorpholine), le bromure de poly(vinyl-3-éthyl-1*H*-imidazol-3-ium-co-*N-*vinylpyrrolidone), le chlorure de poly(vinylbenzyl-1-butyl-1*H*-imidazol-3-ium-co-*N-*méthyl-maléimide), l'acétate de poly-3-butyl-1*H*-imidazol-3-ium, et l'acétate de poly-3-(2,2'-(éthane-1,2-diylbis(oxy))bis(éthane)-1*H*-imidazol-3-ium, le bromure de poly(vinyl-3-butyl-1*H*-imidazol-3-ium), le chlorure de poly(vinylbenzyl-1-éthyl-1*H-*imidazol-3-ium), le bromure de poly(vinyl-3-éthyl-1*H*-imidazol-3-ium-co-vinyl-3,3'-butane-1*H*-imidazol-3-ium), le bromure-chlorure de poly(vinylbenzyl-1-éthyl-1*H-*imidazol-3-ium-co-vinyl-3-éthyl-1*H*-imidazol-3-ium), le bromure de poly(acrylate de 1-éthyl-3-propyl-1*H*-imidazol-3-ium), le bromure de poly(vinyl-3-isopropyl-1*H*-imidazol-3-ium), le bromure de poly(vinyl-3-isopropyl-1*H*-imidazol-3-ium-co-*N*-vinyl-pyrrolidone), le bromure de poly(vinyl-3-butyl-1*H*-imidazol-3-ium-co-*N*-vinyl-pyrrolidone), l'acétate de poly(vinyl-3-éthyl-1*H*-imidazol-3-ium), le malonate de poly(vinyl-3-éthyl-1*H*-imidazol-3-ium), le nitrate de poly(vinyl-3-éthyl-1*H*-imidazol-3-ium), et des combinaisons de ceux-ci.

10. Méthode de polissage pour la planarisation mécano-chimique d'un substrat semi-conducteur comprenant au moins une surface contenant du tungstène,
la méthode de polissage comprenant les étapes suivantes :
a) la mise à disposition d'un tampon de polissage ;
b) la mise à disposition d'une composition de planarisation chimico-mécanique comprenant :
un additif comprenant le poly(liquide ionique) à base d'imidazolium selon l'une quelconque des revendications 1 à 7, l'additif comprenant un polymère cationique à base d'imidazolium étant préférablement présent de 0,00001% en poids à 1% en poids, de 0,0001% en poids à 0,5 % en poids, ou de 0,0005% en poids à 0,1% en poids ;
de l'eau ; et
un abrasif préférablement choisi dans le groupe constitué par les particules d'oxyde inorganique, les particules d'oxyde inorganique revêtues d'oxyde métallique, les particules de polymère organique, les particules de polymère organique revêtues d'oxyde métallique, et des combinaisons de celles-ci, l'abrasif étant préférablement présent de 0,01% en poids à 30% en poids, de 0,05% en poids à 20% en poids, de 0,01% en poids à 10% en poids, ou de 0,1% en poids à 2% en poids ;
et éventuellement
un activateur préférablement choisi dans le groupe constitué par
(1) une particule d'oxyde inorganique dont la surface est revêtue d'un métal de transition ; et le métal de transition est choisi dans le groupe constitué par Fe, Cu, Mn, Co, Ce, et des combinaisons de ceux-ci ;
(2) un catalyseur soluble choisi dans le groupe constitué par l'oxalate d'ammonium et de fer (III) trihydraté, le citrate de fer (III) tribasique monohydraté, l'acétylacétonate de fer (III) et l'acide éthylènediaminetétraacétique, le sel de sodium de fer (III) hydraté ;
(3) un composé métallique présentant plusieurs états d'oxydation choisi dans le groupe constitué par Ag, Co, Cr, Cu, Fe, Mo, Mn, Nb, Ni, Os, Pd, Ru, Sn, Ti, V ; et des combinaisons de ceux-ci,
l'activateur étant préférablement présent de 0,00001% en poids à 5,0% en poids, de 0,0001% en poids à 2,0% en poids, de 0,0005% en poids à 1,0% en poids, ou de 0,001% en poids à 0,5% en poids ;
un agent oxydant préférablement choisi dans le groupe constitué par un composé péroxy choisi dans le groupe constitué le peroxyde d'hydrogène, le peroxyde d'urée, l'acide peroxyformique, l'acide peracétique, l'acide propaneperoxoïque, l'acide butaneperoxoïque substitué ou non substitué, l'hydroperoxy-acétaldéhyde, le périodate de potassium, le peroxymonosulfate d'ammonium ; et un composé non péroxy choisi dans le groupe constitué par le nitrite ferrique, KClO₄, KBrO₄, KMnO₄ ; et des combinaisons de ceux-ci, l'agent oxydant étant préférablement présent de 0,01% en poids à 30% en poids, de 0,1% en poids à 20% en poids, ou de 0,5% en poids à 10% en poids ;
un inhibiteur de corrosion préférablement choisi dans le groupe constitué par le 1,2,3-triazole, le 1,2,4-triazole, le 1,2,3-benzotriazole, le 5-méthylbenzotriazole, le benzotriazole, le 1-hydroxybenzotriazole, le 4-hydroxybenzotriazole, le 3-amino-1,2,4-triazole, le 4-amino-4H-1,2,4-triazole, le 5-aminotriazole, le benzimidazole, le 2,1,3-benzothiadiazole, le triazinéthiol, le triazinedithiol, et le triazinetrithiol, les pyrazoles, les imidazoles, un isocyanurate tel que le 1,3,5-tris(2-hydroxyéthyl)-isocyanurate, et des combinaisons de ceux-ci, l'inhibiteur de corrosion étant préférablement présent à moins de 1,0% en poids, moins de 0,5% en poids, ou moins de 0,25% en poids ;
un agent réducteur de déformation préférablement choisi dans le groupe constitué par le sarcosinate et les composés carboxyliques apparentés ; le sarcosinate substitué par des hydrocarbures ; les acides aminés ; les polymères et copolymères organiques dont les molécules contiennent des motifs répétitifs d'oxyde d'éthylène, tels que le poly(oxyde d'éthylène) (PEO) ; les agents tensioactifs éthoxylés ; les hétérocycles azotés sans liaison azote-hydrogène ; les sulfures ; l'oxazolidine ou un mélange de groupements fonctionnels au sein d'un même composé ; les composés azotés comportant trois, ou plus, atomes de carbone et formant des ions alkylammonium ; les aminoalkyles comportant trois, ou plus, atomes de carbone ; un inhibiteur de corrosion polymère comprenant un motif répétitif d'au moins un cycle hétérocyclique azoté ou un atome d'azote tertiaire ou quaternaire ; un composé d'amine polycationique ; un composé de cyclodextrine ; un composé de polyéthylèneimine ; un acide glycolique ; un chitosane ; les alcools de sucre ; les polysaccharides ; un composé d'alginate ; un composé de phosphonium ; et un polymère d'acide sulfonique ; et des combinaisons de ceux-ci, l'agent réducteur de déformation étant préférablement présent de 0,001% en poids à 2,0% en poids, de 0,005% en poids à 1,5% en poids, ou de 0,01% en poids à 1,0% en poids ;
un stabilisant préférablement choisi dans le groupe constitué par l'acide adipique, l'acide phtalique, l'acide citrique, l'acide malonique, l'acide orthophtalique ; l'acide phosphorique ; les acides phosphoniques substitués ou non substitués ; les nitriles ; et des combinaisons de ceux-ci, le stabilisant étant préférablement présent de 0,0001 à 5% en poids, de 0,0005 à 2% en poids, ou de 0,001 à 1% en poids ;
un agent d'ajustement du pH, l'agent d'ajustement du pH étant préférablement choisi dans le groupe constitué par
(a) l'acide nitrique, l'acide sulfurique, l'acide tartrique, l'acide succinique, l'acide citrique, l'acide malique, l'acide malonique, divers acides gras, divers acides polycarboxyliques et des mélanges de ceux-ci, destinés à abaisser le pH ; et
(b) l'hydroxyde de potassium, l'hydroxyde de sodium, l'ammoniaque, l'hydroxyde de tétraéthylammonium, l'éthylènediamine, la pipérazine, la polyéthylèneimine, la polyéthylèneimine modifiée, et des mélanges de ceux-ci, destinés à augmenter le pH ; et
le pH de la composition étant préférablement entre 1 et 14, 1 et 7, 1 et 6, ou 1 et 4 ;
et
c) le polissage de la au moins une surface contenant du tungstène avec la composition de planarisation chimico-mécanique.

11. Méthode de polissage selon la revendication 10, la composition de planarisation chimico-mécanique comprenant l'abrasif ; et
le poly(liquide ionique) à base d'imidazolium choisi dans le groupe constitué par le chlorure de poly(vinylbenzyl-1-butyl-1*H*-imidazol-3-ium), le bromure de poly(vinyl-3-éthyl-1*H*-imidazol-3-ium), le chlorure de poly(vinylbenzyl-1-butyl-1*H*-imidazol-3-iumco-acrylamide), le chlorure de poly(vinylbenzyl-1-butyl-1*H*-imidazol-3-ium-co-acrylomorpholine), le bromure de poly(vinyl-3-éthyl-1*H*-imidazol-3-ium-co-*N*-vinyl-pyrrolidone), le chlorure de poly(vinylbenzyl-1-butyl-1*H*-imidazol-3-ium-co-*N*-méthyl-maléimide), l'acétate de poly-3-butyl-1*H*-imidazol-3-ium, et l'acétate de poly-3-(2,2'-(éthane-1,2-diylbis(oxy))bis(éthane)-1*H*-imidazol-3-ium, le bromure de poly(vinyl-3-butyl-1*H*-imidazol-3-ium), le chlorure de poly(vinylbenzyl-1-éthyl-1*H*-imidazol-3-ium), le bromure de poly(vinyl-3-éthyl-1*H*-imidazol-3-ium-co-vinyl-3,3'-butane-1*H*-imidazol-3-ium), le bromure-chlorure de poly(vinylbenzyl-1-éthyl-1*H*-imidazol-3-ium-co-vinyl-3-éthyl-1*H*-imidazol-3-ium), le bromure de poly(acrylate de 1-éthyl-3-propyl-1*H-*imidazol-3-ium), le bromure de poly(vinyl-3-isopropyl-1*H*-imidazol-3-ium), le bromure de poly(vinyl-3-isopropyl-1*H*-imidazol-3-ium-co-*N*-vinylpyrrolidone), le bromure de poly(vinyl-3-butyl-1*H*-imidazol-3-ium-co-*N*-vinylpyrrolidone), l'acétate de poly(vinyl-3-éthyl-1*H*-imidazol-3-ium), le malonate de poly(vinyl-3-éthyl-1*H*-imidazol-3-ium), le nitrate de poly(vinyl-3-éthyl-1*H*-imidazol-3-ium), et des combinaisons de ceux-ci ou
où la composition de planarisation chimico-mécanique comprend des particules de silice ; du nitrate ferrique, de l'acide malonique, du peroxyde d'hydrogène, le poly(liquide ionique) à base d'imidazolium choisi dans le groupe constitué par le chlorure de poly(vinylbenzyl-1-butyl-1*H*-imidazol-3-ium), le bromure de poly(vinyl-3-éthyl-1*H*-imidazol-3-ium), le chlorure de poly(vinylbenzyl-1-butyl-1*H*-imidazol-3-ium-co-acrylamide), le chlorure de poly(vinylbenzyl-1-butyl-1*H*-imidazol-3-ium-co-acrylomorpholine), le bromure de poly(vinyl-3-éthyl-1*H*-imidazol-3-ium-co-*N-*vinylpyrrolidone), le chlorure de poly(vinylbenzyl-1-butyl-1*H*-imidazol-3-ium-co-*N-*méthyl-maléimide), l'acétate de poly-3-butyl-1*H*-imidazol-3-ium, l'acétate de poly-3-(2,2'-(éthane-1,2-diylbis(oxy))bis(éthane)-1*H*-imidazol-3-ium, le bromure de poly(vinyl-3-butyl-1*H*-imidazol-3-ium), le chlorure de poly(vinylbenzyl-1-éthyl-1*H-*imidazol-3-ium), le bromure de poly(vinyl-3-éthyl-1*H*-imidazol-3-ium-co-vinyl-3,3'-butane-1*H*-imidazol-3-ium), le bromure-chlorure de poly(vinylbenzyl-1-éthyl-1*H-*imidazol-3-ium-co-vinyl-3-éthyl-1*H*-imidazol-3-ium), le bromure de poly(acrylate de 1-éthyl-3-propyl-1*H*-imidazol-3-ium), le bromure de poly(vinyl-3-isopropyl-1*H*-imidazol-3-ium), le bromure de poly(vinyl-3-isopropyl-1*H*-imidazol-3-ium-co-*N*-vinyl-pyrrolidone), le bromure de poly(vinyl-3-butyl-1*H*-imidazol-3-ium-co-*N*-vinyl-pyrrolidone), l'acétate de poly(vinyl-3-éthyl-1*H*-imidazol-3-ium), ) le malonate de poly(vinyl-3-éthyl-1*H*-imidazol-3-ium, le nitrate de poly(vinyl-3-éthyl-1*H*-imidazol-3-ium), et des combinaisons de ceux-ci.

12. Méthode de polissage selon la revendication 10, dans laquelle au moins une surface contenant du tungstène présente une topographie de déformation inférieure à 2000 ou inférieure à 1000 Angströms et une topographie d'érosion inférieure à 2000 ou inférieure à 1000 Angströms.

13. Système de planarisation mécano-chimique d'un substrat semi-conducteur comprenant au moins une surface contenant du tungstène, comprenant :
a) un tampon de polissage ; et
b) une composition de planarisation chimico-mécanique comprenant :
un additif comprenant le poly(liquide ionique) à base d'imidazolium selon l'une quelconque des revendications 1 à 7, l'additif comprenant un polymère cationique à base d'imidazolium étant préférablement présent de 0,00001% en poids à 1% en poids, de 0,0001% en poids à 0,5 % en poids, ou de 0,0005% en poids à 0,1% en poids ;
de l'eau ; et
un abrasif préférablement choisi dans le groupe constitué par les particules d'oxyde inorganique, les particules d'oxyde inorganique revêtues d'oxyde métallique, les particules de polymère organique, les particules de polymère organique revêtues d'oxyde métallique, et des combinaisons de celles-ci, l'abrasif étant préférablement présent de 0,01% en poids à 30% en poids, de 0,05% en poids à 20% en poids, de 0,01% en poids à 10% en poids, ou de 0,1% en poids à 2% en poids ;
et éventuellement
un activateur préférablement choisi dans le groupe constitué par
(1) une particule d'oxyde inorganique dont la surface est revêtue d'un métal de transition ; et le métal de transition est choisi dans le groupe constitué par Fe, Cu, Mn, Co, Ce, et des combinaisons de ceux-ci ;
(2) un catalyseur soluble choisi dans le groupe constitué par l'oxalate d'ammonium et de fer (III) trihydraté, le citrate de fer (III) tribasique monohydraté, l'acétylacétonate de fer (III) et l'acide éthylènediaminetétraacétique, le sel de sodium de fer (III) hydraté ;
(3) un composé métallique présentant plusieurs états d'oxydation choisi dans le groupe constitué par Ag, Co, Cr, Cu, Fe, Mo, Mn, Nb, Ni, Os, Pd, Ru, Sn, Ti, V ; et des combinaisons de ceux-ci,
l'activateur étant préférablement présent de 0,00001% en poids à 5,0% en poids, de 0,0001% en poids à 2,0% en poids, de 0,0005% en poids à 1,0% en poids, ou de 0,001% en poids à 0,5% en poids ;
un agent oxydant préférablement choisi dans le groupe constitué par un composé péroxy choisi dans le groupe constitué le peroxyde d'hydrogène, le peroxyde d'urée, l'acide peroxyformique, l'acide peracétique, l'acide propaneperoxoïque, l'acide butaneperoxoïque substitué ou non substitué, l'hydroperoxy-acétaldéhyde, le périodate de potassium, le peroxymonosulfate d'ammonium ; et un composé non péroxy choisi dans le groupe constitué par le nitrite ferrique, KClO₄, KBrO₄, KMnO₄ ; et des combinaisons de ceux-ci, l'agent oxydant étant préférablement présent de 0,01% en poids à 30% en poids, de 0,1% en poids à 20% en poids, ou de 0,5% en poids à 10% en poids ;
un inhibiteur de corrosion préférablement choisi dans le groupe constitué par le 1,2,3-triazole, le 1,2,4-triazole, le 1,2,3-benzotriazole, le 5-méthylbenzotriazole, le benzotriazole, le 1-hydroxybenzotriazole, le 4-hydroxybenzotriazole, le 3-amino-1,2,4-triazole, le 4-amino-4H-1,2,4-triazole, le 5-aminotriazole, le benzimidazole, le 2,1,3-benzothiadiazole, le triazinéthiol, le triazinedithiol, et le triazinetrithiol, les pyrazoles, les imidazoles, un isocyanurate tel que le 1,3,5-tris(2-hydroxyéthyl)-isocyanurate, et des combinaisons de ceux-ci, l'inhibiteur de corrosion étant préférablement présent à moins de 1,0% en poids, moins de 0,5% en poids, ou moins de 0,25% en poids ;
un agent réducteur de déformation préférablement choisi dans le groupe constitué par le sarcosinate et les composés carboxyliques apparentés ; le sarcosinate substitué par des hydrocarbures ; les acides aminés ; les polymères et copolymères organiques dont les molécules contiennent des motifs répétitifs d'oxyde d'éthylène, tels que le poly(oxyde d'éthylène) (PEO) ; les agents tensioactifs éthoxylés ; les hétérocycles azotés sans liaison azote-hydrogène ; les sulfures ; l'oxazolidine ou un mélange de groupements fonctionnels au sein d'un même composé ; les composés azotés comportant trois, ou plus, atomes de carbone et formant des ions alkylammonium ; les aminoalkyles comportant trois, ou plus, atomes de carbone ; un inhibiteur de corrosion polymère comprenant un motif répétitif d'au moins un cycle hétérocyclique azoté ou un atome d'azote tertiaire ou quaternaire ; un composé d'amine polycationique ; un composé de cyclodextrine ; un composé de polyéthylèneimine ; un acide glycolique ; un chitosane ; les alcools de sucre ; les polysaccharides ; un composé d'alginate ; un composé de phosphonium ; et un polymère d'acide sulfonique ; et des combinaisons de ceux-ci, l'agent réducteur de déformation étant préférablement présent de 0,001% en poids à 2,0% en poids, de 0,005% en poids à 1,5% en poids, ou de 0,01% en poids à 1,0% en poids ;
un stabilisant préférablement choisi dans le groupe constitué par l'acide adipique, l'acide phtalique, l'acide citrique, l'acide malonique, l'acide orthophtalique ; l'acide phosphorique ; les acides phosphoniques substitués ou non substitués ; les nitriles ; et des combinaisons de ceux-ci, le stabilisant étant préférablement présent de 0,0001 à 5% en poids, de 0,0005 à 2% en poids, ou de 0,001 à 1% en poids ;
un agent d'ajustement du pH préférablement choisi dans le groupe constitué par
(a) l'acide nitrique, l'acide sulfurique, l'acide tartrique, l'acide succinique, l'acide citrique, l'acide malique, l'acide malonique, divers acides gras, divers acides polycarboxyliques et des mélanges de ceux-ci, destinés à abaisser le pH ; et
(b) l'hydroxyde de potassium, l'hydroxyde de sodium, l'ammoniaque, l'hydroxyde de tétraéthylammonium, l'éthylènediamine, la pipérazine, la polyéthylèneimine, la polyéthylèneimine modifiée, et des mélanges de ceux-ci, destinés à augmenter le pH ; et
le pH de la composition étant préférablement entre 1 et 14, 1 et 7, 1 et 6, ou 1 et 4 ; et
la au moins une surface contenant du tungstène étant en contact avec le tampon de polissage et la composition de planarisation chimico-mécanique effectuant le polissage de la au moins une surface contenant du tungstène avec la composition de planarisation chimico-mécanique.

14. Système selon la revendication 13, la composition de planarisation chimico-mécanique comprenant
des particules de silice ; et le poly(liquide ionique) à base d'imidazolium choisi dans le groupe constitué par le chlorure de poly(vinylbenzyl-1-butyl-1*H*-imidazol-3-ium), le bromure de poly(vinyl-3-éthyl-1*H*-imidazol-3-ium), le chlorure de poly(vinylbenzyl-1-butyl-1*H*-imidazol-3-ium-co-acrylamide), le chlorure de poly(vinylbenzyl-1-butyl-1*H-*imidazol-3-ium-co-acrylomorpholine), le bromure de poly(vinyl-3-éthyl-1*H*-imidazol-3-ium-co-*N*-vinylpyrrolidone), le chlorure de poly(vinylbenzyl-1-butyl-1*H*-imidazol-3-ium-co-*N*-méthyl-maléimide), l'acétate de poly-3-butyl-1*H*-imidazol-3-ium, et l'acétate de poly-3-(2,2'-(éthane-1,2-diylbis(oxy))bis(éthane)-1*H*-imidazol-3-ium, le bromure de poly(vinyl-3-butyl-1*H*-imidazol-3-ium), le chlorure de poly(vinylbenzyl-1-éthyl-1*H*-imidazol-3-ium), le bromure de poly(vinyl-3-éthyl-1*H*-imidazol-3-ium-co-vinyl-3,3'-butane-1*H*-imidazol-3-ium), le bromure-chlorure de poly(vinylbenzyl-1-éthyl-1*H*-imidazol-3-ium-co-vinyl-3-éthyl-1*H*-imidazol-3-ium), le bromure de poly(acrylate de 1-éthyl-3-propyl-1*H*-imidazol-3-ium), le bromure de poly(vinyl-3-isopropyl-1*H*-imidazol-3-ium), le bromure de poly(vinyl-3-isopropyl-1*H*-imidazol-3-ium-co-*N*-vinylpyrrolidone), le bromure de poly(vinyl-3-butyl-1*H*-imidazol-3-ium-co*N*-vinylpyrrolidone), l'acétate de poly(vinyl-3-éthyl-1*H*-imidazol-3-ium), le malonate de poly(vinyl-3-éthyl-1*H*-imidazol-3-ium), le nitrate de poly(vinyl-3-éthyl-1*H*-imidazol-3-ium), et des combinaisons de ceux-ci ; ou
la composition de planarisation chimico-mécanique comprend des particules de silice ; du nitrate ferrique, de l'acide malonique, du peroxyde d'hydrogène, le poly(liquide ionique) à base d'imidazolium choisi dans le groupe constitué par le chlorure de poly(vinylbenzyl-1-butyl-1*H*-imidazol-3-ium), le bromure de poly(vinyl-3-éthyl-1*H*-imidazol-3-ium), le chlorure de poly(vinylbenzyl-1-butyl-1*H*-imidazol-3-ium-co-acrylamide), le chlorure de poly(vinylbenzyl-1-butyl-1*H*-imidazol-3-ium-coacrylomorpholine), le bromure de poly(vinyl-3-éthyl-1*H*-imidazol-3-ium-co-*N-*vinylpyrrolidone), le chlorure de poly(vinylbenzyl-1-butyl-1*H*-imidazol-3-ium-co-*N-*méthyl-maléimide), l'acétate de poly-3-butyl-1*H*-imidazol-3-ium, l'acétate de poly-3-(2,2'-(éthane-1,2-diylbis(oxy))bis(éthane)-1*H*-imidazol-3-ium, le bromure de poly(vinyl-3-butyl-1*H*-imidazol-3-ium), le chlorure de poly(vinylbenzyl-1-éthyl-1*H-*imidazol-3-ium), le bromure de poly(vinyl-3-éthyl-1*H*-imidazol-3-ium-co-vinyl-3,3'-butane-1*H*-imidazol-3-ium), le bromure-chlorure de poly(vinylbenzyl-1-éthyl-1*H-*imidazol-3-ium-co-vinyl-3-éthyl-1*H*-imidazol-3-ium), le bromure de poly(acrylate de 1-éthyl-3-propyl-1*H*-imidazol-3-ium), le bromure de poly(vinyl-3-isopropyl-1*H*-imidazol-3-ium), le bromure de poly(vinyl-3-isopropyl-1*H*-imidazol-3-ium-co-*N*-vinyl-pyrrolidone), le bromure de poly(vinyl-3-butyl-1*H*-imidazol-3-ium-co-*N*-vinyl-pyrrolidone), l'acétate de poly(vinyl-3-éthyl-1*H*-imidazol-3-ium), le malonate de poly(vinyl-3-éthyl-1*H*-imidazol-3-ium), le nitrate de poly(vinyl-3-éthyl-1*H*-imidazol-3-ium), et des combinaisons de ceux-ci.
